# EUROPÄISCHE PATENTSCHRIFT

(11) **EP 2 935 291 B1**
(45) Veröffentlichungstag und Bekanntmachung des Hinweises auf die Patenterteilung: **16.10.2019**
(21) Anmeldenummer: 13802878.2
(22) Anmeldetag: 27.11.2013
(51) Int. Cl.: C07F 15/00, C09K 11/06, H01L 51/00, H05B 33/14, H01L 51/50

(54) **IRIDIUMKOMPLEXE UND DEREN VERWENDUNG IN OLIGOMEREN, POLYMEREN ODER DENDRIMEREN IN ELEKTRONISCHEN VORRICHTUNGEN**
IRIDIUM COMPLEXES USED IN OLIGOMERS, POLYMERS OR DENDRIMERS IN ELECTRONIC DEVICES
COMPLEXES D'IRIDIUM ET LEUR UTILISATION DANS LES OLIGOMÈRES, POLYMÈRES OU DENDRIMÈRES DANS LES DISPOSITIFS ELECTRONIQUES

(30) Priorität: 21.12.2012 EP 12008582; 10.07.2013 EP 13003485
(43) Veröffentlichungstag der Anmeldung: 28.10.2015
(73) Patentinhaber: Merck Patent GmbH, 64293 Darmstadt (DE)
(72) Erfinder: STOESSEL, Philipp, 60487 Frankfurt am Main (DE); KOENEN, Nils, 64285 Darmstadt (DE); BREUNING, Esther, 64372 Ober-Ramstadt (DE); EHRENREICH, Christian, 64297 Darmstadt (DE)
(86) Internationale Anmeldenummer: PCT/EP2013/003580
(87) Internationale Veröffentlichungsnummer: WO 2014/094960

(56) Entgegenhaltungen:
- EP-A1- 1 659 129
- EP-A2- 1 238 981
- WO-A1-2004/043974
- WO-A1-2005/113563
- WO-A1-2011/044988

## Beschreibung

Die vorliegende Erfindung betrifft Metallkomplexe sowie elektronische Vorrichtungen, insbesondere organische Elektrolumineszenzvorrichtungen, enthaltend diese Metallkomplexe.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch Verbesserungsbedarf, insbesondere im Hinblick auf Effizienz, Betriebsspannung und Lebensdauer.

Gemäß dem Stand der Technik werden in phosphoreszierenden OLEDs als Triplettemitter insbesondere Iridiumkomplexe eingesetzt, wie zum Beispiel Iridiumkomplexe, welche als Liganden Imidazophenanthridin-Derivate bzw. Diimidazochinazolin-Derivate enthalten (WO 2007/095118). Aus der WO 2011/044988 sind Iridiumkomplexe bekannt, in welchen der Ligand mindestens eine Carbonylgruppe enthält. Generell sind bei phosphoreszierenden Emittern noch weitere Verbesserungen, insbesondere hinsichtlich Effizienz, Betriebsspannung, Lebensdauer und/oder thermischer Stabilität der Lumineszenz, wünschenswert.

Aufgabe der vorliegenden Erfindung ist daher die Bereitstellung neuer Metallkomplexe, welche sich als Emitter für die Verwendung in OLEDs eignen und dabei zu verbesserten Eigenschaften der OLED, insbesondere hinsichtlich Effizienz, Betriebsspannung und/oder Lebensdauer führen.

Überraschend wurde gefunden, dass bestimmte, unten näher beschriebene Metallchelatkomplexe, welche im Liganden einen ankondensierten aliphatischen Fünfring aufweisen, diese Aufgabe lösen und verbesserte Eigenschaften in organischen Elektrolumineszenzvorrichtung zeigen. Insbesondere zeigen diese Metallkomplexe verbesserte Effizienz und Lebensdauer gegenüber den analogen Metallkomplexen, die diesen ankondensierten aliphatischen Fünfring nicht enthalten. Diese Metallkomplexe und elektronische Vorrichtungen, insbesondere organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

[Ir(L)ₙ(L')ₘ] Formel (1)

wobei die Verbindung der allgemeinen Formel (1) eine Teilstruktur Ir(L)ₙ der Formel (2) enthält: 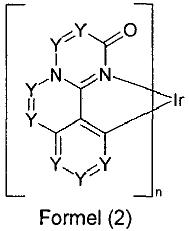 wobei für die verwendeten Symbole und Indizes gilt:
- Y: ist bei jedem Auftreten gleich oder verschieden CR oder N mit der Maßgabe, dass maximal ein Symbol Y pro Cyclus für N steht, oder zwei benachbarte Symbole Y stehen zusammen für eine Gruppe der folgenden Formel (3), 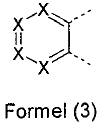 wobei die gestrichelten Bindungen die Verknüpfung dieser Gruppe im Liganden symbolisieren;
- X: ist bei jedem Auftreten gleich oder verschieden CR oder N mit der Maßgabe, dass maximal zwei Symbole X pro Ligand für N stehen;
- R: ist bei jedem Auftreten gleich oder verschieden H, D, F, Cl, Br, I, N(R¹)₂, CN, Si(R¹)₃, B(OR¹)₂, C(=O)R¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, Si(R¹)₂, C=O, NR¹, O, S oder CONR¹ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden;
- R¹: ist bei jedem Auftreten gleich oder verschieden H, D, F, Cl, Br, I, N(R²)₂, CN, Si(R²)₃, B(OR²)₂, C(=O)R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², Si(R²)₂, C=O, NR², O, S oder CONR² ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R² auch miteinander ein mono- oder polycyclisches, aliphatisches oder aromatisches Ringsystem bilden;
- L': ist gleich oder verschieden bei jedem Auftreten ein mono- oder bidentater Ligand;
- n: ist 1, 2 oder 3;
- m: ist 0, 1, 2, 3 oder 4;
dadurch gekennzeichnet, dass in der Teilstruktur der Formel (2) zwei benachbarte Gruppen Y für CR stehen und die jeweiligen Reste R zusammen mit den C-Atomen einen Ring gemäß einer der folgenden Formeln (4), (5), (6), (7), (8), (9) oder (10) aufspannen,
und/oder dass zwei benachbarte Gruppen Y für eine Gruppe der Formel (3) stehen, in dieser Gruppe der Formel (3) zwei benachbarte Gruppen X für CR stehen und die jeweiligen Reste R zusammen mit den C-Atomen einen Ring gemäß einer der folgenden Formeln (4), (5), (6), (7), (8), (9) oder (10) aufspannen, 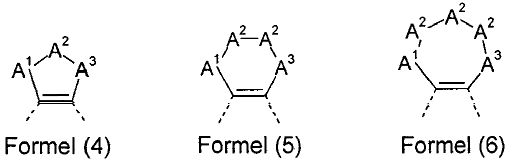 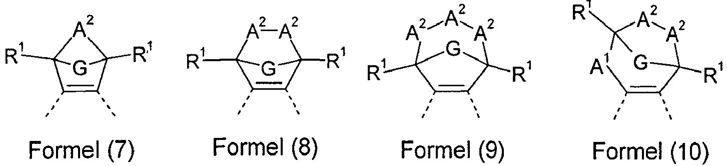 wobei R¹ und R² die oben genannten Bedeutungen aufweisen, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, S, NR³ oder C(=O);
- A²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

Dabei werden die Indizes n und m so gewählt, dass die Koordinationszahl am Iridium insgesamt 6 entspricht. Dies ist insbesondere davon abhängig, wie viele Liganden L vorhanden sind und ob es sich bei den Liganden L' um mono- oder bidentate Liganden handelt.

In der folgenden Beschreibung bedeutet "benachbarte Gruppen Y" bzw. "benachbarte Gruppen X", dass die Gruppen Y bzw. X in der Struktur direkt aneinander gebunden sind.

Weiterhin bedeutet "benachbart" in der Definition der Reste, dass diese Reste an dasselbe oder an direkt aneinander gebundene C-Atome gebunden sind oder, wenn sie nicht an direkt gebundene C-Atome gebunden sind, dass es sich um die nächstmögliche Position handelt, in der ein Substituent gebunden sein kann. Dies wird anhand von einem spezifischen Liganden in der folgenden schematischen Darstellung für benachbarte Reste nochmals erläutert:

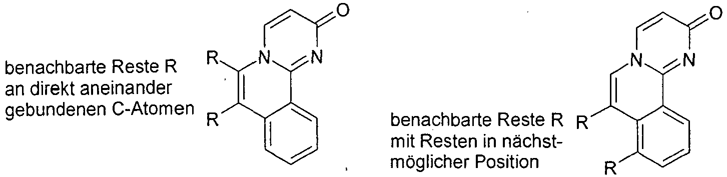

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N- oder O-Atom oder eine Carbonylgruppe, verbunden sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylengruppe oder durch eine Silylengruppe verbunden sind.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, Cyclohexyl, 2-Methylpentyl, neo-Hexyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die erfindungsgemäßen Komplexe können facial bzw. pseudofacial sein, oder sie können meridional bzw. pseudomeridional sein.

In einer bevorzugten Ausführungsform ist der Index n = 3, d. h. es handelt sich um einen homoleptischen Metallkomplex und der Index m = 0.

In einer weiteren bevorzugten Ausführungsform ist der Index n = 2 und m = 1, der erfindungsgemäße Komplex enthält zwei Liganden L und einen bidentaten Liganden L'. Dabei ist bevorzugt, wenn der Ligand L' ein Ligand ist, der über ein Kohlenstoffatom und ein Stickstoffatom, ein Kohlenstoffatom und ein Sauerstoffatom, zwei Sauerstoffatome, zwei Stickstoffatome oder ein Sauerstoff- und ein Stickstoffatom an das Iridium koordinieren.

In einer weiteren bevorzugten Ausführungsform ist der Index n = 1 und m = 2, und der erfindungsgemäße Komplex enthält einen Liganden L und zwei bidentate Liganden L'. Dies ist inbesondere dann bevorzugt, wenn der Ligand L' ein ortho-metallierter Ligand ist, der über ein Kohlenstoffatom und ein Stickstoffatom oder ein Kohlenstoffatom und ein Sauerstoffatom an das Iridium koordiniert.

In einer weiteren bevorzugten Ausführungsform der Erfindung ist in den erfindungsgemäßen Verbindungen maximal eine Gruppe der Formel (3) vorhanden. Es handelt sich also bevorzugt um Verbindungen der folgenden Formeln (11), (12), (13) oder (14), 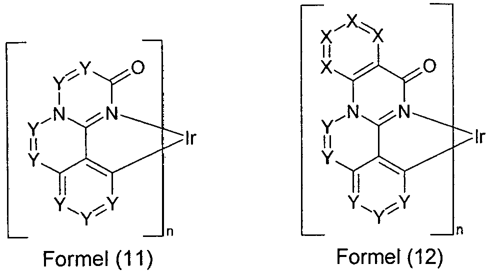 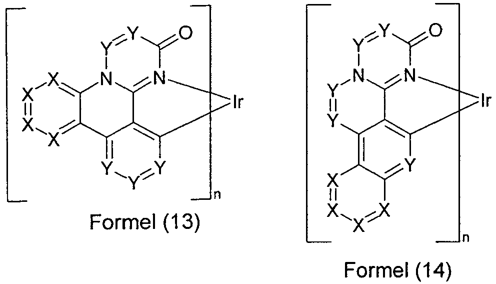 wobei Y bei jedem Auftreten gleich oder verschieden für CR oder N steht und die weiteren Symbole und Indizes die oben genannten Bedeutungen aufweisen.

In einer bevorzugten Ausführungsform der Erfindung stehen im Liganden L insgesamt 0, 1 oder 2 der Symbole Y und, falls vorhanden, X für N. Besonders bevorzugt stehen im Liganden L insgesamt 0 oder 1 der Symbole Y und, falls vorhanden, X für N. Insbesondere bevorzugt stehen in dem Cyclus, der über das Kohlenstoffatom an das Iridium koordiniert, die Symbole Y gleich oder verschieden bei jedem Auftreten für CR.

Bevorzugte Ausführungsformen der Formel (11) sind die Strukturen der folgenden Formeln (11-1) bis (11-5), bevorzugte Ausführungsformen der Formel (12) sind die Strukturen der folgenden Formeln (12-1) bis (12-8), bevorzugte Ausführungsformen der Formel (13) sind die Strukturen der folgenden Formeln (13-1) bis (13-8), und bevorzugte Ausführungsformen der Formel (14) sind die Strukturen der folgenden Formeln (14-1) bis (14-9), 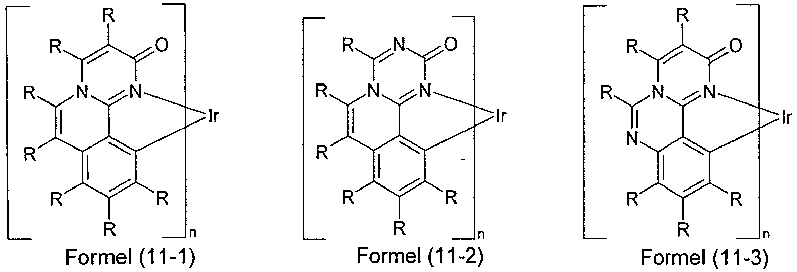 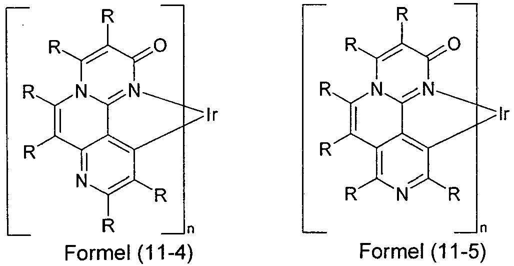 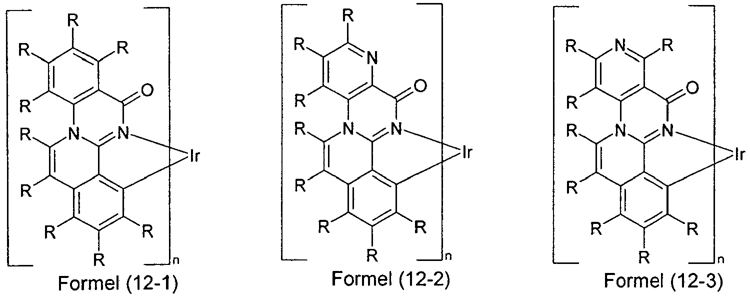 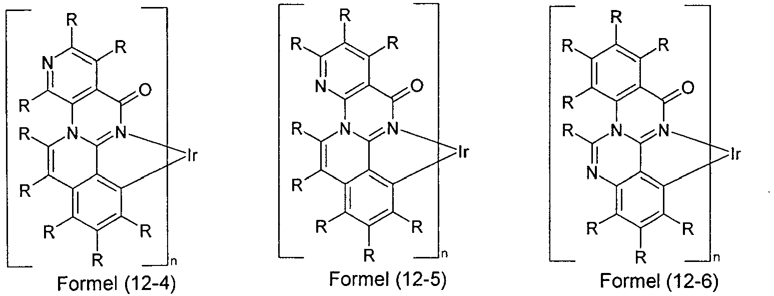 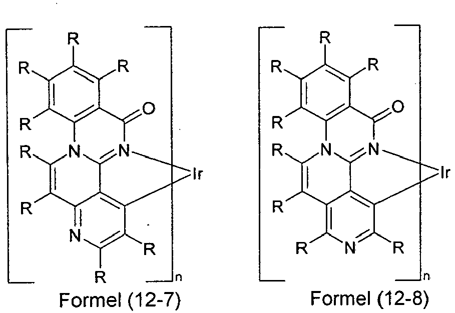 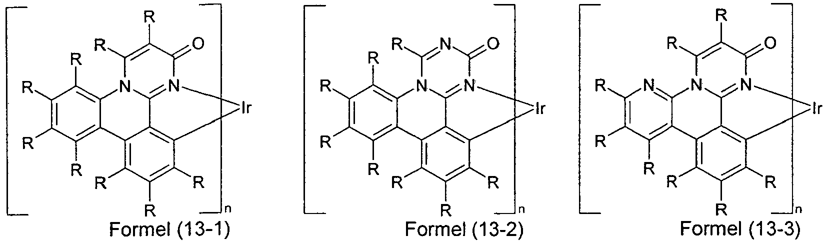 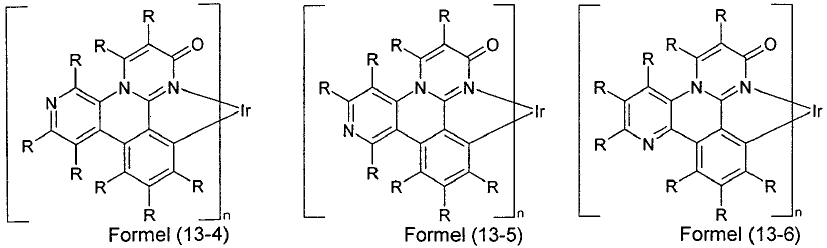 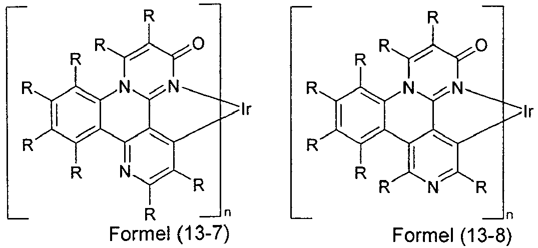 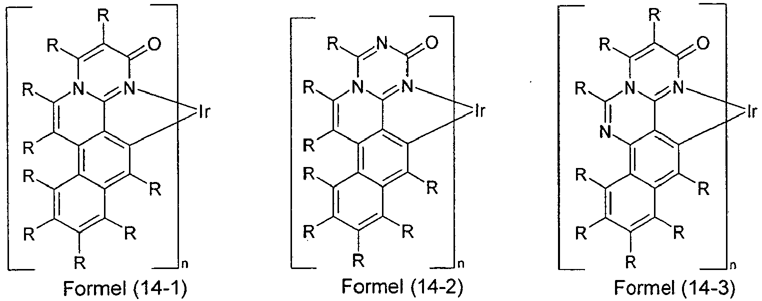 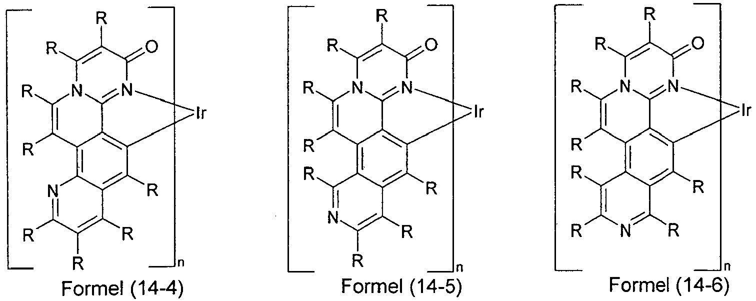 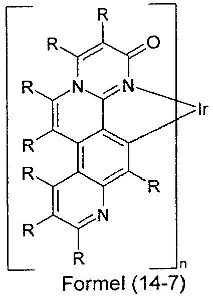 wobei die verwendeten Symbole und Indizes die oben genannten Bedeutungen aufweisen.

In einer bevorzugten Ausführungsform der Erfindung steht die Gruppe Y, die in ortho-Position zur Koordination an das Iridium vorliegt, für CR. Dabei ist in dieser Rest R, der in ortho-Position zur Koordination an das Iridium gebunden ist, bevorzugt ausgewählt aus der Gruppe bestehend aus H, D, F und Methyl. Dies gilt insbesondere, wenn es sich um faciale, homoleptische Komplexe handelt, während bei meridionalen oder heteroleptischen Komplexen auch andere Reste R in dieser Position bevorzugt sein können.

In einer weiteren Ausführungsform der Erfindung ist es bevorzugt, falls eines der Atome Y oder, wenn vorhanden, X für N steht, wenn benachbart zu diesem Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden. Dabei handelt es sich dann bevorzugt um Strukturen der Formel (4) bis (10), wie sie erfindungsgemäß in den Verbindungen der vorliegenden Erfindung vorliegen.

Wenn der Rest R, der einem Stickstoffatom benachbart ist, für eine Alkylgruppe steht, dann weist diese Alkylgruppe bevorzugt 3 bis 10 C-Atome auf. Bevorzugt handelt es sich weiterhin um eine sekundäre oder tertiäre Alkylgruppe, bei der das sekundäre oder tertiäre C-Atom entweder direkt an den Liganden gebunden ist oder über eine CH₂-Gruppe an den Liganden gebunden ist. Besonders bevorzugt ist diese Alkylgruppe ausgewählt aus den Strukturen der folgenden Formeln (R-1) bis (R-33), wobei jeweils auch die Anknüpfung dieser Gruppen an den Liganden mit eingezeichnet ist: 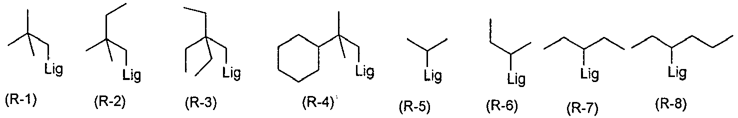 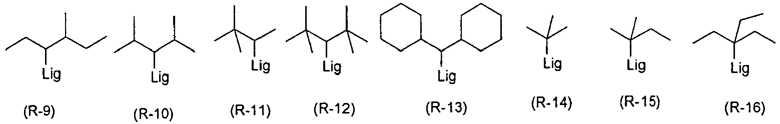 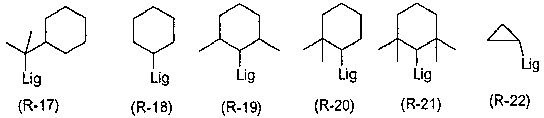 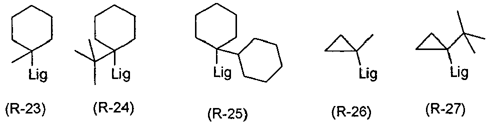 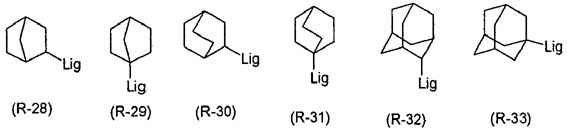 wobei Lig die Anknüpfung der Alkylgruppe an den Liganden kennzeichnet.

Wenn der Rest R, der einem Stickstoffatom benachbart ist, für eine Alkoxygruppe steht, dann weist diese Alkoxygruppe bevorzugt 3 bis 10 C-Atome auf. Bevorzugt ist diese Alkoxygruppe ausgewählt aus den Strukturen der folgenden Formeln (R-34) bis (R-47), wobei jeweils auch die Anknüpfung dieser Gruppen an den Liganden mit eingezeichnet ist: 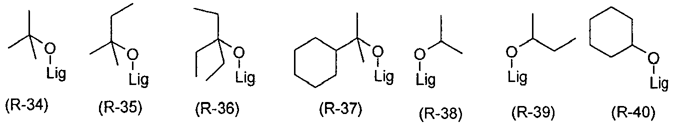 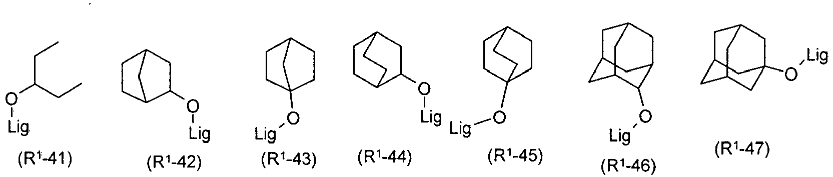 wobei Lig die Anknüpfung der Alkoxygruppe an den Liganden kennzeichnet.

Wenn der Rest R, der einem Stickstoffatom benachbart ist, für eine Dialkylaminogruppe steht, dann weist jede dieser Alkylgruppen bevorzugt 1 bis 8 C-Atome auf, besonders bevorzugt 1 bis 6 C-Atome. Beispiele für geeignete Alkylgruppen sind Methyl, Ethyl oder die oben als Gruppen (R-1) bis (R-33) aufgeführten Strukturen. Besonders bevorzugt ist die Dialkylaminogruppe ausgewählt aus den Strukturen der folgenden Formeln (R-48) bis (R-55), wobei jeweils auch die Anknüpfung dieser Gruppen an den Liganden mit eingezeichnet ist: 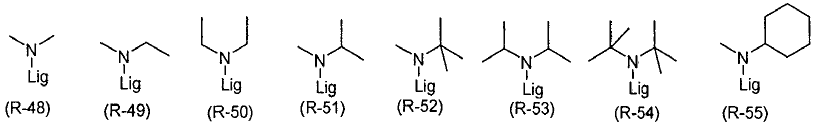 wobei Lig die Anknüpfung der Dialkylaminogruppe an den Liganden kennzeichnet.

Wenn der Rest R, der einem Stickstoffatom benachbart ist, für eine Aralkylgruppe steht, dann ist diese Aralkylgruppe bevorzugt ausgewählt aus den Strukturen der folgenden Formeln (R-56) bis (R-69), wobei jeweils auch die Anknüpfung dieser Gruppen an den Liganden eingezeichnet ist: 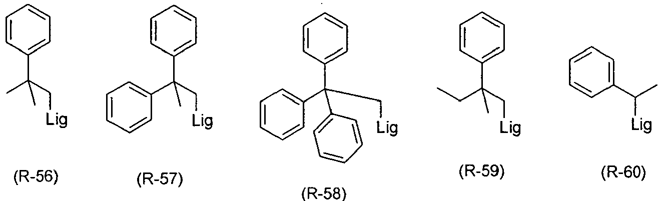 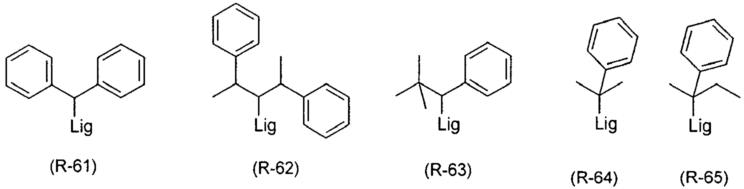 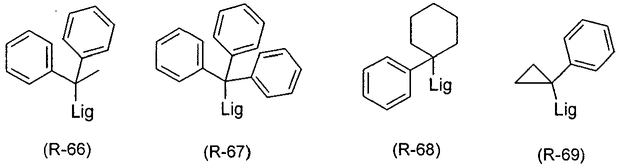 wobei Lig die Anknüpfung der Aralkylgruppe an den Liganden kennzeichnet und die Phenylgruppen jeweils durch einen oder mehrere Reste R¹ substituiert sein können.

Wenn der Rest R, der einem Stickstoffatom benachbart ist, für ein aromatisches bzw. heteroaromatisches Ringsystem steht, dann weist dieses aromatische bzw. heteroaromatische Ringsystem bevorzugt 5 bis 30 aromatische Ringatome auf, besonders bevorzugt 5 bis 24 aromatische Ringatome. Weiterhin enthält dieses aromatische bzw. heteroaromatische Ringsystem bevorzugt keine Aryl- bzw. Heteroarylgruppen, in denen mehr als zwei aromatische Sechsringe direkt aneinander kondensiert sind. Besonders bevorzugt enthält das aromatische bzw. heteroaromatische Ringsystem überhaupt keine kondensierten Aryl- bzw. Heteroarylgruppen, und ganz besonders bevorzugt enthält es nur Phenylgruppen. Dabei ist das aromatische Ringsystem bevorzugt ausgewählt aus den Strukturen der folgenden Formeln (R-70) bis (R-88), wobei jeweils auch die Anknüpfung dieser Gruppen an den Liganden eingezeichnet ist: 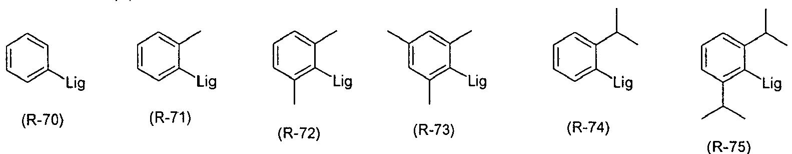 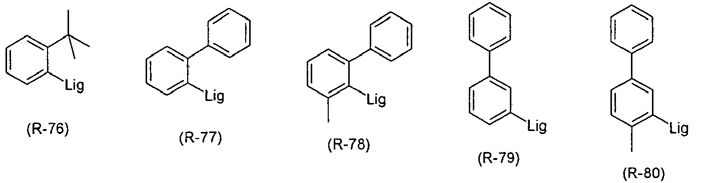 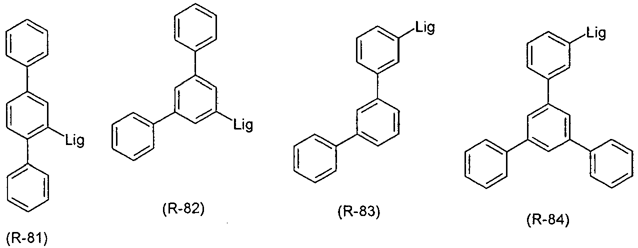 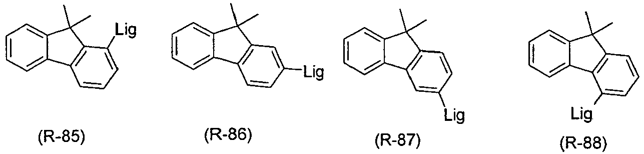 wobei Lig die Anknüpfung des aromatischen Ringsystems an den Liganden kennzeichnet und die Phenylgruppen jeweils durch einen oder mehrere Reste R¹ substituiert sein können.

Weiterhin ist das heteroaromatische Ringsystem bevorzugt ausgewählt aus den Strukturen der folgenden Formeln (R-89) bis (R-119), wobei jeweils auch die Anknüpfung dieser Gruppen an den Liganden eingezeichnet ist: 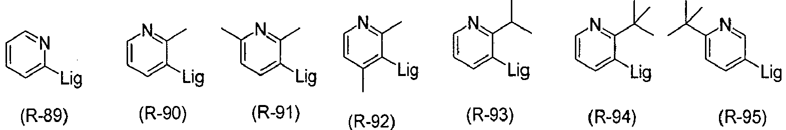 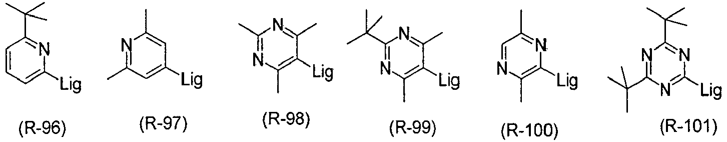 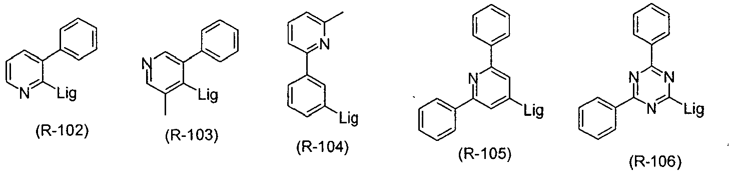 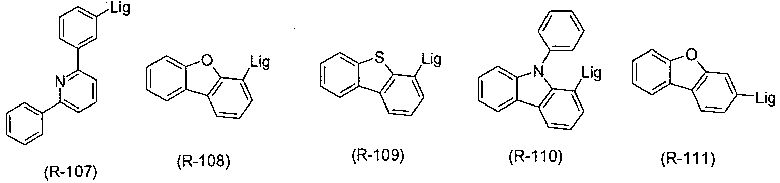 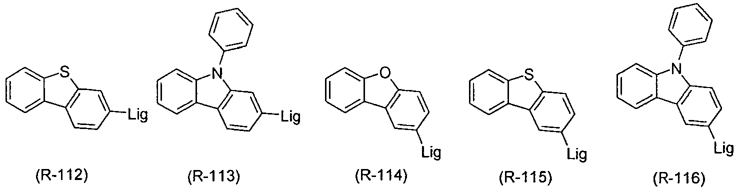 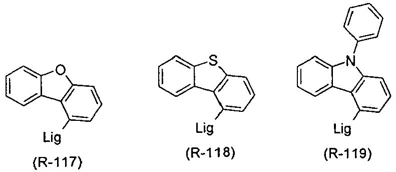 wobei Lig die Anknüpfung des heteroaromatischen Ringsystems an den Liganden kennzeichnet und die aromatischen und heteroaromatischen Gruppen jeweils durch einen oder mehrere Reste R¹ substituiert sein können.

Das charakterisierende Merkmal der vorliegenden Erfindung ist, wie oben beschrieben, dass in der Teilstruktur der Formel (2) zwei benachbarte Gruppen Y und/oder, falls vorhanden, zwei benachbarte Gruppen X für CR stehen und die jeweiligen Reste R zusammen mit den C-Atomen einen Ring gemäß einer der Formeln (4) bis (10) aufspannen.

Die Gruppen der Formel (4) bis (10) können in jeder Position der Teilstruktur der Formel (2) vorliegen, in der zwei Gruppen Y bzw., falls vorhanden, zwei Gruppen X direkt aneinander gebunden sind. Bevorzugte Positionen, in denen eine Gruppe der Formel (4) bis (10) vorliegt, sind die Teilstrukturen der folgenden Formeln (11a) bis (14e), 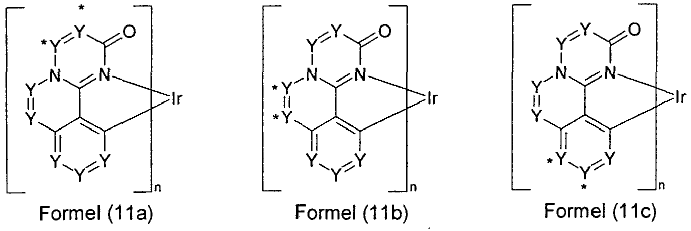 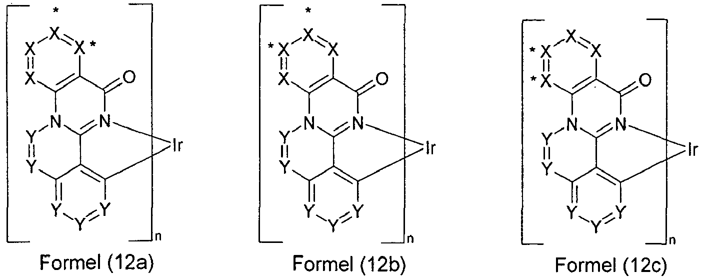 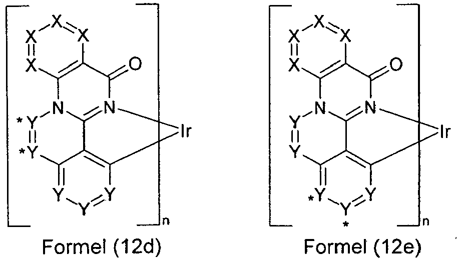 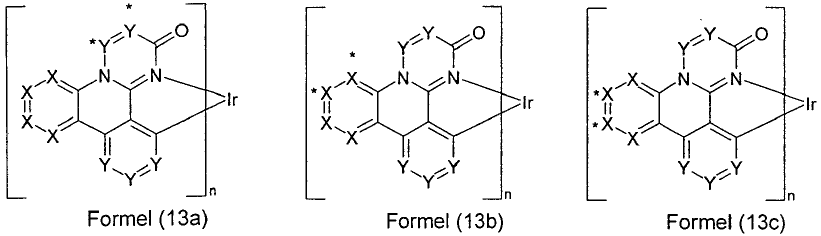 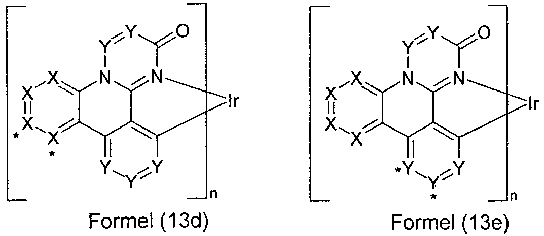 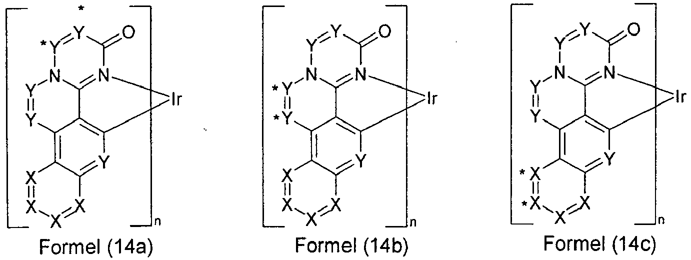 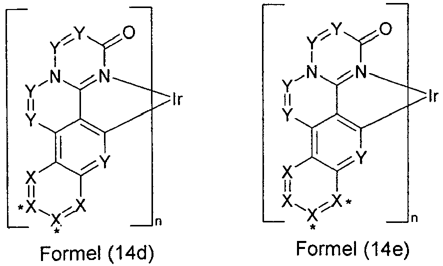 wobei die verwendeten Symbole und Indizes die oben genannten Bedeutungen aufweisen und * jeweils die Position anzeigt, an der die beiden benachbarten Gruppen Y bzw. X für CR stehen und die jeweiligen Reste R zusammen mit den C-Atomen einen Ring gemäß einer der Formeln (4) bis (10) aufspannen.

In den oben abgebildeten Strukturen der Formeln (4) bis (10) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wesentlich bei den Gruppen der Formeln (4) bis (10) ist, dass diese keine aziden benzylischen Protonen aufweisen. Unter benzylischen Protonen werden Protonen verstanden, die an ein Kohlenstoffatom binden, welches direkt an den Liganden gebunden sind. Die Abwesenheit von aziden benzylischen Protonen wird in den Formeln (4) bis (6) dadurch erreicht, dass A¹ und A³, wenn diese für C(R³)₂ stehen, so definiert sind, dass R³ ungleich Wasserstoff ist. Die Abwesenheit von aziden benzylischen Protonen ist in Formeln (7) bis (10) dadurch erreicht, dass es sich dabei um eine bicyclische Struktur handelt. Aufgrund der starren räumlichen Anordnung ist R¹, wenn es für H steht, deutlich weniger azide als benzylische Protonen, da das korrespondierende Anion der bicyclischen Struktur nicht mesomeriestabilisiert ist. Auch wenn R¹ in Formeln (7) bis (10) für H steht, handelt es sich dabei daher um ein nicht-azides Proton im Sinne der vorliegenden Anmeldung.

In einer bevorzugten Ausführungsform der Struktur gemäß Formel (4) bis (10) steht maximal eine der Gruppen A¹, A² und A³ für ein Heteroatom, und die anderen Gruppen stehen für C(R³)₂ bzw. C(R¹)₂ oder A¹ und A³ stehen gleich oder verschieden bei jedem Auftreten für NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂ oder CH₂.

Bevorzugte Ausführungsformen der Formel (4) sind somit die Strukturen der Formel (4-A), (4-B), (4-C) und (4-D), und eine besonders bevorzugte Ausführungsform der Formel (4-A) sind die Strukturen der Formel (4-E) und (4-F), 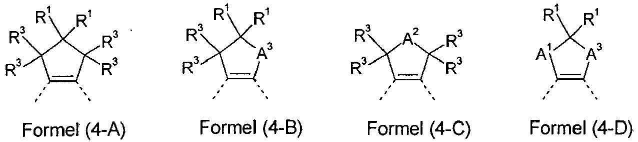 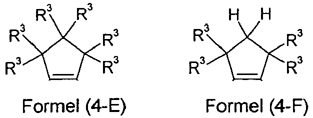 wobei R¹ und R³ die oben genannten Bedeutungen aufweisen und A¹, A² und A³ gleich oder verschieden bei jedem Auftreten für O oder NR³ steht. Bevorzugte Ausführungsformen der Formel (5) sind die Strukturen der folgenden Formeln (5-A) bis (5-F), 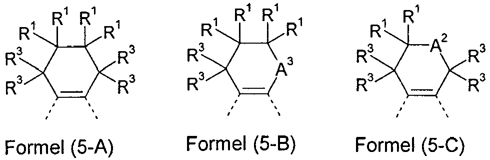 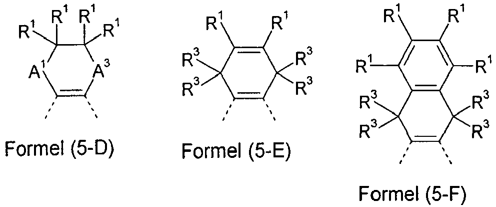 wobei R¹ und R³ die oben genannten Bedeutungen aufweisen und A¹ und A³ gleich oder verschieden bei jedem Auftreten für NR³ steht und A² gleich oder verschieden bei jedem Auftreten für O oder NR³ steht.

Bevorzugte Ausführungsformen der Formel (6) sind die Strukturen der folgenden Formeln (6-A) bis (6-E), 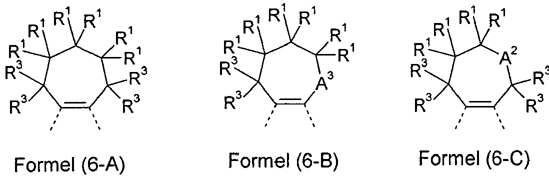 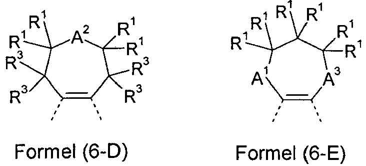 wobei R¹ und R³ die oben genannten Bedeutungen aufweisen und A¹ und A³ gleich oder verschieden bei jedem Auftreten für NR³ steht und A² gleich oder verschieden bei jedem Auftreten für O oder NR³ steht.

In einer bevorzugten Ausführungsform der Struktur gemäß Formel (7) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (7) sind somit eine Strukturen der Formel (7-A) und (7-B), und eine besonders bevorzugte Ausführungsform der Formel (7-A) ist eine Struktur der Formel (7-C), 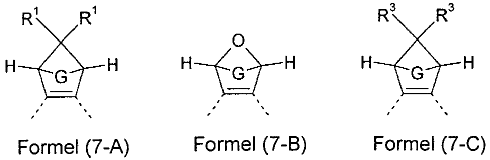 wobei die verwendeten Symbole die oben genannten Bedeutungen aufweisen.

In einer bevorzugten Ausführungsform der Struktur gemäß Formel (8), (9) und (10) stehen die Reste R¹, die an den Brückenkopf gebunden sind, für H, D, F oder CH₃. Weiterhin bevorzugt steht A² für C(R¹)₂. Bevorzugte Ausführungsformen der Formel (8), (9) und (10) sind somit die Strukturen der Formeln (8-A), (9-A) und (10-A), 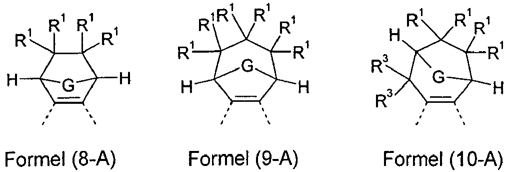 wobei die verwendeten Symbole die oben genannten Bedeutungen aufweisen.

Weiterhin bevorzugt steht die Gruppe G in den Formeln (7), (7-A), (7-B), (7-C), (8), (8-A), (9), (9-A), (10) und (10-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (4) bis (10) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (4) bis (10) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (4) sind die im Folgenden aufgeführten Gruppen (4-1) bis (4-69):

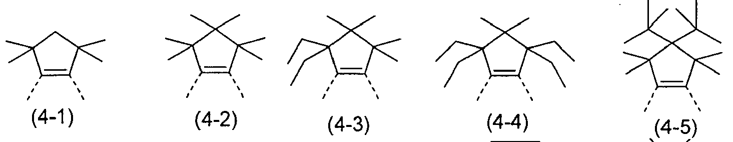

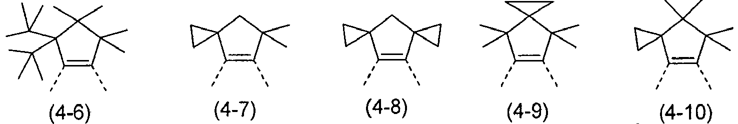

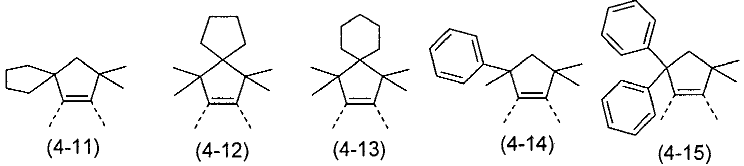

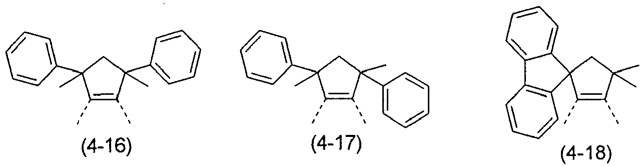

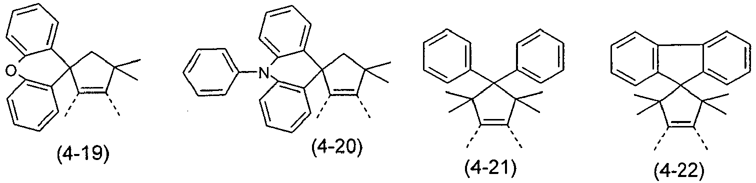

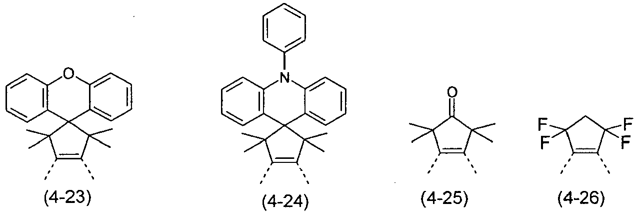

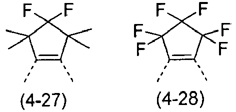

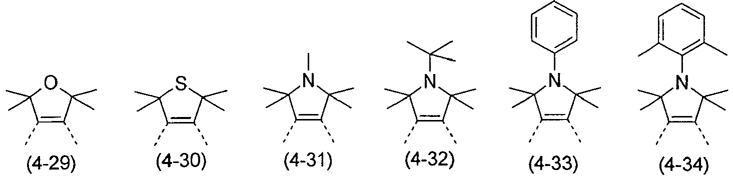

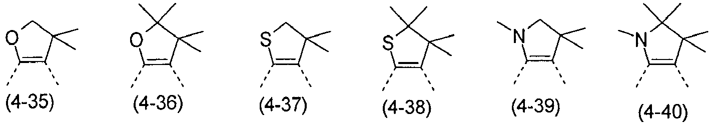

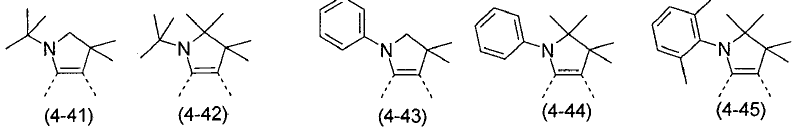

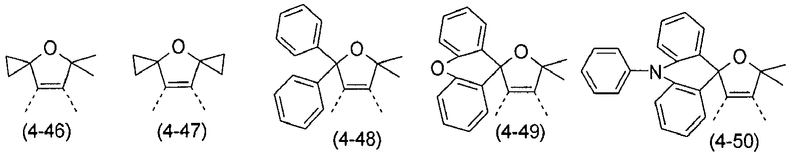

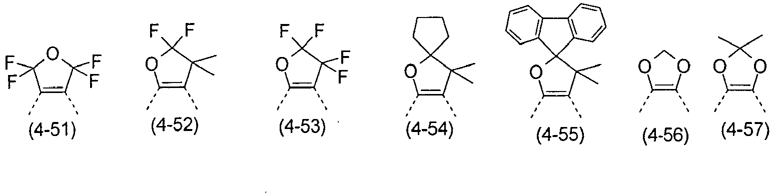

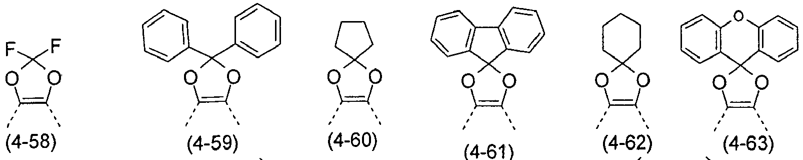

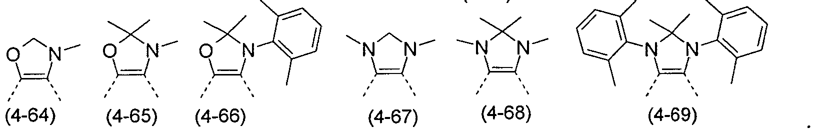

Beispiele für besonders geeignete Gruppen der Formel (5) sind die im Folgenden aufgeführten Gruppen (5-1) bis (5-14):

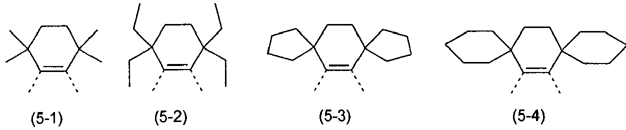

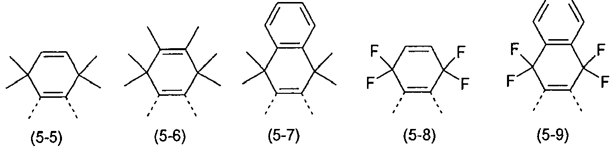

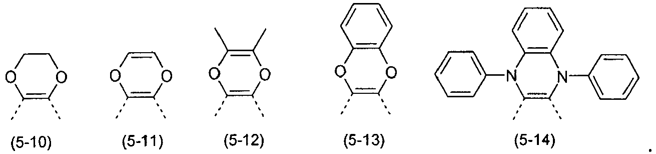

Beispiele für besonders geeignete Gruppen der Formel (6), (9) und (10) sind die im Folgenden aufgeführten Gruppen (6-1), (9-1) und (10-1):

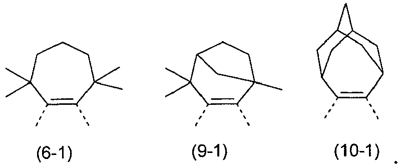

Beispiele für besonders geeignete Gruppen der Formel (7) sind die im Folgenden aufgeführten Gruppen (7-1) bis (7-22):

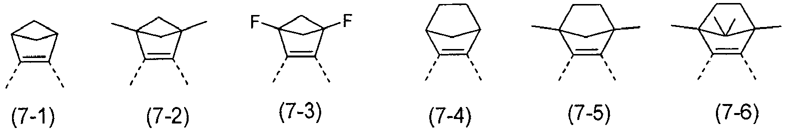

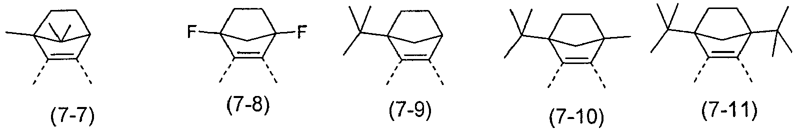

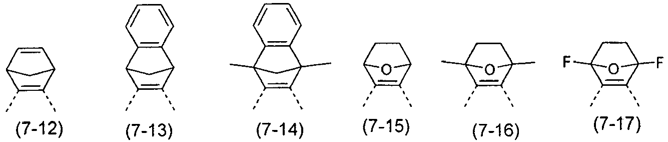

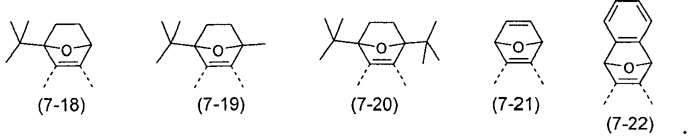

Beispiele für besonders geeignete Gruppen der Formel (8) sind die im Folgenden aufgeführten Gruppen (8-1) bis (8-5):

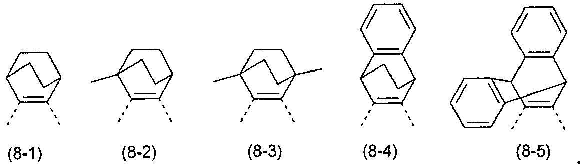

Insbesondere die Verwendung derartiger ankondensierter bicyclischer Strukturen kann aufgrund der Chiralität der Strukturen auch zu chiralen Liganden L führen. Hier kann sowohl die Verwendung enantiomerenreiner Liganden wie auch die Verwendung des Racemats geeignet sein. Es kann auch insbesondere geeignet sein, im erfindungsgemäßen Metallkomplex nicht nur ein Enantiomer von einem Liganden zu verwenden, sondern gezielt beide Enantiomere, so dass beispielsweise ein Komplex (+L)₂(-L)M oder ein Komplex (+L)(-L)₂M entsteht, wobei +L bzw. -L jeweils das entsprechende + bzw- Enantiomer des Liganden kennzeichnen. Dies kann Vorteile bezüglich der Löslichkeit des entsprechenden Komplexes gegenüber Komplexen, die nur +L oder nur -L als Ligand enthalten, haben.

Wenn in der Teilstruktur der Formel (2) noch weitere bzw. andere Reste R gebunden sind, so sind diese Reste R bei jedem Auftreten gleich oder verschieden bevorzugt ausgewählt aus der Gruppe bestehend aus H, D, F, N(R¹)₂, CN, Si(R¹)₃, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch F ersetzt sein können, oder einem aromatischen oder heteroaromatischen Ringsystem mit 5 bis 18 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden. Wenn es sich um ein aromatisches oder heteroaromatisches Ringsystem handelt, ist es bevorzugt, wenn dieses nicht mehr als zwei direkt aneinander ankondensierte aromatische 6-Ringe aufweist, insbesondere überhaupt keine direkt aneinander ankondensierten aromatischen 6-Ringe.

Im Folgenden werden bevorzugte Liganden L' beschrieben, wie sie Verbindungen der Formel (1) vorkommen können. Die Liganden L' sind definitionsgemäß mono- oder bidentate Liganden. Die Liganden L' sind bevorzugt neutrale, monoanionische, dianionische oder trianionische Liganden, besonders bevorzugt neutrale oder monoanionische Liganden. Bevorzugt sind bidentate Liganden L'.

Bevorzugte neutrale, monodentate Liganden L' sind ausgewählt aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri*-tert-*butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L' sind ausgewählt aus Hydrid, Deuterid, den Halogeniden F⁻, Cl⁻, Br⁻ und I⁻, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, iso-Propanolat, tert-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Bevorzugte di- bzw. trianionische Liganden sind O²⁻, S²⁻, Carbide, welche zu einer Koordination der Form R-C≡M führen, und Nitrene, welche zu einer Koordination der Form R-N=M führen, wobei R allgemein für einen Substituenten steht, und N³⁻.

Bevorzugte neutrale oder mono- oder dianionische, bidentate oder höherdentate Liganden L' sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]pyridin, 2-[1-(2-Methylphenylimino)ethyl]pyridin, 2-[1-(2,6-Di-*iso*-propylphenylimino)ethyl]pyridin, 2-[1-(Methylimino)ethyl]pyridin, 2-[1-(ethylimino)ethyl]pyridin, 2-[1-(*Iso*-Propylimino)ethyl]pyridin, 2-[1-(*Tert-*Butylimino)ethyl]pyridin, Diminen, wie z. B. 1,2-Bis(methylimino)ethan, 1,2-Bis(ethylimino)ethan, 1,2-Bis(*iso*-propylimino)ethan, 1,2-Bis(*tert*-butyl-imino)ethan, 2,3-Bis(methylimino)butan, 2,3-Bis(ethylimino)butan, 2,3-Bis-(*iso*-propylimino)butan, 2,3-Bis(*tert*-butylimino)butan, 1,2-Bis(phenylimino)-ethan, 1,2-Bis(2-methylphenylimino)ethan, 1,2-Bis(2,6-di-*iso*-propylphenylimino)ethan, 1,2-Bis(2,6-di-*tert*-butylphenylimino)ethan, 2,3-Bis(phenylimino)butan, 2,3-Bis(2-methylphenylimino)butan, 2,3-Bis(2,6-di-*iso*-propylphenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)propan, Bis(diphenylphosphino)butan, Bis(dimethylphosphino)methan, Bis(dimethylphosphino)-ethan, Bis(dimethylphosphino)propan, Bis(diethylphosphino)methan, Bis-(diethylphosphino)ethan, Bis(diethylphosphino)propan, Bis(di-*tert*-butylphosphino)methan, Bis(di-*tert*-butylphosphino)ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 2,2,6,6-Tetramethyl-3,5-heptandion, 3-Ketonaten abgeleitet von 3-Ketoestern, wie z. B. Acetylacetat, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

In einer weiteren bevorzugten Ausführungsform der Erfindung handelt es sich bei den Liganden L' um bidentate monoanionische Liganden, welche mit dem Iridium einen cyclometallierten Fünfring oder Sechsring mit mindestens einer Iridium-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (15) bis (42) dargestellt sind, wobei eine Gruppe über ein neutrales Atom und die andere Gruppe über ein negativ geladenes Atom bindet. Dabei ist das neutrale Atom insbesondere ein neutrales Stickstoffatom oder ein Carben-Kohlenstoffatom und das negativ geladene Atom insbesondere ein negativ geladenes Kohlenstoffatom, ein negativ geladenes Stickstoffatom oder ein negativ geladenes Sauerstoffatom. Der Ligand L' kann dann aus den Gruppen der Formeln (15) bis (42) gebildet werden, indem diese Gruppen jeweils an der durch # gekennzeichneten Position aneinander binden. Die Position, an der die Gruppen an das Metall koordinieren, sind durch * gekennzeichnet. Weiterhin können hier auch zwei benachbarte Reste R, die jeweils an den beiden Gruppen der Formeln (15) bis (42) gebunden sind, miteinander ein aliphatisches oder aromatisches Ringsystem bilden.

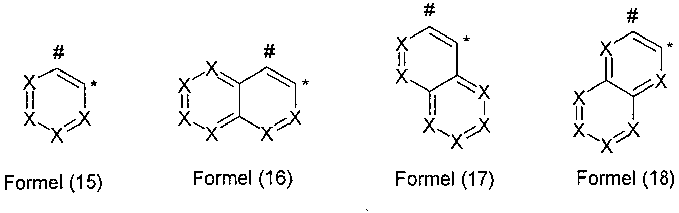

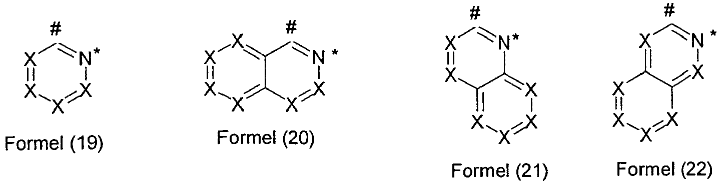

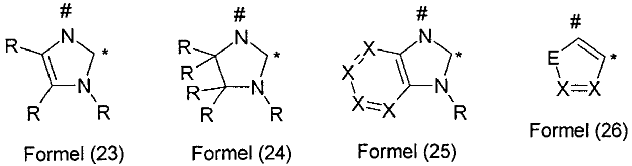

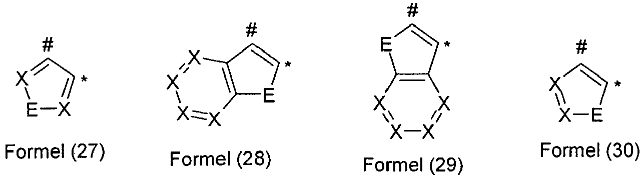

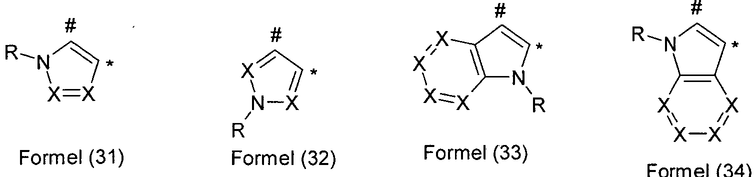

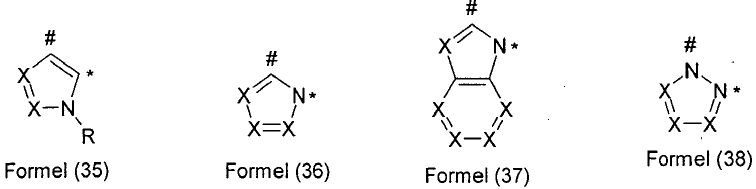

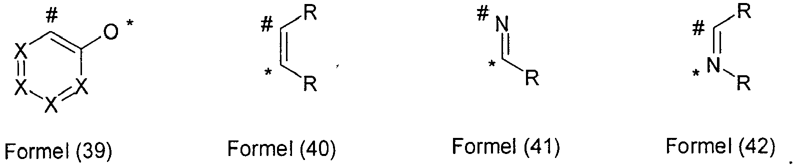

Dabei haben die verwendeten Symbole dieselbe Bedeutung wie oben beschrieben, E steht für O, S oder CR₂, und bevorzugt stehen maximal zwei Symbole X in jeder Gruppe für N, besonders bevorzugt steht maximal ein Symbol X in jeder Gruppe für N. Ganz besonders bevorzugt stehen alle Symbole X für CR.

In einer ganz besonders bevorzugten Ausführungsform der Erfindung handelt es sich bei dem Liganden L' um einen monoanionischen bidentaten Liganden, der aus zwei der Gruppen der Formel (15) bis (42) gebildet wird, wobei eine dieser Gruppen über ein negativ geladenes Kohlenstoffatom und die andere dieser Gruppen über ein neutrales Stickstoffatom an das Iridium koordiniert.

Ebenfalls kann es bevorzugt sein, wenn zwei benachbarte Symbole X in diesen Liganden für eine Gruppe gemäß einer der oben genannten Formeln (4) bis (10) stehen.

Die weiteren bevorzugten Reste R in den oben aufgeführten Strukturen sind definiert wie die Reste R des Liganden L.

Die Liganden L und L' können je nach Struktur auch chiral sein. Dies ist insbesondere dann der Fall, wenn sie eine bicyclische Gruppe der Formel (7) bis (10) enthalten oder wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln bei Raumtemperatur in ausreichender Konzentration löslich, um die Komplexe aus Lösung verarbeiten zu können, beispielsweise durch Druckverfahren.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die Verbindungen können auch als chirale, enantiomerenreine Komplexe eingesetzt werden, welche circular polarisiertes Licht emittieren können. Dies kann Vorteile aufweisen, da dadurch der Polarisationsfilter auf dem Device eingespart werden kann. Außerdem eignen sich solche Komplexe auch zur Verwendung in Sicherheitslabeln, da sie neben der Emission auch die Polarisation des Lichts als einfach auslesbares Merkmal aufweisen.

Ein weiterer Gegenstand der vorliegenden Erfindung sind Oligomere, Polymere und Dendrimere, enthaltend mindestens eine erfindungsgemäße Verbindung, wobei die Verbindung statt einem oder mehreren Resten eine Bindung zum Oligomer, Polymer oder Dendrimer aufweist.

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der erfindungsgemäßen Verbindungen gemäß Formel (1) durch Umsetzung der entsprechenden freien Liganden mit Iridiumalkoholaten der Formel (43), mit Iridiumketoketonaten der Formel (44), mit Iridiumhalogeniden der Formel (45) oder mit dimeren Iridiumkomplexen der Formel (46) oder (47), 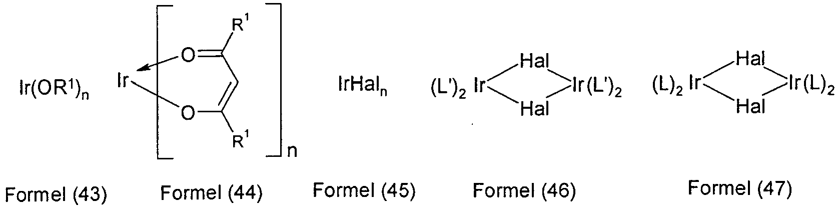 wobei die Symbole und Indizes L', m, n und R¹ die oben angegebenen Bedeutungen haben und Hal = F, Cl, Br oder I ist.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet ist [IrCl₂(acac)₂]⁻, beispielsweise Na[IrCl₂(acac)₂]. Weitere besonders geeignete Iridiumedukte sind Iridium(III)-tris(acetylacetonat) und Iridium(III)-tris(2,2,6,6-tetramethyl-3,5-heptandionat).

Die Synthese kann auch durch Umsetzung der Liganden L mit Iridiumkomplexen der Formel [Ir(L')₂(HOMe)₂]A oder [Ir(L')₂(NCMe)₂]A oder durch Umsetzung der Liganden L' mit Iridiumkomplexen der Formel [Ir(L)₂(HOMe)₂]A oder [Ir(L)₂(NCMe)₂]A, wobei A jeweils ein nicht koordinierendes Anion, wie z. B. Triflat, Tetrafluoroborat, Hexafluorophosphat, etc., darstellt, in dipolar-protischen Lösungsmitteln, wie z. B. Ethylenglykol, Propylenglykol, Glycerin, Diethylenglykol, Triethylenglykol, etc., durchgeführt werden.

Die Synthese der Komplexe wird bevorzugt durchgeführt wie in WO 2002/060910 und in WO 2004/085449 beschrieben. Heteroleptische Komplexe können beispielsweise auch gemäß WO 05/042548 synthetisiert werden. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMOS) oder Sulfone (Dimethylsulfon, Sulfolan, etc.). Geeignete Schmelzhilfen sind Verbindungen, die bei Rautemperatur fest vorliegen, jedoch beim Erwäremen der Reaktionsmischung schmelzen und die Reaktanden lösen, so dass eine homogene Schmelze entsteht. Besonders geeignet sind Biphenyl, m-Terphenyl, Triphenylen, 1,2-, 1,3-, 1,4-Bisphenoxybenzol, Triphenylphosphinoxid, 18-Krone-6, Phenol, 1-Naphthol, Hydrochinon, etc..

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, enthaltend eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die oben beschriebenen Komplexe gemäß Formel (1) bzw. die oben aufgeführten bevorzugten Ausführungsformen können in einer elektronischen Vorrichtung als aktive Komponente verwendet werden. Ein weiterer Gegenstand der vorliegenden Erfindung ist daher die Verwendung einer Verbindung nach Formel (1) bzw. nach einer der bevorzugten Ausführungsformen in einer elektronischen Vorrichtung. Weiterhin können die erfindungsgemäßen Verbindungen zur Erzeugung von Singulett-Sauerstoff, in der Photokatalyse oder in Sauerstoffsensoren eingesetzt werden.

Nochmals ein weiterer Gegenstand der vorliegenden Erfindung ist eine elektronische Vorrichtung enthaltend mindestens eine Verbindung gemäß Formel (1) bzw. nach einer der bevorzugten Ausführungsformen.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Eine bevorzugte Ausführungsform sind Dreischichtsysteme, wobei die drei Schichten blaue, grüne und orange oder rote Emission zeigen (siehe z. B. WO 2005/011013) bzw. Systeme, welche mehr als drei emittierende Schichten aufweisen. Eine weitere bevorzugte Ausführungsform sind Zweischichtsysteme, wobei die beiden Schichten entweder blaue und gelbe oder blaugrüne und orange Emission zeigen. Zweischichtsysteme sind insbesondere für Beleuchtungsanwendungen von Interesse. Solche Ausführungsformen sind mit den erfindungsgemäßen Verbindungen besonders geeignet, da diese häufig gelbe bzw. orange Emission zeigen. Die weiß emittierenden Elektrolumineszenzvorrichtungen können für Beleuchtungsanwendungen oder als Backlight für Displays oder mit Farbfilter als Display eingesetzt werden.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bzw. der Matrixmaterialien bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Berylliumkomplexe, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen. Hierfür eignen sich insbesondere Mischungen aus mindestens einem elektronentransportierenden Matrixmaterial und mindestens einem lochtransportierenden Matrixmaterial oder Mischungen aus mindestens zwei elektronentransportierenden Matrixmaterialien oder Mischungen aus mindestens einem loch- oder elektronentransportierenden Matrixmaterial und mindestens einem weiteren Material mit einer großen Bandlücke, welches somit weitgehend elektrisch inert ist und nicht oder nicht in wesentlichem Umfang am Ladungstransport teilnimmt, wie z. B. in WO 2010/108579 beschrieben. Eine bevorzugte Kombination ist beispielsweise die Verwendung eines aromatischen Ketons oder eines Triazinderivats mit einem Triarylamin-Derivat oder einem Carbazol-Derivat als gemischte Matrix für den erfindungsgemäßen Metallkomplex.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise blau oder grün emittierende Triplettemitter als Co-Matrix für die erfindungsgemäßen Komplexe gemäß Formel (1) eingesetzt werden.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

In den weiteren Schichten können generell alle Materialien verwendet werden, wie sie gemäß dem Stand der Technik für die Schichten verwendet werden und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Organische Elektrolumineszenzvorrichtungen enthaltend Verbindungen gemäß Formel (1) als emittierende Materialien weisen eine sehr gute Lebensdauer auf. Insbesondere weisen sie eine bessere Lebensdauer auf als Elektrolumineszenzvorrichtungen, welche analoge Verbindungen enthalten, die keinen ankondensierten aliphatischen Fünfring der Formel (4) oder (5) enthalten.
2. Organische Elektrolumineszenzvorrichtungen enthaltend Verbindungen gemäß Formel (1) als emittierende Materialien weisen eine sehr gute Effizienz auf. Insbesondere weisen sie eine bessere Effizienz auf als Elektrolumineszenzvorrichtungen, welche analoge Verbindungen enthalten, die keinen ankondensierten aliphatischen Fünfring der Formel (4) oder (5) enthalten.
3. Organische Elektrolumineszenzvorrichtungen enthaltend Verbindungen gemäß Formel (1) als emittierende Materialien weisen eine sehr niedrige Betriebsspannung auf.
4. Die erfindungsgemäßen Verbindungen emittieren auch bei hohen Temperaturen und weisen kein oder kaum thermisches Quenching auf. Sie sind somit auch für Anwendungen, die einer hohen thermischen Belastung ausgesetzt sind, geeignet.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße Verbindungen synthetisieren und diese in elektronischen Vorrichtungen verwenden und kann somit die Erfindung im gesamten offenbarten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone S:

### Beispiel S1: 5-iso-Butyl-[2,6]naphthylridin-1-ylamin

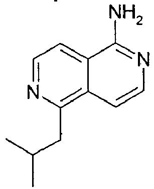

Ein Gemisch aus 18.0 g (100 mmol) 5-Chlor-[2,6]naphthyridin-1-ylamin [1392428-85-1], 15.3 g (150 mmol) iso-Butylboronsäure [84110-40-7], 46.1 g (200 mmol) Trikaliumphosphat-monohydrat, 2.5 g (6 mmol) S-Phos, 674 mg (3 mmol) Palladium(II)acetat, 100 g Glaskugeln (Durchmesser 3 mm), 400 ml Toluol und 6 ml Wasser wird 24 h unter Rückfluss erhitzt. Nach Erkalten wäscht man die Reaktionsmischung dreimal mit je 200 ml Wasser, einmal mit 200 ml gesättigter Kochsalzlösung, trocknet über Natriumsulfat und entfernt dann das Lösungsmittel im Vakuum. Dreimalige Umkristallisation aus Cyclohexan. Ausbeute 14.9 g (74 mmol), 74 %. Reinheit ca. 98.0 %ig n. ¹H-NMR.

Analog können folgende Verbindungen dargestellt werden.

| **Bsp.** | **Boronsäure** | **Produkt** | **Ausbeute** |
|---|---|---|---|
| S2 | 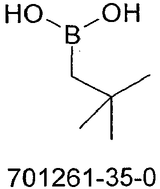 | 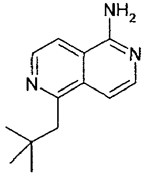 | 67 % |
| S3 | 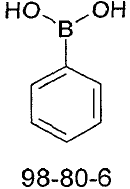 | 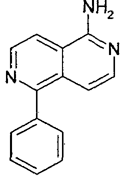 | 70 % |

### Beispiel S4:

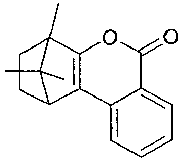

Durchführung nach J. Langer et. al, Synthesis, 2006, 16, 2697.

Ein Gemisch aus 3.4 g (10 mmol) [Benzoato-κC², κO¹](2,2'-bipyridin-κN¹, κN¹)nickel(II) [76262-92-5] und 2.3 g (10 mmol) (1R,3S,4S)-3-Brom-1,7,7-trimethyl-bicyclo[2.2.1]heptan-2-on [10293-06-8] in 150 ml THF wird 30 h bei 50 °C gerührt, bis eine grüne Suspension entstanden ist. Das THF wird im Vakuum entfernt, der Rückstand wird 1 h mit 200 ml 2 N Salzsäure gerührt und dann fünfmal mit je 100 ml Dichlormethan extrahiert. Die vereinigten organischen Phasen werden fünfmal mit je 200 ml gesättigter Natriumcarbonat-Lösung ausgeschüttelt. Die vereinigten wässrigen Phasen werden mit konz. Salzsäure sauer gestellt und dann fünfmal mit je 100 ml Dichlormethan extrahiert. Nach Trocknen über Magnesiumsulfat werden die vereinigten organischen Phasen vom Lösungsmittel befreit, der Rückstand wird mit 100 ml Essigsäureanhydrid versetzt und 2 h unter Rückfluss erhitzt. Nach Entfernen des Essigsäureanhydrids im Vakuum wird der Rückstand einmal aus Aceton / n-Heptan umkristallisiert. Ausbeute 1.8 g (7.1 mmol), 71 %. Reinheit ca. 98.0 %ig n. ¹H-NMR.

Analog können folgende Verbindungen dargestellt werden.

| **Bsp.** | **β-Halo-keton** | **iso-Chromen-1-on** | **Ausbeute** |
|---|---|---|---|
| S5 | 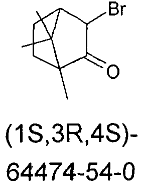 | 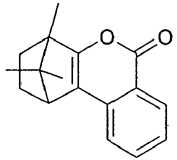 | 74 "% |
| S6 | 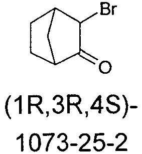 | 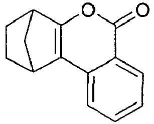 | 68% |
| S7 | 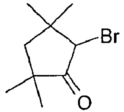 | 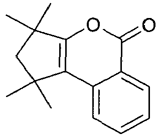 | 73 % |
| S8 | 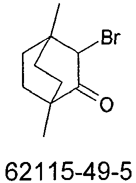 | 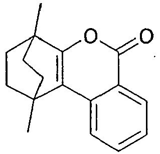 | 70 % |
| S9 | 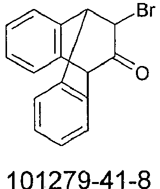 | 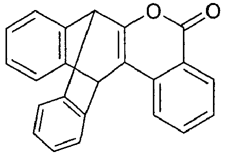 | 46 % |
| S10 | 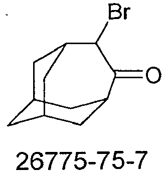 | 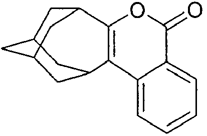 | 69% |

### B: Synthese der Liganden:

### 1) 3,4-Anellierte Pyrimido[2,1-a]isochinolin-2-one

### a) Aus 1-Amino-isochinolinen und β-Ketocarbonsäuren

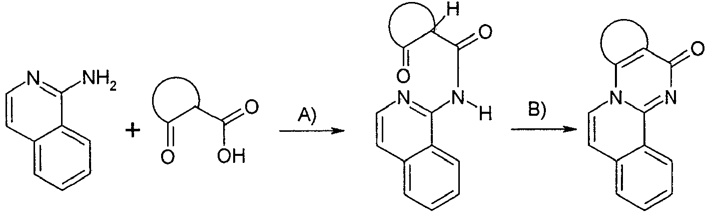

A) Ein gut gerührtes Gemisch aus 100 mmol 1-Amino-isochniolin, 120 mmol der Ketocarbonsäure, 5 mmol 4-Dimethylaminopyridin und 300 ml Dichlormethan wird bei Raumtemperatur alle 2 h mit insgesamt 5 Portionen zu je 32 mmol Dicyclohexylcarbodimid versetzt und dann 16 h nachgerührt. Man filtriert vom ausgefallenen Dicyclohexylharnstoff ab, wäscht diesen mit wenig Dichlormethan nach, engt die Reaktionsmischung auf ca. 100 ml ein und chromatographiert an Kieselgel mit Dichlormethan, wobei zunächst Nebenprodukte eluiert werden und dann durch Umstellen auf Ethylacetat das Produkt eluiert wird. Das so als Öl erhaltene Rohprodukt wird in B) weiter umgesetzt.
B) Variante 1:
   Durchführung analog J. Heterocycl. Chem., 2004, 41, 2, 187.
   Ein Gemisch aus 100 mmol des Carboxamids aus A), 10 g Polyphosphorsäure und 45 ml Phosphorylchlorid wird in einem Autoklaven 60 h bei 100 °C gerührt. Nach Erkalten wird die Reaktionsmischung auf 500 ml Eiswasser gegeben (Achtung: Exotherm!) mit 10 Gew.-%iger NaOH auf pH 8 eingestellt und fünfmal mit je 100 ml Dichlormethan extrahiert. Die vereinigten Dichlormethan-Extrakte werden einmal mit 100 ml Wasser und einmal mit 100 ml gesättigter Kochsalz-Lösung gewaschen und dann über Magnesiumsulfat getrocknet. Nach Einengen wird der Rückstand an Kieselgel chromatographiert oder unkristallisiert. Die so erhaltenen Produkte werden durch Tempern im Hochvakuum bzw. durch fraktionierte Kugelrohrdestillation oder Sublimation von Leichtsiedern und nicht flüchtigen Nebenkomponenten befreit.
B) Variante 2:
   Eine auf -78 °C gekühlte Lösung von 100 mmol des Carboxamids aus A) in 500 ml THF wird tropfenweise mit 50 ml (100 mmol) einer Lösung von Lithium-di-isopropylamid (2.0 M in THF, Ether, Benzol) versetzt und 15 min. gerührt. Dann tropft man eine Lösung von 100 mmol 1,1,1-Trifluor-N-phenyl-N-[(trifluormethyl)sulfonyl]-methansulfonamid [37595-74-7] in 100 ml THF zu, lässt während 1 h auf 0 °C erwärmen, kühlt die Reaktionsmischung erneut auf -78 °C und versetzt tropfenweise mit 50 ml (100 mmol) einer Lösung von Lithium-di-isopropylamid (2.0 M in THF, Ether, Benzol). Nach Entfernen des Kältebads und Erwärmen auf Raumtemperatur rührt man 16 h bei Raumtemperatur nach, quencht dann durch Zugabe von 15 ml Methanol, entfernt das Lösungsmittel im Vakuum, nimmt den Rückstand in 300 ml Ethylacetat auf, wäscht dreimal mit je 200 ml Wasser, einmal mit 200 ml gesättigter Kochsalzlösung und trocknet über Magnesiumsulfat. Nach Einengen wird der Rückstand an Kieselgel chromatographiert. Die so erhaltenen Produkte werden durch Tempern im Hochvakuum bzw. durch fraktionierte Kugelrohrdestillation oder Sublimation von Leichtsiedern und nicht flüchtigen Nebenkomponenten befreit.

### Beispiel L1:

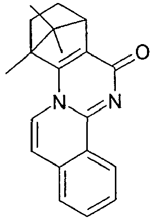

A) Einsatz von 14.4 g (100 mmol) 1-Amino-iso-chinolin [1532-84-9], 25.5 g (130 mmol (1R,2S,4R)-4,7,7-Trimethyl-3-oxo-bicyclo[2.2.1]heptan-2-carbonsäure [18530-30-8], 611 mg (5 mmol) 4-Dimethylaminopyridin [1122-58-3], 33.0 g (160 mmol) Dicyclohexylcarbodiimid [538-75-0]. Chromatographie an Kieselgel (Dichlormethan/Ethylacetat 10:1, vv). Ausbeute: 24.2 g (75 mmol), 75 %. Reinheit ca. 95 % ig n. ¹H-NMR. Gemisch der endo-/exo- und Enol-Form.
B) Variante 1:
   24.2 g (75 mmol) des Carboxamids aus A), 7.6 g Polyphosphorsäure, 35.0 ml Phosphorylchlorid. Chromatographie an Kieselgel (eluieren mit Ethylacetat, dann Umstellen auf Ethylacetat /Methanol 1:1, vv).). Alternativ Umkristallisation aus Ethanol. Fraktionierte Sublimation (p. ca. 10⁻⁵ mbar, T = 210 °C). Ausbeute: 15.5 g (51 mmol), 68 %. Reinheit ca. 99.5 %ig n. ¹H-NMR.

Analog können folgende Verbindungen dargestellt werden.

| **Bsp.** | **Amin** | **β-Ketocarbonsäure** | **Ligand Variante** | **Ausbeute** |
|---|---|---|---|---|
| L2 | 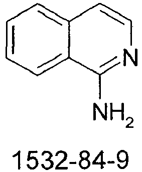 | 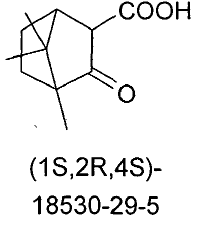 | 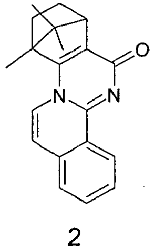 | 53 % |
| L3 | 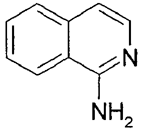 | 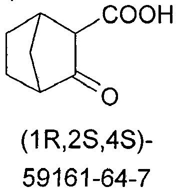 | 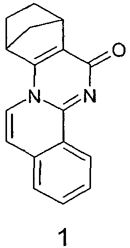 | 50 % |
| L4 | 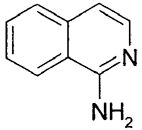 | 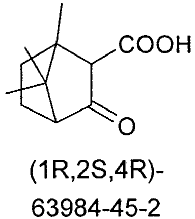 | 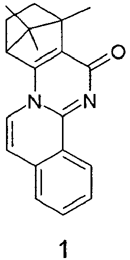 | 41 % |
| L5 | 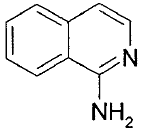 | 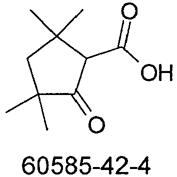 | 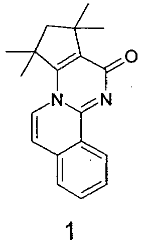 | 52 % |
| L6 | 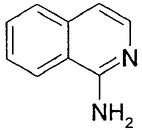 | 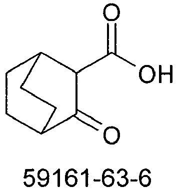 | 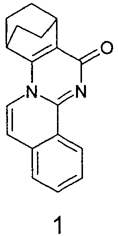 | 55 % |
| L7 | 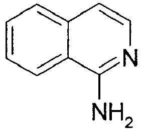 | 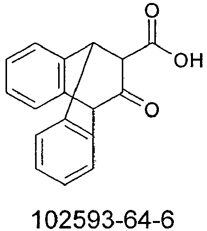 | 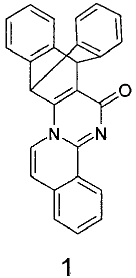 | 53 % |
| L8 | 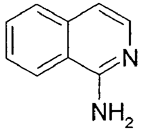 | 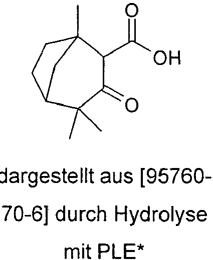 | 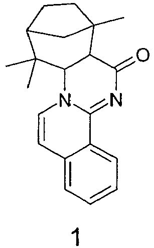 | 48 % |
| L9 | 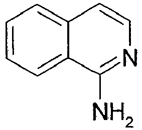 | 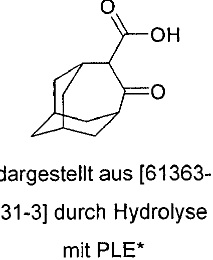 | 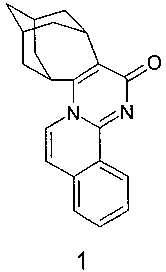 | 54 % |
| L10 | 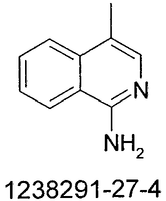 | 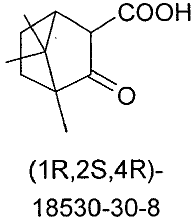 | 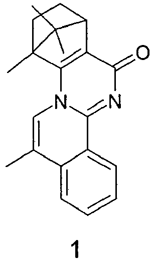 | 49 % |
| L11 | 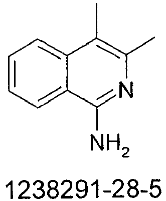 | 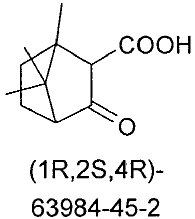 | 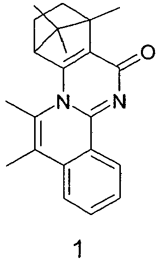 | 40 % |
| L12 | 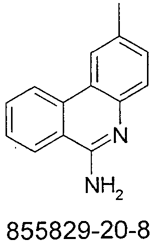 | 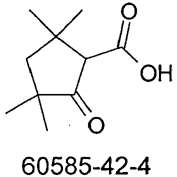 | 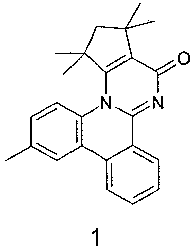 | 51 % |
| L13 | 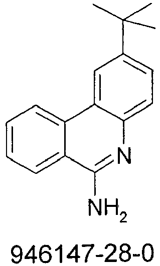 | 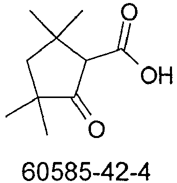 | 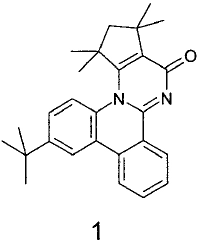 | 57 % |
| L14 | 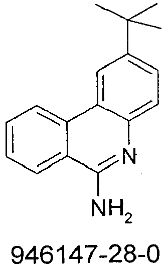 | 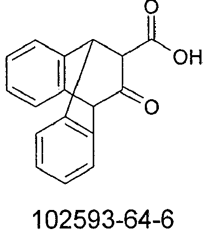 | 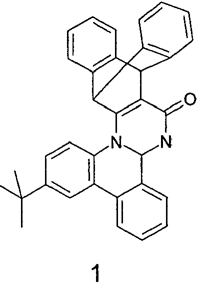 | 48 % |
| L15 | 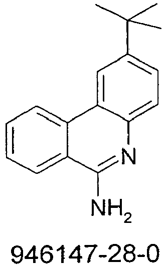 | 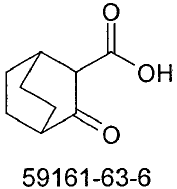 | 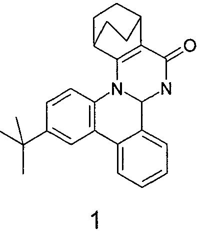 | 55 % |
| L16 | 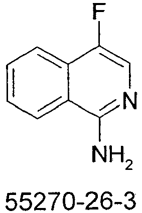 | 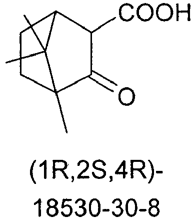 | 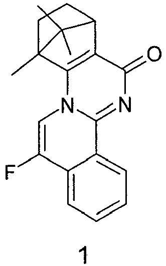 | 50 % |
| L18 | 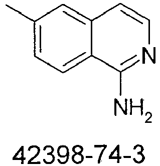 | 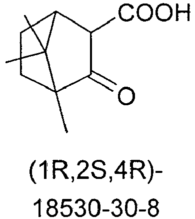 | 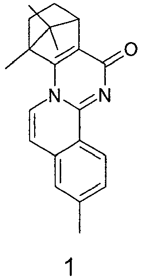 | 50 % |
| L19 | 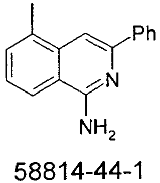 | 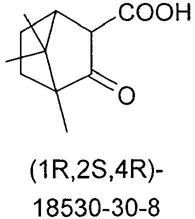 | 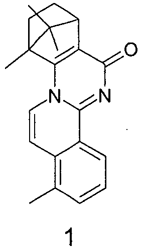 | 49 % |
| L20 | 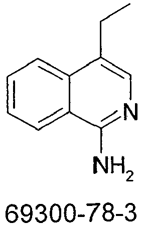 | 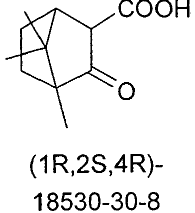 | 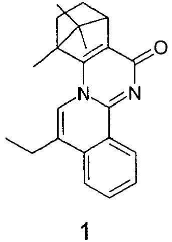 | 47 % |
| L21 | 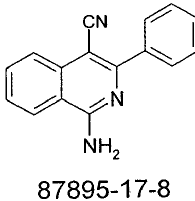 | 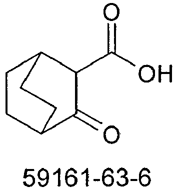 | 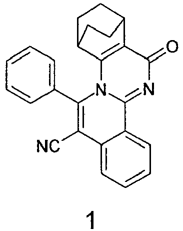 | 23 % |
| L22 | 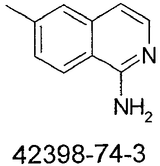 | 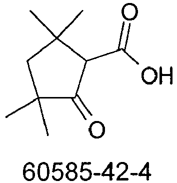 | 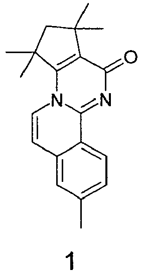 | 55 % |
| L23 | 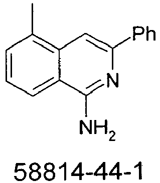 | 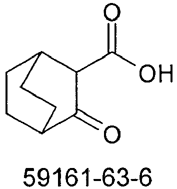 | 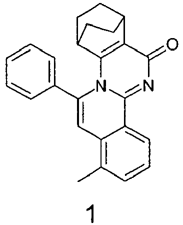 | 53 % |
| L24 | 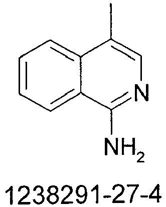 | 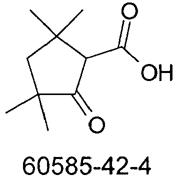 | 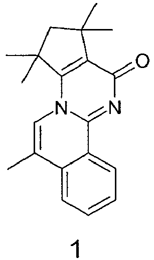 | 49 % |

### 2) 7,8-anellierte 1,5,8a-Triaza-phenanthren-6-one a) Aus [1,6]Naphthyridin-5-ylaminen und β-Ketocarbonsäuren

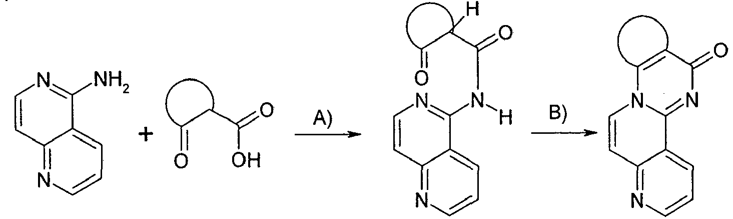

A) Ein gut gerührtes Gemisch aus 100 mmol [1,6]Naphthyridin-5-ylamin, 120 mmol der Ketocarbonsäure, 5 mmol 4-Dimethylaminopyridin und 300 ml Dichlormethan wird bei Raumtemperatur alle 2 h mit insgesamt 5 Portionen zu je 32 mmol Dicyclohexylcarbodimid versetzt und dann 16 h nachgerührt. Man filtriert vom ausgefallenen Dicyclohexylharnstoff ab, wäscht diesen mit wenig Dichlormethan nach, engt die Reaktionsmischung auf ca. 100 ml ein und chromatographiert an Kieselgel mit Dichlormethan, wobei zunächst Nebenprodukte eluiert werden und dann durch Umstellen auf Ethylacetat das Produkt eluiert wird. Das so als Öl erhaltene Rohprodukt wird in B) weiter umgesetzt.
B) Variante 1:
   Durchführung analog J. Heterocycl. Chem., 2004, 41, 2, 187.
   Ein Gemisch aus 100 mmol des Carboxamids aus A), 10 g Polyphosphorsäure, und 45 ml Phosphorylchlorid wird in einm Autoklaven 60 h bei 100 °C gerührt. Nach Erkalten wird die Reaktionsmischung auf 500 ml Eiswasser gegeben (Achtung: Exotherm!) mit 10 Gew.-%iger NaOH auf pH 8 eingestellt und fünfmal mit je 100 ml Dichlormethan extrahiert. Die vereinigten Dichlormethan-Extrakte werden einmal mit 100 ml Wasser und einmal mit 100 ml gesättigter Kochsalz-Lösung gewaschen und dann über Magnesiumsulfat getrocknet. Nach Einengen wird der Rückstand an Kieselgel chromatographiert. Die so erhaltenen Produkte werden durch Tempern im Hochvakuum bzw. durch fraktionierte Kugelrohrdestillation oder Sublimation von Leichtsiedern und nicht flüchtigen Nebenkomponenten befreit.
B) Variante 2:
   Eine auf -78 °C gekühlte Lösung von 100 mmol des Carboxamids aus A) in 500 ml THF wird tropfenweise mit 50 ml (100 mmol) einer Lösung von Lithium-di-isopropylamid (2.0 M in THF, Ether, Benzol) versetzt und 15 min. gerührt. Dann tropft man eine Lösung von 100 mmol 1,1,1-Trifluor-N-phenyl-N-[(trifluormethyl)sulfonyl]-methansulfonamid [37595-74-7] in 100 ml THF zu, lässt während 1 h auf 0°C erwärmen, kühlt die Reaktionsmischung erneut auf -78 °C, und versetzt tropfenweise mit 50 ml (100 mmol) einer Lösung von Lithium-di-isopropylamid (2.0 M in THF, Ether, Benzol). Nach Entfernen des Kältebads und Erwärmen auf Raumtemperatur rührt man 16 h bei Raumtemperatur nach, quencht dann durch Zugabe von 15 ml Methanol, entfernt das Lösungsmittel im Vakuum, nimmt den Rückstand in 300 ml Ethylacetat auf, wäscht dreimal mit je 200 ml Wasser, einmal mit 200 ml gesättigter Kochsalzlösung und trocknet über Magnesiumsulfat. Nach Einengen wird der Rückstand an Kieselgel chromatographiert. Die so erhaltenen Produkte werden durch Tempern im Hochvakuum bzw. durch fraktionierte Kugelrohrdestillation oder Sublimation von Leichtsiedern und nicht flüchtigen Nebenkomponenten befreit.

### Beispiel L25:

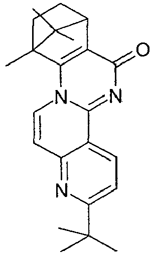

A) Einsatz von 20.1 g (100 mmol) 2-tert-Butyl-[1,6]naphthyridin-5-ylamin [1352329-32-8], 25.5 g (130 mmol (1R,2S,4R)-4,7,7-Trimethyl-3-oxobicyclo[2.2.1]hepatan-2-carbonsäure [18530-30-8], 611 mg (5 mmol) 4-Dimethylaminopyridin [1122-58-3], 33.0 g (160 mmol) Dicyclohexylcarbodiimid [538-75-0]. Chromatographie an Kieselgel (Dichlormethan/Ethylacetat 10:1, vv). Ausbeute: 29.6 g (78 mmol), 78 %. Reinheit ca. 95 % ig n. ¹H-NMR. Gemisch der endo- / exo- und Enol-Form.
Variante 1:
   B) 29.6 g (78 mmol) des Carboxamids aus A), 7.8 g Polyphosphorsäure, 35.1 ml Phosphorylchlorid. Chromatographie an Kieselgel (eluieren mit Ethylacetat, dann Umstellen auf Ethylacetat/Methanol 1:1, vv).). Alternativ Umkristallisation aus Ethanol. Fraktionierte Sublimation (p. ca. 10⁻⁵ mbar, T = 210 °C). Ausbeute: 16.3 g (45 mmol), 58 %. Reinheit ca. 99.5 %ig n. ¹H-NMR.

Analog können folende Verbindunaen dergestellt werden.

| **Bsp.** | **Amin** | **β-Keto-carbonsäure** | **Ligand Variante** | **Aus-beute** |
|---|---|---|---|---|
| L26 | 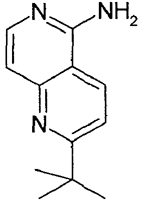 | 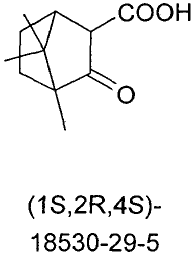 | 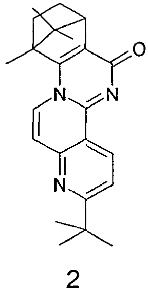 | 47 % |
| L27 | 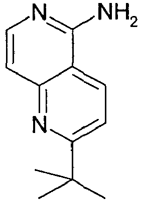 | 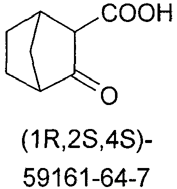 | 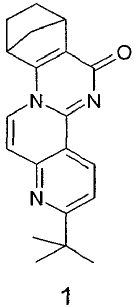 | 45 % |
| L28 | 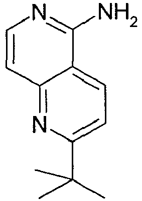 | 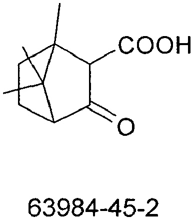 | 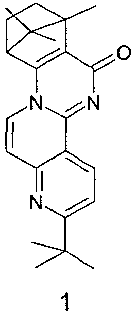 | 33 % |
| L29 | 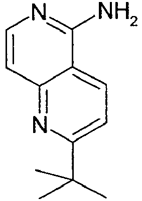 | 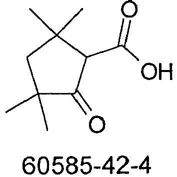 | 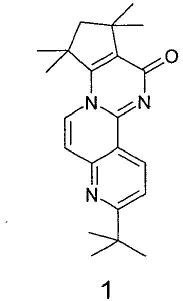 | 48 % |
| L30 | 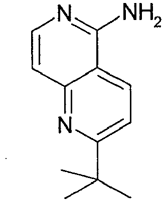 | 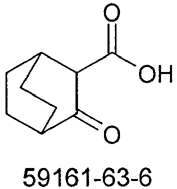 | 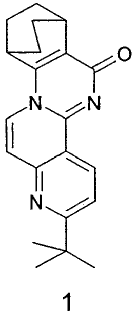 | 56 % |
| L31 | 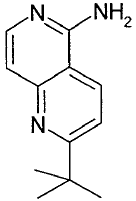 | 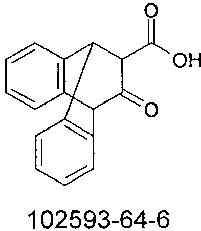 | 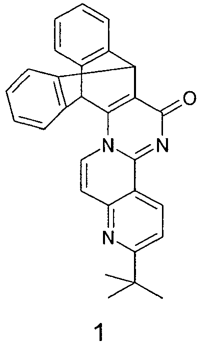 | 51 % |
| L32 | 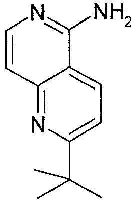 | 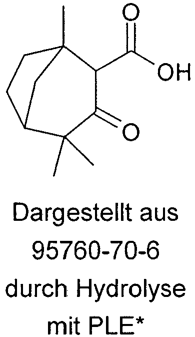 | 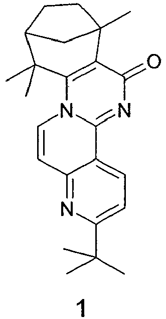 | 24 % |
| L33 | 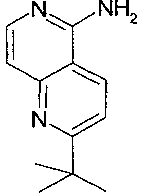 | 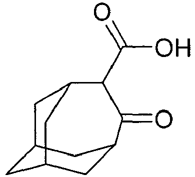 | 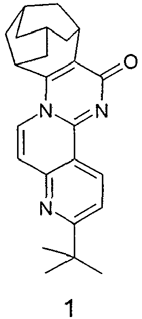 | 20% |
| | | Dargestellt aus 61363-31-3 durch Hydrolyse mit PLE* | | |
| L34 | 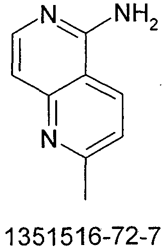 | 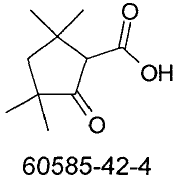 | 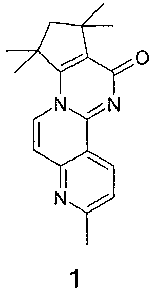 | 46% |
| L35 | 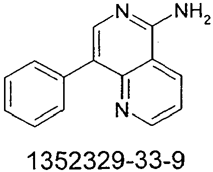 | 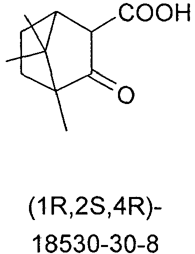 | 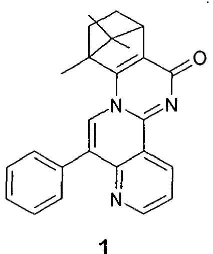 | 51 % |

| | | | | |
|---|---|---|---|---|
| * L. K. P. Lam et al., J. Org. Chem., 1986, 51, 2047. | | | | |

### 3) 9,10-anellierte 1,5,8a-Triazaphenanthren-6-one

### a) Aus 2-Fluor-3-cyanopyridinen, Ketonen und β-Aminoestern

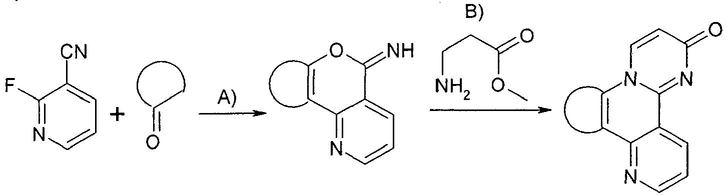

Eine auf -78 °C gekühlte Lösung von 100 mmol des Ketons wird tropfenweise mit 100 ml einer Lösung von Lithium-di-isopropylamid (2.0 M in THF, Ether, Benzol) versetzt und 15 min. gerührt. Dann tropft man eine Lösung von 100 mmol des 2-Fluor-3-cyanopyridins in 100 ml THF zu. Nach Entfernen des Kältebads und Erwärmen auf Raumtemperatur rührt man 3 h bei Raumtemperatur nach. Nach Abziehen des THFs im Vakuum nimmt man den Rückstand in 200 ml Ethylenglykol auf, fügt 110 mmol des β-Aminoester-Hydrochlorids zu und erhitzt am Wasserabscheider 6 h auf 180 °C. Anschließend lässt man auf 60 °C erkalten, rührt 2 h an Luft nach, gießt auf 1000 ml Wasser, stellt mit Ammoniumhydroxid auf pH 9 ein und extrahiert fünfmal mit je 200 ml Dichlormethan. Die vereinigten organischen Phasen werden dreimal mit je 200 ml Wasser und einmal mit 200 ml gesättigter Kochsalzlösung gewaschen und über Magnesiumsulfat getrocknet. Nach Einengen wird der Rückstand an Kieselgel chromatographiert. Die so erhaltenen Produkte werden durch Tempern im Hochvakuum bzw. durch fraktionierte Kugelrohrdestillation oder Sublimation von Leichtsiedern und nicht flüchtigen Nebenkomponenten befreit.

### Beispiel L36:

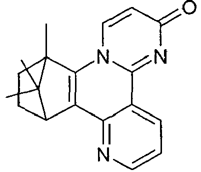

Einsatz von 12.2 g (100 mmol) 2-Fluor-3-cyano-pyridin [3939-13-7], 15.2 g (100 mmol) (1R,4R)-1,7,7-Trimethyl-bicyclo[2.2.1]heptan-2-on, 15.4 g (110 mmol) β-Alanin-methylester-Hydrochlorid [3196-73-4]. Chromatographie an Kieselgel (Dichlormethan/Methanol 6:1, vv). Fraktionierte Sublimation (p ca. 10⁻⁵ mbar, T = 200 °C). Ausbeute: 7.0 g (23 mmol), 23 %. Reinheit ca. 99 % ig n. ¹H-NMR

Analog können folgende Verbindungen dargestellt werden.

| **Bsp.** | **Pyridin** | **Keton β-Aminoester-Hydrochlorid** | **Ligand** | **Aus-beute** |
|---|---|---|---|---|
| L37 | 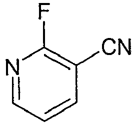 | 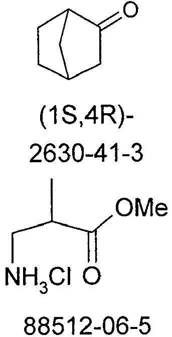 | 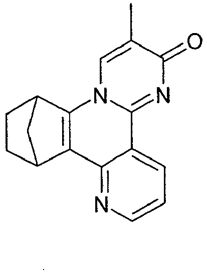 | 24 % |
| L38 | 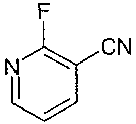 | 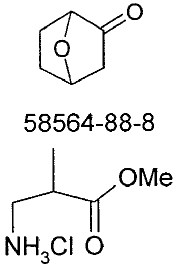 | 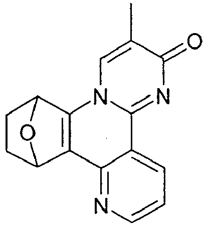 | 20 % |
| L39 | 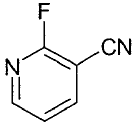 | 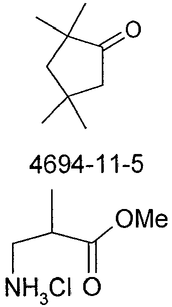 | 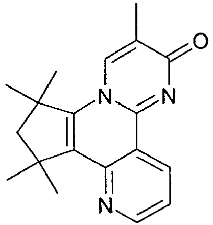 | 23 % |
| L40 | 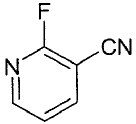 | 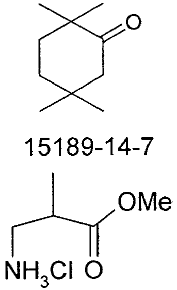 | 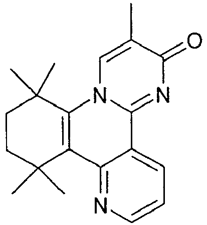 | 25 % |
| L41 | 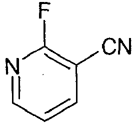 | 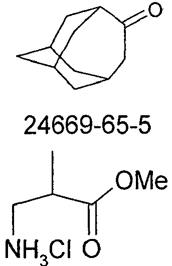 | 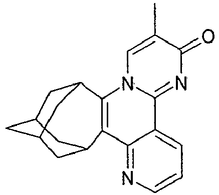 | 21 % |

### 4) 3,4-Anellierte Pyrimido[2,1-a]isochinolin-2-one

### a) Aus 3,4-anellierten iso-Chromen-1-onen und β-Amino-acetamiden

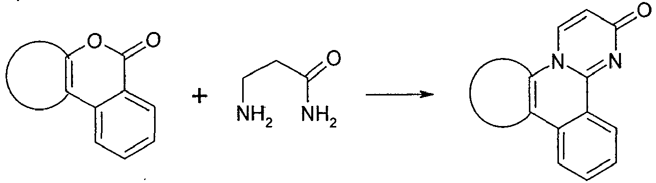

Ein Gemisch aus 10 mmol des iso-Chromen-1-ons und 11 mmol des βAmino-propanamids in 20 ml NMP wird 60 h am Wasserabscheider auf 150 °C erhitzt. Nach Entfernen des Lösungsmittels im Vakuum wird der Rückstand in 10 g Polyphosphorsäure aufgenommen, die Mischung wird homogenisiert und dann an Luft unter Rühren 1 h auf 220 °C erhitzt. Nach Erkalten löst man den Rückstand in 200 ml Wasser, stellt mit fester NaOH alkalisch und extrahiert dreimal mit je 100 ml Dichlormethan. Die vereinigten organischen Phasen werden einmal mit 200 ml Wasser und einmal mit 100 ml gesättigter Kochsalzlösung gewaschen und über Magnesiumsulfat getrocknet. Der nach Entfernen des Lösungsmittels erhaltene Rückstand wird an Kieselgel mit Ethyacetat / n-Heptan (1:1, vv) chromatographiert. Die so erhaltenen Produkte werden durch Tempern im Hochvakuum bzw. durch fraktionierte Kugelrohrdestillation oder Sublimation von Leichtsiedern und nicht flüchtigen Nebenkomponenten befreit.

### Beispiel L42:

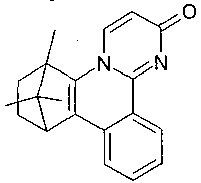

Einsatz von 2.5 g (10 mmol) S4, 969 mg (11 mmol) 3-Amino-propanamid [4726-85-6]. Fraktionierte Sublimation (p ca. 10⁻⁵ mbar, T = 200 °C). Ausbeute: 1.6 g (5.3 mmol), 53%. Reinheit ca. 99.5 %ig n. ¹H-NMR.

Analog können folgende Verbindungen dargestellt werden.

| **Bsp.** | **iso-Chromen-1-on** | **β-Amino-acetamide** | **Ligand** | **Aus-beute** |
|---|---|---|---|---|
| L43 | 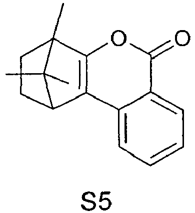 | 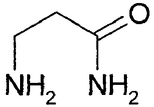 | 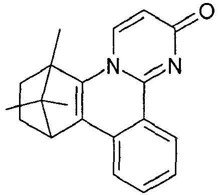 | 55 % |
| L44 | 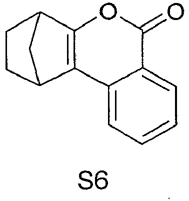 | 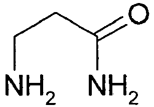 | 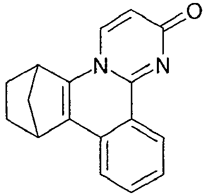 | 48 % |
| L45 | 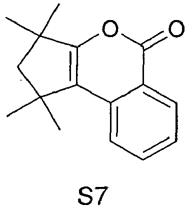 | 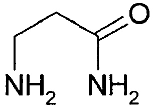 | 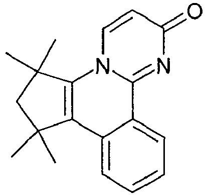 | 45 % |
| L46 | 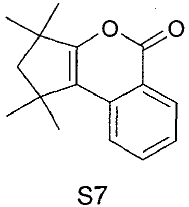 | 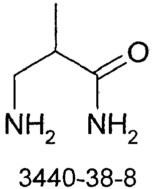 | 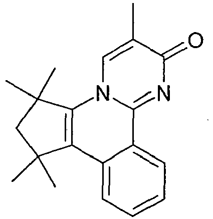 | 50 % |
| L47 | 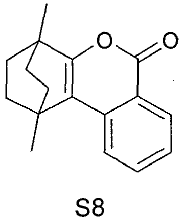 | 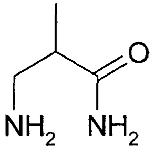 | 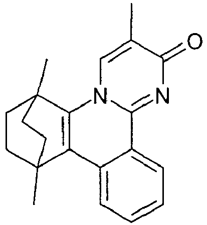 | 47 % |
| L48 | 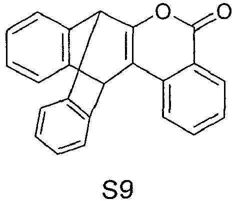 | 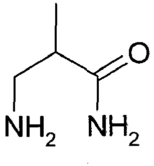 | 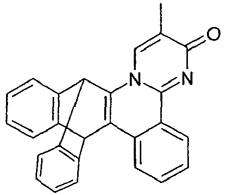 | 41 % |
| L49 | 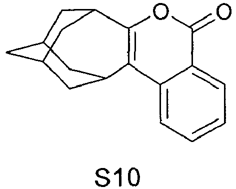 | 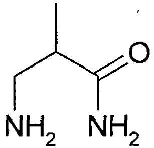 | 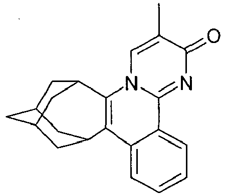 | 44 % |

### 5) 7,8-Anellierte 2,5,8a-Triaza-phenanthren-6-one

### a) Aus [2,6]Naphthyridin-1-ylaminen und β-Ketocarbonsäuren

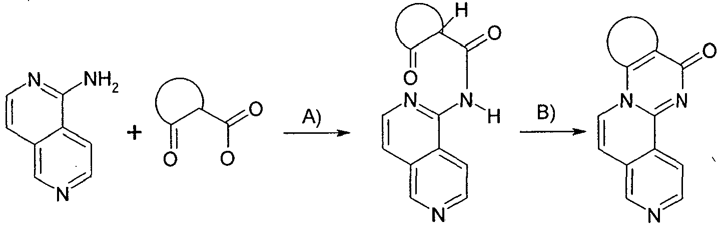

Darstellung analog 2a), wobei anstelle von [1,6]Naphthyridin-5-ylaminen [2,6]Naphthyridin-1-ylamine eingesetzt werden.

### Beispiel L50:

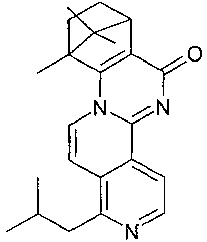

A) Einsatz von 20.1 g (100 mmol) 5-iso-Butyl-[2,6]naphthyridin-1-ylamin S1, 25.5 g (130 mmol (1R,2S,4R)-4,7,7-Trimethyl-3-oxo-bicyclo[2.2.1]-heptan-2-carbonsäure [18530-30-8], 611 mg (5 mmol) 4-Dimethylaminopyridin, 33.0 g (160 mmol) Dicyclohexylcarbodiimid. Chromatographie an Kieselgel (Dichlormethan/Ethylacetat 10:1, vv). Ausbeute: 30.4 g (80 mmol), 80 %. Reinheit ca. 95 % ig n. ¹H-NMR. Gemisch der endo-/exo-und Enol-Form.
B) Variante A:
   30.4 g (80 mmol) des Carboxamids aus A), 7.8 g Polyphosphorsäure, 35.1 ml Phosphorylchlorid. Chromatographie an Kieselgel (eluieren mit Ethylacetat, dann Umstellen auf Ethylacetat/Methanol 1:1, vv). Fraktionierte Sublimation (p. ca. 10⁻⁵ mbar, T = 200 °C). Ausbeute: 14.9 g (41 mmol), 51 %. Reinheit ca. 99.5 %ig n. ¹H-NMR.

Analog können folgende Verbindungen dargestellt werden.

| **Bsp.** | **Amin** | **β-Keto-carbonsäure** | **Ligand** | **Ausbeute** |
|---|---|---|---|---|
| L51 | 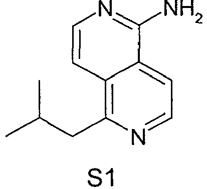 | 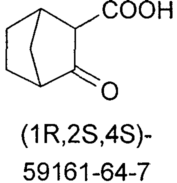 | 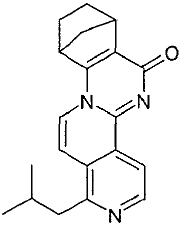 | 47 % |
| L52 | 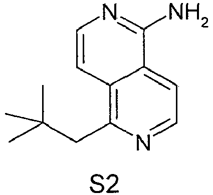 | 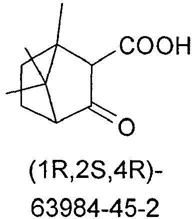 | 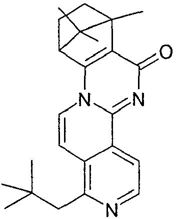 | 34 % |
| L53 | 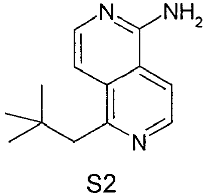 | 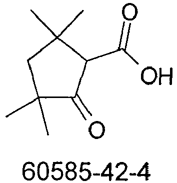 | 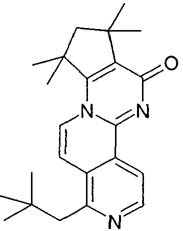 | 45 % |
| L54 | 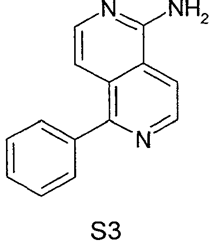 | 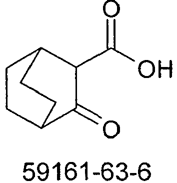 | 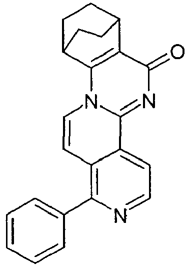 | 43 % |

### C: Synthese der Metallkomplexe

### 1) Homoleptische tris-faciale Iridium-Komplexe

### Variante A: Tris-acetylacetonato-iridium(III) als Iridium-Edukt

Ein Gemisch aus 10 mmol Tris-acetylacetonato-iridium(III) [15635-87-7], 40 mmol des Liganden L, gegebenenfalls 1-10 g, typischerweise 3 g, eines inerten hochsiedenden Zusatzes als Schmelzhilfe bzw. Lösungsmittel, z. B. Hexadecan, m-Terphenyl, Triphenylen, Bis-phenylether, 3-Phenoxy-toluol, 1,2-, 1,3-, 1,4-Bis-phenoxybenzol, Triphenylphosphinoxid, Sulfolan, 18-Krone-6, Triethylenglykol, Glycerin, Polyethylenglykole, Phenol, 1-Naphthol, Hydrochinon, etc., und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmessser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist; besonders geeignete Extraktionsmittel sind Kohlenwasserstoffe wie Toluol, Xylole, Mesitylen, Naphthalin, o-Dichlorbenzol, halogenierte aliphatische Kohlenwasserstoffe, Aceton, Ethylacetat, Cyclohexan) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metall-Komplexes mittels NMR und/ oder HPLC bestimmt. Liegt die Reinheit unter 99.5 % wird der Heißextraktionsschritt wiederholt, wobei ab der 2. Extraktion das Alox-Bett weggelassen wird. Ist eine Reinheit von 99.5 - 99.9 % oder besser erreicht, wird der Metallkomplex getempert oder sublimiert. Das Tempern erfolgt im Hochvakuum (p ca. 10⁻⁶ mbar) im Temperaturbereich von ca. 200-300 °C. Die Sublimation erfolgt im Hochvakuum (p ca. 10⁻⁶ mbar) im Temperaturbereich von ca. 300 - 430 °C, wobei die Sublimation bevorzugt in Form einer fraktionierten Sublimation durchgeführt wird. Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

### Variante B: Tris-(2,2,6,6-tetramethyl-3,5-heptandionato)iridium(III) als Iridium-Edukt

Durchführung analog zu Variante A, wobei anstelle von 10 mmol Tris-acetylacetonato-iridium(III) [15635-87-7] 10 mmol Tris-(2,2,6,6-tetramethyl-3,5-heptandionato)iridium [99581-86-9] eingesetzt werden. Die Verwendung dieses Edukts ist vorteilhaft, da der Druckaufbau in der Ampulle häufig nicht so ausgeprägt ist.

| **Bsp.** | **Ligand L** | **Ir-Komplex** | **Variante Zusatz Reaktionstemp./ Reaktionszeit Suspensionsmittel Extraktionsmittel** | **Ausbeute** |
|---|---|---|---|---|
| Ir(L1)₃ A | L1 | 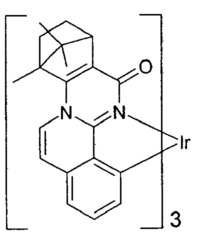 | A1-Naphthol 245 °C / 30 h EtOH Toluol | 55% |
| | | Ir(L1)₃ Diastereomerentrennung s.u. | | |
| Ir(L1)₃ B | L1 | 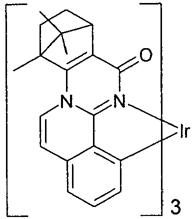 | B1-Naphthol 255°C/30h EtOH Toluol | 60 % |
| | | Ir(L1)₃ | | |
| Ir(L2)₃ | L2 | Ir(L2)₃ | wie Ir(L1)₃A | 62 % |
| Ir(L3)₃ | L3 | Ir(L3)₃ | wie Ir(L1)₃A | 59 % |
| Ir(L4)₃ | L4 | Ir(L4)₃ | wie Ir(L1)₃A | 51 % |
| Ir(L5)₃ | L5 | Ir(L5)₃ | wie Ir(L1)₃A | 54 % |
| Ir(L6)₃ | L6 | Ir(L6)₃ | wie Ir(L1)₃A | 59 % |
| Ir(L7)₃ | L7 | Ir(L7)₃ | wie Ir(L1)₃A | 53 % |
| Ir(L8)₃ | L8 | Ir(L8)₃ | wie Ir(L1)₃A | 40 % |
| Ir(L9)₃ | L9 | Ir(L9)₃ | wie Ir(L1)₃A | 49 % |
| Ir(L10)₃ | L10 | Ir(L10)₃ | wie Ir(L1)₃ B | 58 % |
| Ir(L11)₃ | L11 | Ir(L11)₃ | wie Ir(L1)₃ A | 55 % |
| Ir(L12)₃ | L12 | Ir(L12)₃ | wie Ir(L1)₃ A | 51 % |
| Ir(L13)₃ | L13 | Ir(L13)₃ | wie Ir(L1)₃ A | 48 % |
| Ir(L14)₃ | L14 | Ir(L14)₃ | wie Ir(L1)₃ A | 61 % |
| Ir(L15)₃ | L15 | Ir(L15)₃ | wie Ir(L1)₃ A | 52 % |
| Ir(L16)₃ | L16 | Ir(L16)₃ | wie Ir(L1)₃ A | 48 % |
| Ir(L17)₃ | L17 | Ir(L17)₃ | wie Ir(L1)₃ A | 60 % |
| Ir(L18)₃ | L18 | Ir(L18)₃ | wie Ir(L1)₃ A | 60 % |
| Ir(L19)₃ | L19 | Ir(L19)₃ | wie Ir(L1)₃ A | 56 % |
| Ir(L20)₃ | L20 | Ir(L20)₃ | wie Ir(L1)₃ A | 60 % |
| Ir(L21)₃ | L21 | Ir(L21)₃ | wie Ir(L1)₃ A | 19 % |
| Ir(L22)₃ | L22 | Ir(L22)₃ | wie Ir(L1)₃ A | 50 % |
| Ir(L23)₃ | L23 | Ir(L23)₃ | wie Ir(L1)₃ A | 53 % |
| Ir(L24)₃ | L24 | Ir(L24)₃ | wie Ir(L1)₃ A | 52 % |
| Ir(L25)₃ | L25 | 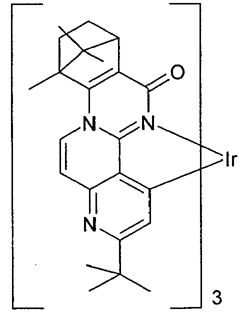 | A1-Naphthol 280 °C/45 h EtOH Toluol | 67 % |
| | | Ir(L25)₃ Diastereomerentren nung s.u. | | |
| Ir(L26)₃ | L26 | Ir(L26)₃ | wie Ir(L25)₃ | 65 % |
| Ir(L27)₃ | L27 | Ir(L27)₃ | wie Ir(L25)₃ | 68 % |
| Ir(L28)₃ | L28 | Ir(L28)₃ | wie Ir(L25)₃ | 64 % |
| Ir(L29)₃ | L29 | Ir(L29)₃ | wie Ir(L25)₃ | 65 % |
| Ir(L30)₃ | L30 | Ir(L30)₃ | wie Ir(L25)₃ | 60 % |
| Ir(L31)₃ | L31 | Ir(L31)₃ | wie Ir(L25)₃ | 64 % |
| Ir(L32)₃ | L32 | Ir(L32)₃ | wie Ir(L25)₃ | 63 % |
| Ir(L33)₃ | L33 | Ir(L33)₃ | wie Ir(L25)₃ | 63 % |
| Ir(L34)₃ | L34 | Ir(L34)₃ | wie Ir(L25)₃ | 55 % |
| Ir(L35)₃ | L35 | Ir(L35)₃ | wie Ir(L25)₃ | 58 % |
| Ir(L36)₃ | L36 | Ir(L36)₃ | wie Ir(L25)₃ | 49 % |
| Ir(L37)₃ | L37 | Ir(L37)₃ | wie Ir(L25)₃ | 58 % |
| Ir(L38)₃ | L38 | Ir(L38)₃ Diastereomerengemisch C1 + Δ, Λ C3 | wie Ir(L25)₃ | 30 % |
| Ir(L39)₃ | L39 | Ir(L39)₃ | wie Ir(L25)₃ | 55 % |
| Ir(L40)₃ | L40 | Ir(L40)₃ | wie Ir(L25)₃ | 57 % |
| Ir(L41)₃ | L41 | Ir(L41)₃ | wie Ir(L25)₃ | 60 % |
| Ir(L42)₃ | L42 | 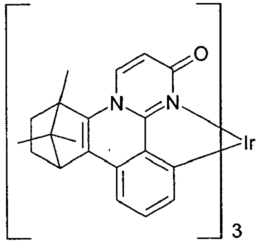 | A1-Naphthol 270 °C / 45 h EtOH Toluol | 60 % |
| | | Ir(L42)₃ | | |
| Ir(L43)₃ | L43 | Ir(L43)₃ | wie Ir(L42)₃ | 59 % |
| Ir(L44)₃ | L44 | Ir(L44)₃ | wie Ir(L42)₃ | 52 % |
| Ir(L45)₃ | L45 | Ir(L45)₃ | wie Ir(L42)₃ | 50 % |
| Ir(L46)₃ | L46 | Ir(L46)₃ | wie Ir(L42)₃ | 50 % |
| Ir(L47)₃ | L47 | Ir(L47)₃ | wie Ir(L42)₃ | 53 % |
| Ir(L48)₃ | L48 | Ir(L48)₃ | wie Ir(L42)₃ | 52 % |
| Ir(L49)₃ | L49 | Ir(L49)₃ | wie Ir(L42)₃ | 49 % |
| Ir(L50)₃ | L50 | 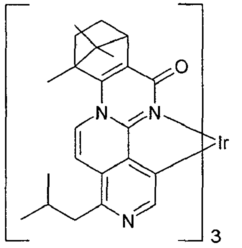 | A1-Naphthol 275 °C / 35 h EtOH Toluol | 54 % |
| | | Ir(L50)₃ | | |
| Ir(L51)₃ | L51 | Ir(L51)₃ | wie Ir(L50)₃ | 56 % |
| Ir(L52)₃ | L52 | Ir(L52)₃ | wie Ir(L50)₃ | 52 % |
| Ir(L53)₃ | L53 | Ir(L53)₃ | wie Ir(L50)₃ | 50 % |
| Ir(L54)₃ | L54 | Ir(L54)₃ | wie Ir(L50)₃ | 53 % |

### Trennung der Diastereomeren von Ir(L1)₃:

Chromatographie an Kieselgel mit Ethylacetat:
Diastereomer 1: R_{f} ca. 0.5
Diastereomer 2: R_{f} ca. 0
   Nach Eluieren von Diastereomer 1 umstellen auf DMF, um das Diastereomer 2 zu eluieren.

### Trennung der Diastereomeren von Ir(L25)₃:

Chromatographie an Kieselgel mit Ethylacetat:
Diastereomer 1: R_{f} ca. 0.7
Diastereomer 2: R_{f} ca. 0.2
   Nach Eluieren von Diastereomer 1 umstellen auf DMF, um das Diastereomer 2 zu eluieren.

### 2) Heteroleptische Iridium-Komplexe:

### Variante A:

### Schritt 1:

Ein Gemisch aus 10 mmol Natrium-bisacetylacetonato-dichloro-iridat(III) [770720-50-8] und 22 mmol des Liganden L, gegebenenfalls 1 - 10 g eines inerten hochsiedenden Zusatzes als Schmelzhilfe bzw. Lösungsmittel, wie unter 1) beschrieben, und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Nach Erkalten -ACHTUNG: die Ampullen stehen meist unter Druck! - wird die Ampulle geöffnet, der Sinterkuchen wird mit 100 g Glaskugeln (3 mm Durchmessser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist, typische Suspensionsmittel sind MeOH, EtOH, DCM, Aceton, Ethylacetat, Toluol, etc.) 3 h gerührt und dabei mechanisch aufgeschlossen. Man dekantiert die feine Suspension von den Glaskugeln ab, saugt den Feststoff ([Ir(L)₂Cl]₂, das noch ca. 2 eq NaCl enthält, nachfolgend das rohe Chloro-Dimer genannt) ab und trocknet diesen im Vakuum.

### Schritt 2:

Das so erhaltene rohe Chloro-Dimer der Formel [Ir(L)₂Cl]₂ wird in einem Gemisch aus 75 ml 2-Ethoxyethanol und 25 ml Wasser suspendiert, mit 15 mmol des Co-Liganden CL bzw. der Co-Liganden-Verbindung CL und 15 mmol Natriumcarbonat versetzt. Nach 20 h unter Rückfluss gibt man weitere 75 ml Wasser tropfenweise zu, saugt nach Erkalten vom Feststoff ab, wäscht diesen dreimal mit je 50 ml Wasser und dreimal mit je 50 ml Methanol und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit dem angegebenen Extraktionsmittel (Vorlagemenge ca. 500 ml, das Extraktionsmittel wird so gewählt, dass der Komplex darin in der Hitze gut und in der Kälte schlecht löslich ist; besonders geeignete Extraktionsmittel sind Kohlenwasserstoffe wie Toluol, Xylole, Mesitylen, Naphthalin, o-Dichlorbenzol, Aceton, Ethylacetat, Cyclohexan) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metall-Komplexes mittels NMR und/oder HPLC bestimmt. Liegt die Reinheit unter 99.5 % wird der Heißextraktionsschritt wiederholt, ist eine Reinheit von 99.5 - 99.9 % oder besser erreicht, wird der Metallkomplex getempert oder sublimiert. Neben dem Heißextraktionsverfahren zur Reinigung kann die Reinigung auch chromatographisch an Kieselgel oder Alox erfolgen. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

| **Bsp.** | **Ligand L** | **Co-Ligand CL** | **Ir-Komplex Schritt 1: Zusatz Reaktionstemp. / Reaktionszeit / Suspensionsmittel Schritt 2: Extraktionsmittel** | **Ausbeute** |
|---|---|---|---|---|
| Ir(L1)₂(CL1) | L1 | 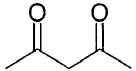 | 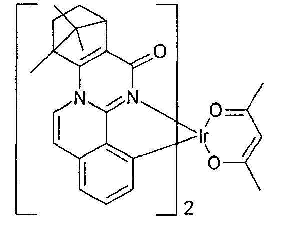 | 51 % |
| | | 123-54-6 CL1 | | |
| | | | 270 °C / 20 h / EtOH Ethylacetat | |
| Ir(L25)₂(CL1) | L25 | CL1 | 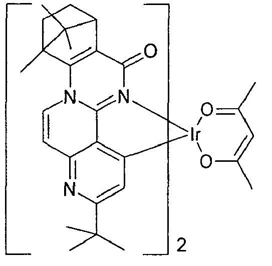 | 57% |
| | | | Hexadecan 280 °C / 20 h / EtOH Ethylacetat | |
| Ir(L39)₂(CL1) | L39 | CL1 | 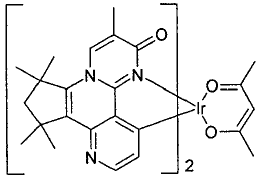 | 57 % |
| | | | 280 °C / 20 h / EtOH Ethylacetat | |
| Ir(L42)₂(CL1) | L42 | CL1 | 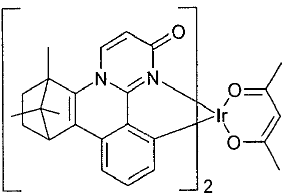 | 50 % |
| | | | 260 °C/ 26 h / EtOH Ethylacetat | |
| Ir(L46)₂(CL1) | L46 | CL1 | 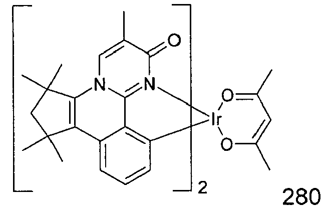 | 52 % |
| | | | °C / 24 h / EtOH Ethylacetat | |
| Ir(L48)₂(CL2) | L48 | 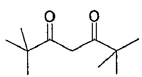 | 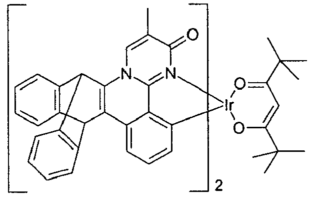 | 45 % |
| | | 1118-71-4 CL2 | | |
| | | | 280 °C / 20 h / EtOH Cyclohexan | |
| Ir(L50)₂(CL2) | L50 | CL2 | 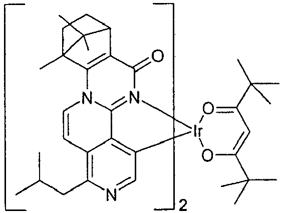 | 54 % |
| | | | 280 °C / 25 h / EtOH Cyclohexan | |
| Ir(L53)₂(CL2) | L53 | CL2 | 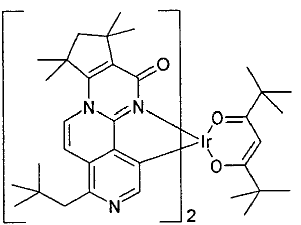 | 60 % |
| | | | 280 °C / 20 h / EtOH Cyclohexan | |
| Ir(L1)₂(CL3) | L1 | 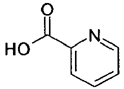 | 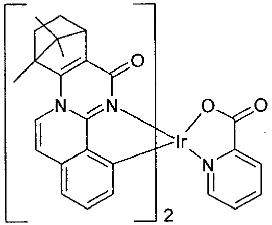 | 53 % |
| | | 98-98-6 CL3 | | |
| | | | 280 °C / 20 h / EtOH Cyclohexan | |
| Ir(L11)₂(CL4) | L11 | 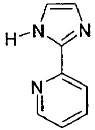 | 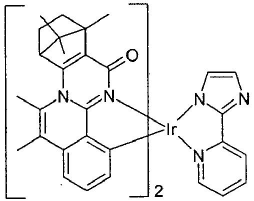 | 44 % |
| | | 18653-75-3 CL4 | 270 °C / 20 h / EtOH Toluol | |
| Ir(L25)₂(CL5) | L25 | 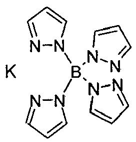 | 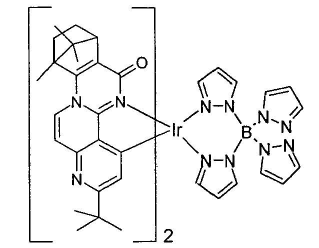 | 56 % |
| | | 14782-58-2 CL5 | Hexadecan 280 °C / 20 h / EtOH Ethylacetat | |
| Ir(L29)₂(CL6) | L29 | 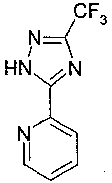 | 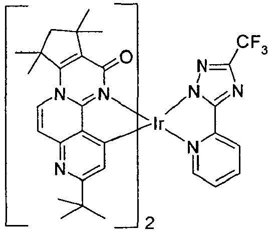 | 57 % |
| | | 219508-27-7 CL6 | Hexadecan 280 °C / 20 h / EtOH Toluol | |
| Ir(L39)₂(CL6) | L39 | 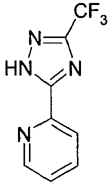 | 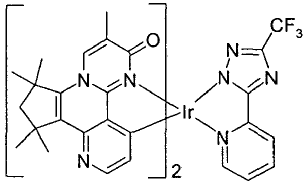 | 57 % |
| | | 219508-27-7 CL6 | 280 °C / 20 h / EtOH Toluol | |

### Variante B:

### Schritt 1:

### Siehe Variante A, Schritt 1.

### Schritt 2:

Das rohe Chloro-Dimer der Formel [Ir(L)₂Cl]₂ wird in 200 ml THF suspendiert, die Suspension wird mit 10 mmol des Co-Liganden CL, 10 mmol Silber(I)trifluoracetat und 20 mmol Kaliumcarbonat versetzt und 24 h unter Rückfluss erhitzt. Nach Erkalten wird das THF im Vakuum entfernt. Der Rückstand wird in 200 ml eines Gemischs aus Ethanol und konzentrierter Ammoniak-Lösung (1:1, vv) aufgenommen. Die Suspension wird 1 h bei Raumtemperatur gerührt, der Feststoff wird abgesaugt, zweimal mit je 50 ml eines Gemischs aus Ethanol und konz. Ammoniak-Lösung (1:1, vv) und zweimal mit je 50 ml Ethanol gewaschen und dann im Vakuum getrocknet. Heißextraktion bzw. Chromatographie und Sublimation wie in Variante A.

| **Bsp.** | **Ligand L** | **Co-Ligand CL** | **Ir-Komplex Schritt 1: Zusatz Reaktionstemp. / Reaktionszeit / Suspensionsmittel Schritt 2: Extraktionsmittel** | **Aus beute** |
|---|---|---|---|---|
| Ir(L1)₂(CL7) | L1 | 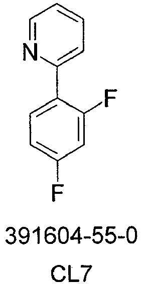 | 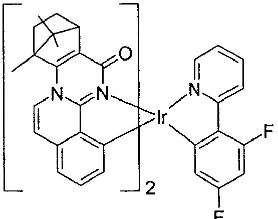 | 50 % |
| | | | 280 °C / 24 h / EtOH Toluol | |
| Ir(L25)₂(CL8) | L25 | 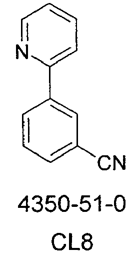 | 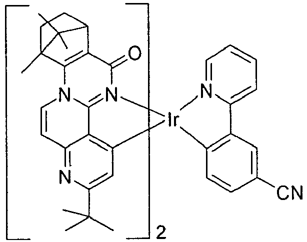 | 51 % |
| | | | Hexadecan 280 °C / 24 h / EtOH Toluol | |
| Ir(L29)₂(CL9) | L29 | 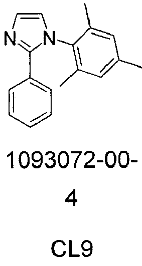 | 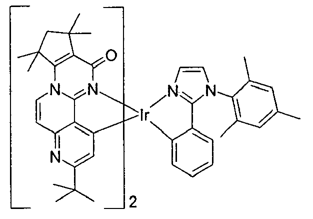 | 49 % |
| | | | Hexadecan 280 °C / 24 h / EtOH Cyclohexan | |
| Ir(L39)₂(CL10) | L39 | 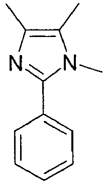 | 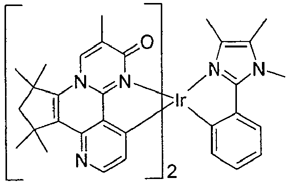 | 52% |
| | | 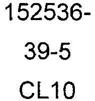 | 280 °C / 24 h / EtOH Toluol | |

### Variante C:

### Schritt 1:

### Siehe Variante A, Schritt 1.

### Schritt 2:

Das rohe Chloro-Dimer der Formel [Ir(L)₂Cl]₂ wird in 500 ml Dichlormethan und 100 ml Ethanol suspendiert, die Suspension wird mit 10 mmol Silber(I)trifluormethansulfonat versetzt und 24 h bei Raumtemperatur gerührt. Man saugt vom ausgefallen Feststoff (AgCl) über eine kurzes Celite-Bett ab und engt das Filtrat im Vakuum zur Trockene ein. Der so erhaltene Feststoff wird in 100 ml Ethylenglykol aufgenommen, mit 10 mmol des Co-Liganden CL und 10 mmol 2,6-Dimethylpyridin versetzt und dann 30 h bei 130 °C gerührt. Nach Erkalten saugt man vom Feststoff ab, wäscht diesen zweimal mit je 50 ml Ethanol und trocknet im Vakuum. Heißextraktion bzw. Chromatographie und Sublimation wie in Variante A.

| **Bsp.** | **Ligand L** | **Co-Ligand CL** | **Ir-Komplex Schritt 1: Zusatz Reaktionstemp. / Reaktionszeit / Suspensionsmittel Schritt 2: Extraktionsmittel** | **Ausbeute** |
|---|---|---|---|---|
| Ir(L6)₂(CL11) | L6 | 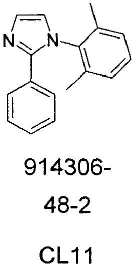 | 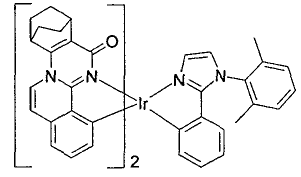 | 47 % |
| | | | 280 °C / 24 h / EtOH Toluol Reinigung chromatographisch an Kieselgel Laufmittel Tol:EE 9:1, vv | |
| Ir(L22)₂(CL11) | L22 | 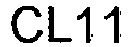 | 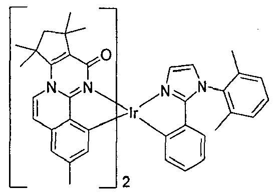 | 53 % |
| | | | 270 °C / 24 h / EtOH Toluol | |
| Ir(L30)₂(CL12) | L30 | 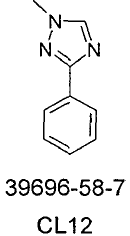 | 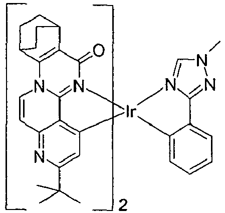 | 54 % |
| | | | Hexadecan 280 °C / 24 h / EtOH Toluol | |
| Ir(L46)₂(CL13) | L46 | 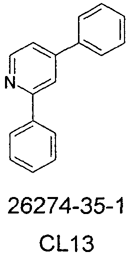 | 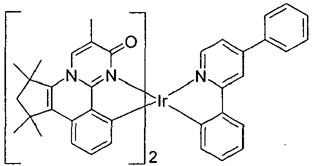 | 45 % |
| | | | 270 °C / 24 h / EtOH Toluol Reinigung chromatographisch an Kieselgel Laufmittel DCM | |
| Ir(L50)₂(CL14) | L50 | 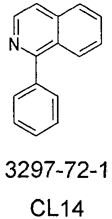 | 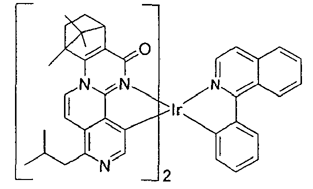 | 44 % |
| | | | Hexadecan 280 °C / 24 h / EtOH Toluol | |

### Variante E:

Ein Gemisch aus 10 mmol des Ir-Komplexes Ir(L)₂(CL1 oder CL2), 11 mmol des Liganden L', gegebenenfalls 1-10 g eines inerten hochsiedenden Zusatzes als Schmelzhilfe bzw. Lösungsmittel, wie unter 1) beschrieben, und ein glasummantelter Magnetrührkern werden unter Vakuum (10⁻⁵ mbar) in eine 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Weitere Aufarbeitung, Reinigung und Sublimation wie unter 1) Homoleptische tris-faciale Iridium-Komplexe beschrieben.

| **Bsp.** | **Ir-Komplex Ir(L)₂(CL)** | **Ligand L'** | **Ir-Komplex Zusatz Reaktionstemp. / Reaktionszeit / Suspensionsmittel Extraktionsmittel** | **Ausbeute** |
|---|---|---|---|---|
| Ir(L1)₂(L25) | Ir(L1)₂(CL1) | L25 | 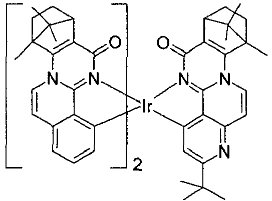 | 49 % |
| | | | Hexadecan 280 °C / 45 h / EtOH Toluol | |
| Ir(L25)₂(L 1) | Ir(L25)₂(CL1) | L1 | 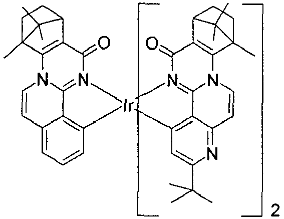 | 45 % |
| | | | wie Ir(L1)₂(L25) | |
| Ir(L25)₂(L39) | Ir(L25)₂(CL1) | L39 | 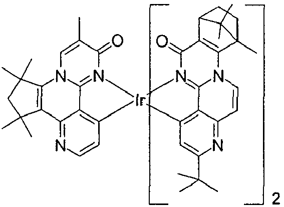 | 53 % |
| | | | wie Ir(L1)₂(L25) | |

### Beispiel S11: 8-tert-Butyl-[1,6]naphthyridin-6-N-oxid

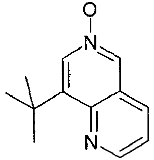

### a) 8-tert-Butyl-[1,6]naphthyridin

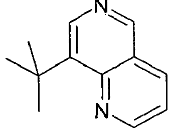

Durchführung analog A. Joshi-Pangu et al., J. Am. Chem. Soc., 2011, 133, 22, 8478. Eine auf -10 °C gekühlte Lösung von 20.9 g (100 mmol) 8-Brom-[1,6]naphthyridin [17965-74-1], 1.5 g (10 mmol) Nickel(II)chlorid x 1.5 H₂O und 3.2 g (10 mmol) 1,3-Dicyclohexyl-1H-imidazolium-tetrafluoroborat [286014-37-7] in 300 ml THF wird tropfenweise mit 100 ml tert-Butylmagnesiumchlorid, 2 M Lösung in THF versetzt und dann 8 h nachgerührt. Nach Erwärmen auf 0 °C gibt man tropfenweise 20 ml Wasser zu, versetzt dann mit 300 ml gesättigter Ammoniumchlorid-Lösung und 500 ml Ethylacetat. Nach gutem Ausschütteln trennt man die org. Phase ab, wäscht diese einmal mit 500 ml Wasser und einmal mit 300 ml gesättigter Kochsalzlösung und trocknet dann über Magnesiumsulfat. Nach Entfernen das Lösungsmittels wird der Rückstand an Kieselgel mit Ethylacetat: Heptan : Triethylamin (1:2:0.05) chromatographiert. Ausbeute: 3.4 g (18 mmol), 18 %. Reinheit ca. 98 % ig n. ¹H-NMR.

### a) 8-tert-Butyl-[1,6]naphthyridin-6-N-oxid, S11

Eine Lösung von 3.4 g (18 mmol) 8-tert-Butyl-[1,6]naphthyridin in 50 ml Chloroform wird portionsweise mit 5.1 g (30 mmol) m-Chlorperbenzoesäure versetzt und dann 4 Tage bei Raumtemperatur gerührt. Nach Zugabe von 200 ml Chloroform wird die Reaktionslösung dreimal mit je 100 ml einer 10 %igen Kaliumcarbonat-Lösung gewaschen und über Magnesiumsulfat getrocknet. Der nach Entfernen des Lösungsmittels erhaltene Festsoff wird ohne weitere Reinigung weiter umgesetzt. Ausbeute: 3.6 g (18 mmol) quantitativ, Reinheit: 95 % ig n. ¹H-NMR.

### 1b) Aus 1-Haloaen-iso-chinolinen und β-Ketocarbonsäure-amiden

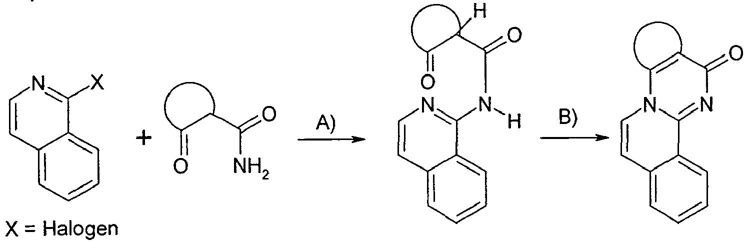

A) Ein gut gerührtes Gemisch aus 100 mmol 1-Halogen-isochinolin (Halogen = Chlor, Brom, lod), 120 mmol des β-Ketocarbonsäureamids, 300 mol einer Base (Natrium-, Kalium-, Cäsiumcarbonat, Kaliumphosphat, etc.), 5 mmol eines zweizähnigen Phosphins (Binap, Xantphos) oder 10 mmol eines einzähnigen Phosphins (S-Phos, X-Phos, BettPhos), 5 mmol Palladium(II)acetat und 100 g (Glaskugeln, 6 mm Durchmesser) in 500 ml eines Lösungsmittels (Dioxan, DMF, DMAC, etc.) wird 16 h bei 80-150 °C gerührt. Nach Erkalten entfernt man das Lösuingsmittel im Vakuum, nimmt den Rückstand in 1000 ml Ethylacetat auf, wäscht dreimal mit je 300 ml Wasser einmal mit 300 ml gesättigter Kochsalzlösung und trocknet dann über Magnesiumsulfat.
B) Der nach Entfernen des Lösungsmittels im Vakuum erhaltene Rückstand wird wie in 1a) Schritt B) Variante 1 beschrieben cyclisiert.

### Beispiel L55:

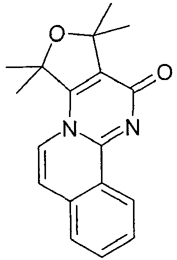

A+B) Einsatz von 16.4 g (100 mmol) 1-Chlor-isochinolin [19493-44-8], 22.2 g (120 mmol) 2,2,5,5-Tetramethyl-4-oxo-tetrahydrofuran-3-carbonsäureamid [99063-20-4], 41.5 g (300 mmol) Kaliumcarbonat, 2.9 g (5 mmol) Xantphos, 1.1 g (5 mmol) Palladium(II)acetat, 500 ml Dioxan, T = 110 °C. Säulenchromatographische Reinigung (Kieselgel, DCM : EE 5:1, vv) und dreimalige Umkristallisation aus Ethylacetat/n-Heptan. Fraktionierte Sublimation (p ca. 10⁻⁵ mbar, T = 190 °C). Ausbeute 4.5 g (15 mmol), 15 %. Reinheit ca. 99.5 %ig n. ¹H-NMR.

Analog können folgende Verbindungen dargestellt werden.

| **Bsp.** | **5-Halogen-[1,6]naphthyridin** | **Amid** | **Ligand** | **Aus-beute** |
|---|---|---|---|---|
| **L56** | 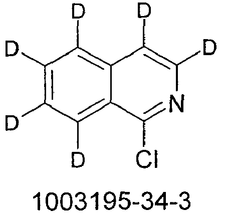 | 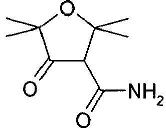 | 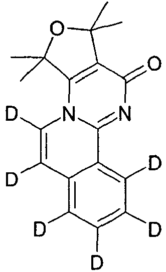 | 15 % |
| **L57** | 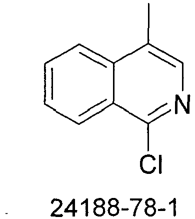 | 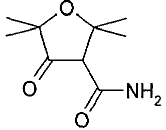 | 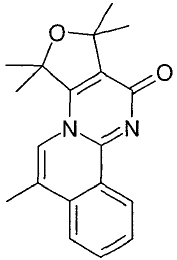 | 17 % |
| **L58** | 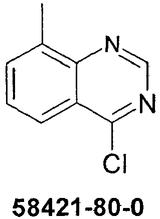 | 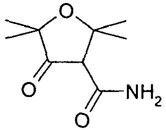 | 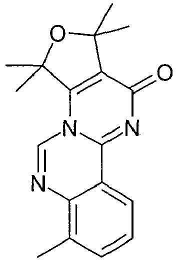 | 11 % |
| **L59** | 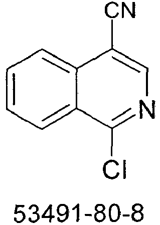 | 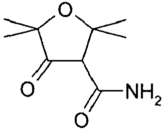 | 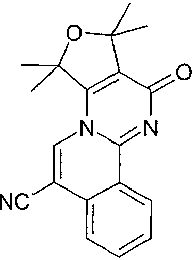 | 13% |
| **L60** | 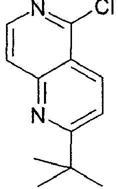 | 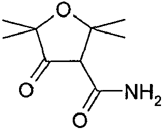 | 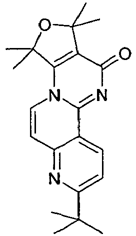 | 12 % |
| **L61** | 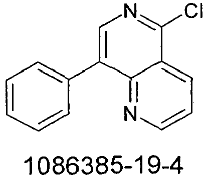 | 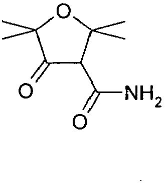 | 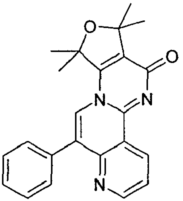 | 10 % |
| **L62** | 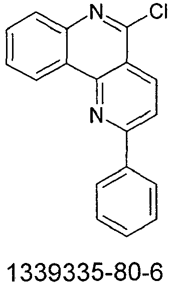 | 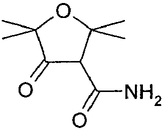 | 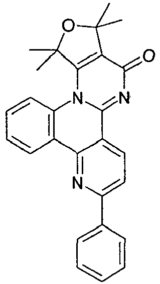 | 9 % |

### 1c) Aus iso-Chinolin-N-oxiden und β-Ketocarbonsäureamiden

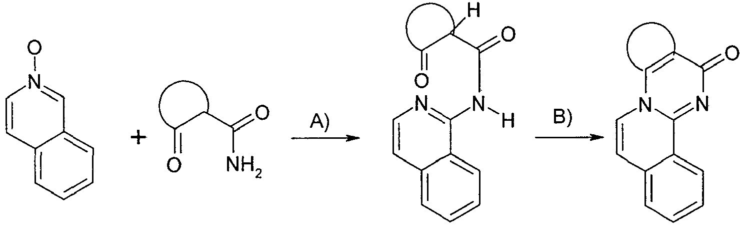

A) Durchführung analog M. Couturier et al., Org. Lett. 2006, 9, 1929.
   Eine Suspension von 100 mmol des Amids in 100 ml 1,2-Dichlorethan wird bei Raumtemperatur tropfenweise mit 100 mmol Oxalylchlorid versetzt und dann 3 h bei 50 °C gerührt. Nach Erkalten auf Raumtemperatur gibt man 50 mmol des iso-Chinolin-N-oxids gelöst in 100 ml 1.2-Dichlorethan zu und rührt 24 h bei Raumtemperatur nach.
B) Der nach Entfernen das Lösungsmittels im Vakuum erhaltene Rückstand wird wie in 1a) Schritt B) Variante 1 beschrieben cyclisiert.

### Beispiel L63:

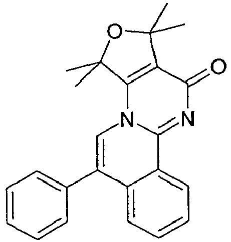

A+B) Einsatz 18.5 g (100 mmol) Tetrahydro-2,2,5,5-tetramethyl-4-oxo-3-furancarboxamid [99063-20-4], 8.6 ml (100 mmol) Oxalylchlorid [79-37.8] und 11.1 g (50 mmol) 4-Phenyl-isochinolin-N-oxid [65811-00-9]. Säulenchromatographische Reinigung (Kieselgel, DCM : EE 5:1, vv) und dreimalige Umkristallisation aus Ethylacetat/n-Heptan. Fraktionierte Sublimation (p ca. 10⁻⁵ mbar, T = 190 °C). Ausbeute: 3.8 g (10 mmol), 20 %. Reinheit ca. 99.5 %ig n. ¹H-NMR.

Analog können folgende Verbindungen daraestellt werden.

| **Bsp.** | **[1,6]Naphthyridin-6-N-oxid** | **Amid** | **Ligand** | **Aus-beute** |
|---|---|---|---|---|
| **L64** | 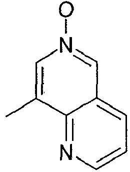 | 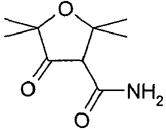 | 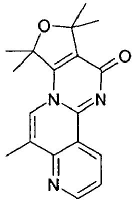 | 13 % |
| **L65** | 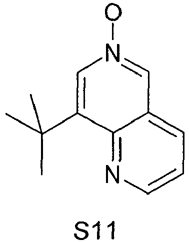 | 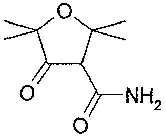 | 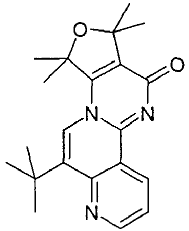 | 14 % |
| **L66** | 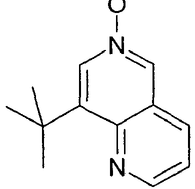 | 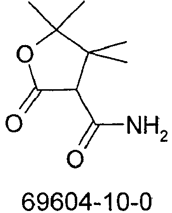 | 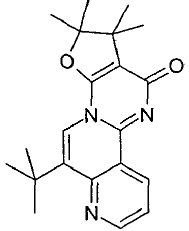 | 10 % |
| **L67** | 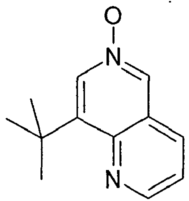 | 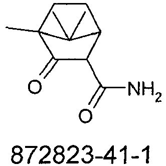 | 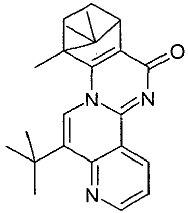 | 16 % |

### 1d) Aus 2-iso-Chinolin-1-yl-2,4,10a-triaza-phenanthren-1,3-dionen und Enaminen

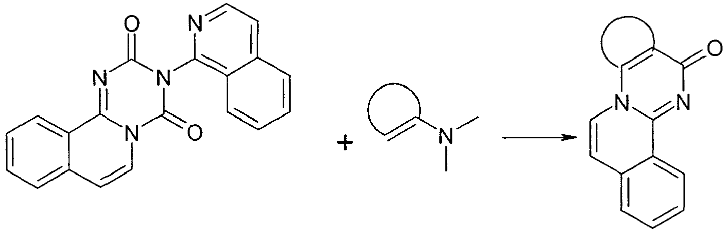

A) Ein Gemisch von 100 mmol des 2-iso-Chinolin-1-yl-2,4,10a-triaza-phenanthren-1,3-dions (dimeres Isocyanat, Synthese analog zu 4737-19-3 nach K. J. Duffy et al. WO2007150011) und 500 mmol des Enamins wird 16 h bei 160 °C am Wasserabscheider gerührt. Dann wird die Temperatur langsam bis ca. 280 °C gesteigert, bis das gebildete sekundäre Amin und das überschüssige Enamin abdestilliert ist. Nach Erkalten wird der Rückstand chromatographiert.

### Beispiel L55:

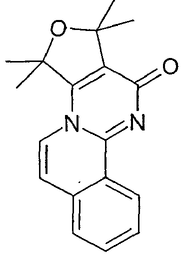

A) Einsatz von 34.0 g (100 mmol) 2-iso-Chinolin-1-yl-2,4,10a-triaza-phenanthren-1,3-dions, 105.7 g (500 mmol) 4-(2,2,5,5-Tetramethyl-2,5-dihydrofuran-3-yl)-morpholin (Darstellung analog 78593-93-8 nach R. Carlson et al., Acta Chem. Scand. B, 1984, B38, 1, 49). Säulenchromatographische Reinigung (Kieselgel, DCM : EE 5:1, vv) und dreimalige Umkristallisation aus Ethylacetat/n-Heptan. Fraktionierte Sublimation (p ca. 10⁻⁵ mbar, T = 190 °C). Ausbeute 5.3 g (18 mmol), 18 %. Reinheit ca. 99.5 %ig n. ¹H-NMR.

Analog können folgende Verbindungen dargestellt werden.

| **Bsp.** | **Dimeres Isocyanat** | **Enamin** | **Ligand** | **Ausbeute** |
|---|---|---|---|---|
| L2 | 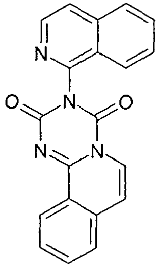 | 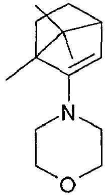 | 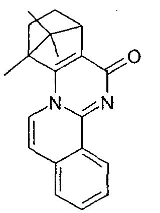 | 43 % |
| | | 78593-93-8 | | |
| L3 | 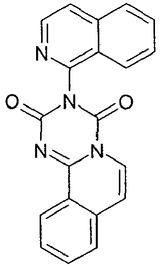 | 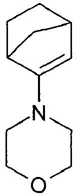 | 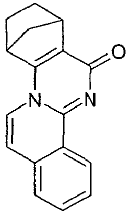 | 51 % |
| | | 5024-92-0 | Racemat | |
| L6 | 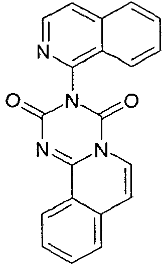 | 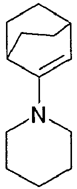 | 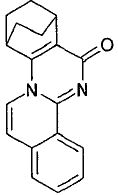 | 47 % |
| | | 41455-20-3 | | |

### 1e) Aus 2-Halogenbenzoesäureamiden, ß-Keto-carbonsäureamiden und Alkinenen

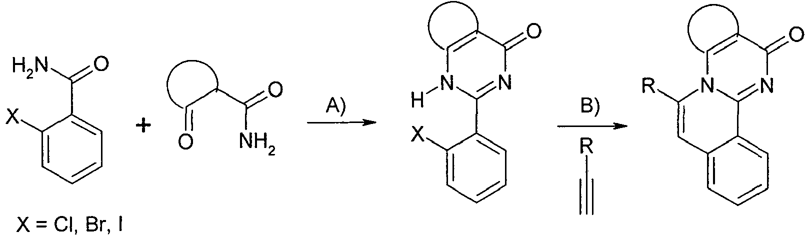

A) Ein inniges Gemisch aus 120 mmol des 2-Halogenbenzoesäureamids und 100 mmol des β-Keto-carbonsäureamids wird am Wasserabscheider aufgeschmolzen und dann so lange (ca. 2 h) bei 240 °C gerührt, bis sich kein Wasser mehr abscheidet. Nach Erkalten wird der Schmelzkuchen mit 200 ml Methanol/Wasser (1:1, vv) heiß ausgerührt. Der nach Abfiltrieren und Trocknen erhaltene Feststoff wird in B) weiter umgesetzt.
B) Eine Lösung von 100 mmol des 2-Phenyl-1H-pyrimidin-4-ons aus A) in 200 ml DMF und 100 ml Triethylamin wird konsekutiv mit 6 mmol Triphenylphosphin, 3 mmol Palladium(II)acetat, 3 mmol Kupfer(I)iodid und 150 mmol des Alkins versetzt und 5 h bei 70 °C gerührt. Nach Erkalten saugt man vom ausgefallenen Triethylammoniumhydrochlorid ab, wäscht dieses mit wenig DMF nach und befreit das Filtrat im Vakuum von den flüchtigen Komponenten. Der Rückstand wird in 200 ml Nitrobenzol gelöst, mit 10 ml Wasser versetzt, langsam auf 200 °C erhitzt und dann am Wasserabscheider 6 h bei 200 °C gerührt. Dann desilliert man das Nitrobenzol bei 200 °C durch Anlegen eines leichten Unterdrucks vollständig ab. Nach Erkalten nimmt man den glasigen Rückstand in 150 ml heißem Methanol auf, wobei das Produkt zu kristallisieren beginnt. Nach Erkalten saugt man den Feststoff ab, wäscht mit wenig Methanol nach und kristallisiert erneut um.

### Beispiel L55:

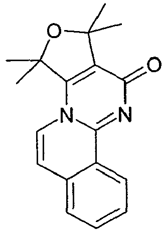

A+B) Einsatz von 24.0 g (120 mmol) 2-Brombenzoesäureamid []4001-73-4], 18.5 g (100 mmol) Tetrahydro-2,2,5,5-tetramethyl-4-oxo-3-furan-carboxamid [99063-20-4], 1.6 g (6 mmol) Triphenylphosphin, 673 mg (3 mmol) Palladium(II)acetat, 571 mg (3 mmol) Kupfer(I)iodid und 14.7 g (150 mmol) Trimethylsilylacetylen [1066-54-2]. Dreimalige Umkristallisation aus Methanol. Fraktionierte Sublimation (p ca. 10⁻⁵ mbar, T = 190 °C). Ausbeute: 8.5 g (29 mmol), 29 %. Reinheit ca. 99.5 %ig n. ¹H-NMR.

### C: Synthese der Metallkomplexe

### 1) Homoleptische tris-faciale Iridium-Komplexe:

| **Bsp.** | **Ligand L** | **Ir-Komplex** | **Variante Zusatz Reaktionstem p./ Reaktionszeit Suspensionsmittel Extraktionsmittel** | **Ausbeute** |
|---|---|---|---|---|
| Ir(L55)₃ | L55 | 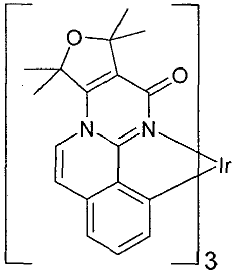 | A Hydrochinon 250 °C/30 h EtOH DCM | 46 % |
| Ir(L56)₃ | L56 | Ir(L56)₃ | A Hydrochinon 260 °C / 30 h EtOH DCM | 38 % |
| Ir(L57)₃ | L57 | Ir(L57)₃ | wie Ir(L55)₃ | 43% |
| Ir(L58)₃ | L58 | Ir(L58)₃ | wie Ir(L56)₃ | 37% |
| Ir(L59)₃ | L59 | Ir(L59)₃ | wie Ir(L55)₃ | 35% |
| Ir(L60)₃ | L60 | 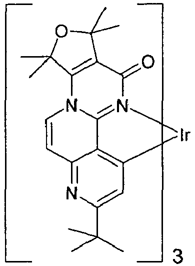 | A Hydrochinon 260 °C/ 30 h EtOH DCM | 56% |
| | | Ir(L60)₃ | | |
| Ir(L61)₃ | L61 | Ir(L61)₃ | wie Ir(L60)₃ | 32% |
| Ir(L62)₃ | L62 | Ir(L62)₃ | wie Ir(L60)₃ | 17 % |
| Ir(L63)₃ | L63 | Ir(L63)₃ | wie Ir(L55)₃ | 44% |
| Ir(L64)₃ | L64 | Ir(L64)₃ | wie Ir(L60)₃ | 48% |
| Ir(L65)₃ | L65 | Ir(L65)₃ | wie Ir(L60)₃ | 45 % |
| Ir(L66)₃ | L66 | Ir(L66)₃ | wie Ir(L60)₃ | 30 % |
| Ir(L67)₃ | L67 | Ir(L67)₃ | wie Ir(L60)₃ | 49% |

### D: Derivatisierung der Metallkomplexe

### 1) Halogenierung der Iridium-Komplexe:

Eine Lösung bzw. Suspension von 10 mmol eines Komplexes, der in para-Position zum Iridium A x C-H-Gruppen (mit A = 1, 2 oder 3) trägt, in 1000 ml Dichlormethan wird unter Licht- und Luftausschluss bei 30 °C mit A x 11 mmol N-Halogensuccinimid (Halogen: Cl, Br, I) versetzt und 20 h gerührt. In DCM schlecht lösliche Komplexe können auch in anderen Lösungsmitteln (TCE, THF, DMF, etc.) und bei erhöhter Temperatur umgesetzt werden. Anschließend wird das Lösungsmittel im Vakuum weitgehend entfernt. Der Rückstand wird mit 100 ml MeOH ausgekocht, der Feststoff wird abgesaugt, dreimal mit 50 ml Methanol gewaschen und dann im Vakuum getrocknet.

### Synthese von Ir(L1-Br)₃:

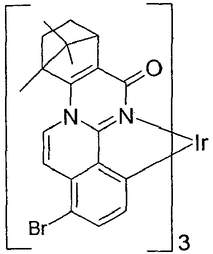

Eine bei 30 °C gerührte Suspension von 11.0 g (10 mmol) Ir(L1)ₛ in 1000 ml DCM wird auf ein Mal mit 5.9 g (33 mmol) N-Bromsuccinimid versetzt und dann weitere 20 h gerührt. Nach Entfernen von ca. 200 ml das DCMs im Vakuum wird die zitronengelbe Suspension mit 100 ml Methanol versetzt, der Feststoff wird abgesaugt, dreimal mit ca. 50 ml Methanol gewaschen und dann im Vakuum getrocknet. Ausbeute: 12.7 g (9.5 mmol) 95 %; Reinheit: ca. 99.5 %ig nach ¹H-NMR.

Analog können folgende Verbindungen dargestellt werden:

| Bsp. | Komplex | Bromierter Komplex | Ausbeute |
|---|---|---|---|
| Ir(L5-Br)₃ | 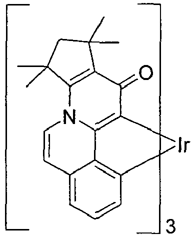 | 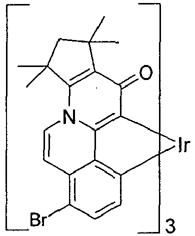 | 97 % |
| | Ir(L5)₃ | Ir(L5-Br)₃ | |
| Ir(L22-Br)₃ | 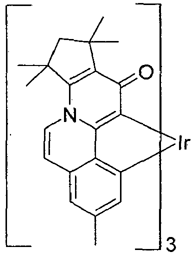 | 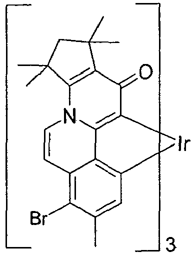 | 90 % |
| | Ir(L22)₃ | Ir(L22-Br)₃ | |
| Ir(L24-Br)₃ | 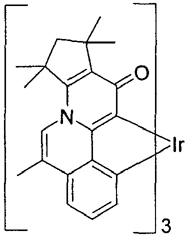 | 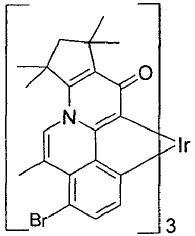 | 94 % |
| | Ir(L24)₃ | Ir(L24-Br)₃ | |
| Ir(L42-Br)₃ | 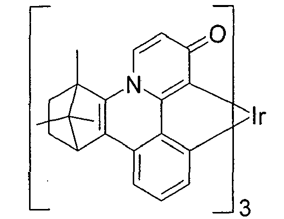 | 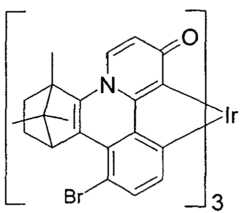 | 87 % |
| | Ir(L42)₃ | Ir(L42-Br)₃ | |

### 2) Suzuki-Kupplung an Iridium-Komplexen:

### Variante A, zweiphasige Reaktionsmischung:

Eine Suspension von 10 mmol eines bromierten Komplexes, 40-80 mmol der Boronsäure bzw. des Boronsäureesters und 80 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Ethanol zu, saugt vom ausgefallenen Rohprodukt ab, wäscht dieses dreimal mit je 100 ml EtOH und trocknet im Vakuum. Das Rohprodukt wird mit Toluol zweimal an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines bromierten Komplexes, 40-80 mmol der Boronsäure bzw. des Boronsäureesters und 60-100 mmol der Base (Kaliumfluorid, Trikaliumphosphat, Trikaliumphosphat-monohydrat, Trikaliumphosphat-trihydrat, Kaliumcarbonat, Cäsiumcarbonat, etc.) und 100 g Glaskugeln (3 mm Durchmesser) in 100-500 ml eines aprotischen Lösungsmittels (THF, Dioxan, Xylol, Mesitylen, Dimethylacetamid, NMP, DMSO, etc.) und gegebenenfalls 5-10 mmol Wasser wird mit 0.6 mmol Tri-o-tolylphosphin und dann mit 0.1 mmol Palladium(II)acetat versetzt und 1-24 h unter Rückfluss erhitzt. Alternativ können andere Phosphine wir Tri-tert-butylphosphin, Di-tert-butylphosphin, S-Phos, Xanthphos, etc. eingesetzt werden, wobei bei diesen Phosphinen das bevorzugte Phosphin : Palladium Verhältnis 2:1 bis 1.2 : 1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter A beschrieben.

### Synthese von Ir(L100)₃:

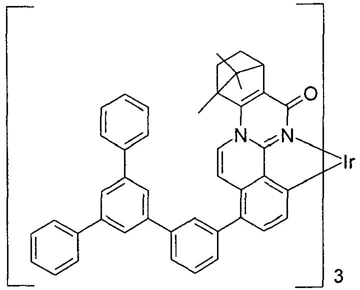

### Variante A:

Einsatz von 14.3 g (10 mmol) Ir(L1-Br)₃ und 14.0 g (40 mmol) Quaterphenylboronsäure [1233200-59-3]. Ausbeute: 10.6 g (5.5 mmol) 55 %; Reinheit: ca. 99.9 %ig nach HPLC.

Analog können folgende Verbindungen dargestellt werden:

| Bsp. | Produkt Variante | Ausbeute |
|---|---|---|
| Ir(L101)₃ | 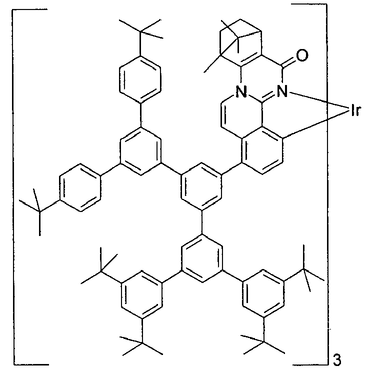 | 51 % |
| | Ir(L1-Br)₃ + [952583-08-3] > Ir(101)₃ A, wie Ir(L100)₃ | |
| Ir(L102)₃ | 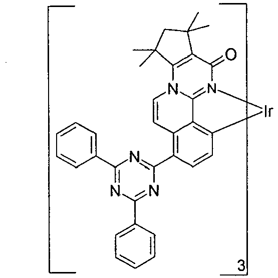 | 55% |
| | Ir(L5-Br)₃ + [1251825-65-6] > Ir(102)₃ A, wie Ir(L100)₃ | |
| Ir(L103)₃ | | 43 % |
| | 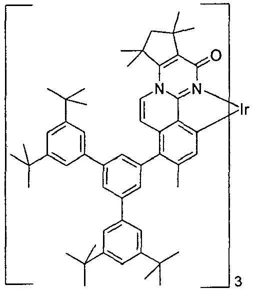 | |
| | Ir(L22-Br)₃ + [1071924-15-6] > Ir(103)₃ A, wie Ir(L100)₃ | |
| Ir(L104)₃ | 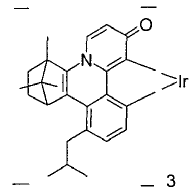 | 59 % |
| | Ir(L42-Br)₃ + [84110-40-7] > Ir(L104)₃ B, Trikaliumphosphat, Toluol, 5 mmol Wasser, S-Phos | |

### 3) Buchwald-Kupplung an den Iridium-Komplexen

Ein Gemisch aus 10 mmol des bromierten Komplexe, 40 mmol des Diarylamins oder Carbazols, 45 mmol Natrium-tert-butylat bei den Aminen bzw. 80 mmol Trikaliumphosphat, wasserfrei, bei Carbazolen, 100 g Glaskugeln (3 mm Durchmesser) und 300-500 ml o-Xylol oder Mesitylen wird mit 0.4 mmol Tri-tert-butylphosphin und dann mit 0.3 mmol Palladium(II)acetat versetzt und unter gutem Rühren 16 h unter Rückfluss erhitzt. Nach Erkalten trennt man die wässrige Phase ab, wäscht zweimal mit 200 ml Wasser, einmal mit 200 ml gesättigter Kochsalzlösung und trocknet über Magnesiumsulfat. Man filtriert über ein Celite-Bett ab, wäscht dieses mit o-Xylol oder Mesitylen nach, entfernt das Lösungsmittel fast vollständig im Vakuum, gibt 300 ml Ethanol zu, saugt vom ausgefallenen Rohprodukt ab, wäscht dieses dreimal mit je 100 ml EtOH und trocknet im Vakuum. Das Rohprodukt wird mit Toluol zweimal an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200- 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Synthese von Ir(L200)₃:

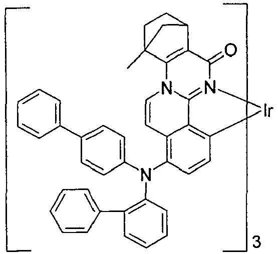

Einsatz von 14.3 g (10 mmol) Ir(L1-Br)₃ und 12.9 g (40 mmol) p-Biphenylo-biphenyl-amin [1372775-52-4] , Mesitylen. Ausbeute: 11.9 g (6.0 mmol) 60 %; Reinheit: ca. 99.8 %ig nach HPLC.

Analog können folgende Verbindungen dargestellt werden:

| Bsp. | Produkt | Ausbeute |
|---|---|---|
| Ir(L201)₃ | 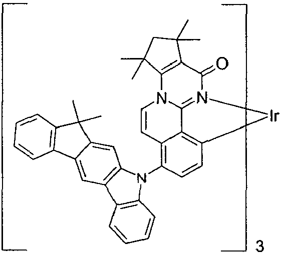 | 49 % |
| | Ir(L5-Br)₃ + [1257220-47-5] > Ir(201)₃ | |

### 4) Cyanierung der Iridium-Komplexe

Ein Gemisch aus 10 mmol des bromierten Komplexes, 13 mmol Kupfer(I)-cyanid pro Brom-Funktion und 300 ml NMP wird 20 h bei 200 °C gerührt. Nach Erkalten entfernt man das Lösungsmittel im Vakuum, nimmt den Rückstand in 500 ml Dichlormethan auf, filtriert über Celite von den Kupfersalzen ab, engt das Dichlormethan im Vakuum fast bis zur Trockene ein, gibt 100 ml Ethanol zu, saugt vom ausgefallenen Feststoff ab, wäscht diesen zweimal mit je 50 ml Ethanol und trocknet im Vakuum. Heißextraktion und Sublimation wie in 1) Variante A. Das Rohprodukt kann alternativ an Kieselgel mit Dichlormethan, gegebenenfalls unter Zusatz von Ethylacetat, chromatographiert und dann sublimiert werden.

### Synthese von Ir(L300)₃:

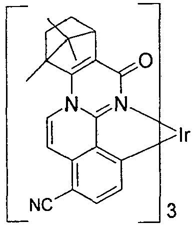

Einsatz von 14.3 g (10 mmol) Ir(L1-Br)ₛ und 3.5 g (39) mmol) Kupfer(I)-cyanid. Ausbeute: 5.4 g (4.6 mmol) 46 %; Reinheit: ca. 99.8 %ig nach HPLC.

### 5) Borylierung der Iridium-Komplexe

Ein Gemisch von 10 mmol des bromierten Komplexes, 12 mmol Bis-(pinacolato)diboran [73183-34-3] pro Brom-Funktion, 30 mmol Kaliumacetat, wasserfrei, pro Bromfunktion, 0.2 mmol Tricyclohexylphosphin und 0.1 mmol Palladium(II)acetat und 300 ml Lösungsmittel (Dioxan, DMSO, NMP, etc.) wird 4-16 h bei 80-160 °C gerührt. Nach Entfernen des Lösungsmittels im Vakuum wird der Rückstand in 300 ml Dichlormethan, THF oder Ethylacetat aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Die Verbindungen können aus Dichlormethan, Ethylacetat oder THF unter Zusatz von Methanol oder alternativ Cyclohexan umkristallisiert werden.

### Synthese von Ir(L1-B)₃:

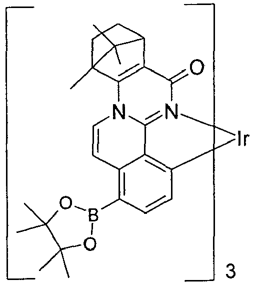

Einsatz von 14.3 g (10 mmol) Ir(L1-Br)₃ und 9.1 g (36 mmol) Bis(pinacolato)-diboran [73183-34-3], DMSO, 140 °C, 6 h, THF, Umkristallisation aus THF:Methanol. Ausbeute: 9.5 g (6.5 mmol) 65 %; Reinheit: ca. 99.7 %ig nach HPLC.

### E: Polymere enthaltend die Metallkomplexe:

### 1) Allgemeine Polymerisationsvorschrift für die Bromide bzw. Boronsäure-Derivate als polymerisierbare Gruppe, Suzuki-Polymerisation

### Variante A - Zweiphasiges Reaktionsgemisch

Die Monomere (Bromide und Boronsäuren bzw. Boronsäureester, Reinheit nach HPLC > 99.8 %ig) werden in der in der Tabelle angegebenen Zusammensetzung in einer Gesamtkonzentration von ca. 100 mmol/L in einem Gemisch aus 2 Volumenteilen Toluol: 6 Volumenteilen Dioxan : 1 Volumenteil Wasser gelöst bzw. suspendiert. Dann gibt man 2 mol Äquivalente Trikaliumphosphat pro eingesetzter Br-Funktionalität zu, rührt 5 min. nach, fügt dann 0.03-0.003 mol Äquivalente Tri-ortho-tolylphosphin und dann 0.005-0.0005 mol Äquivalente Palladium(II)acetat (Verhältnis Phosphin zu Pd bevorzugt 6:1) pro eingesetzter Br-Funktionalität zu und erhitzt dann unter sehr gutem Rühren 2-3 h unter Rückfluss. Falls die Viskosität der Mischung zu stark ansteigt, kann mit einem Gemisch aus 2 Volumenteilen Toluol: 3 Volumenteilen Dioxan verdünnt werden. Nach insgesamt 4-6 h Reaktionszeit fügt man zum End-capping 0.05 mol Aquivalente pro eingesetzter Boronsäure-Funktionalität eines Monobromaromaten und dann 30 min. danach 0.05 mol Äquivalente pro eingesetzter Br-Funktionalität einer Monoboronsäure bzw. eines Monoboronsäureesters zu und kocht weiter 1 h nach. Nach Erkalten verdünnt man mit 300 ml Toluol, trennt die wässrige Phase ab, wäscht die organische Phase zweimal mit je 300 ml Wasser, trocknet über Magnesiumsulfat, filtriert über ein Celite-Bett ab, um Palladium zu entfernen, und engt dann zur Trockene ein. Man löst das Rohpolymer in THF (Konzentration ca. 10-30 g/L) und lässt die Lösung unter sehr gutem Rühren langsam in das doppelte Volumen Methanol einlaufen. Das Polymer wird abgesaugt und dreimal mit Methanol gewaschen. Der Umfällvorgang wird dreimal wiederholt, danach wird das Polymer im Vakuum bis zur Gewichtskonstanz bei 30-50 °C getrocknet.

### Variante B - Einphasiges Reaktionsgemisch

Die Monomere (Bromide und Boronsäuren bzw. Boronsäureester, Reinheit nach HPLC > 99.8 % ig) werden in der in der Tabelle angegebenen Zusammensetzung in einer Gesamtkonzentration von ca. 100 mmol/L in einem Lösemittel (THF, Dioxan, Xyylol, Mesitylen, Dimethylacetamid, NMP, DMSO, etc.) gelöst bzw. suspendiert. Dann gibt man 3 mol Äquivalente Base (Kaliumfluorid, Trikaliumphosphat, Kaliumcarbonat, Cäsiumcarbonat etc., jeweils wasserfrei) pro Br-Funktionalität und das Gewichtsäquivalent Glaskugeln (3 mm Durchmesser) zu, rührt 5 min. nach, fügt dann 0.03-0.003 mol Äquivalente Tri-ortho-tolylphosphin und dann 0.005-0.0005 mol Äquivalente Palladium(II)acetat (Verhältnis Phosphin : Pd bevorzugt 6:1) pro Br-Funktionalität zu und erhitzt dann unter sehr gutem Rühren 2-3 h unter Rückfluss. Alternativ können andere Phosphine wir Tri-tert-butylphosphin, Di-tert-butylphosphin, S-Phos, Xanthphos, etc. eingesetzt werden, wobei bei diesen Phosphinen das bevorzugte Phosphin : Palladium Verhältnis 2:1 bis 1.3:1 beträgt. Nach insgesamt 4-12 h Reaktionszeit fügt man zum End-capping 0.05 mol Äquivalente eines Monobromaromaten und dann 30 min. danach 0.05 mol Äquivalente einer Monoboronsäure bzw. eines Monoboronsäureesters zu und kocht weiter 1 h nach. Man entfernt das Lösungsmittel weitgehend im Vakuum, nimmt den Rückstand in Toluol auf, und reinigt das Polymer wie unter Variante A beschrieben.

### Monomere / Endcapper:

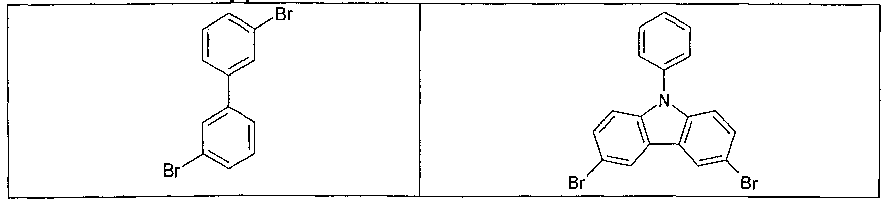

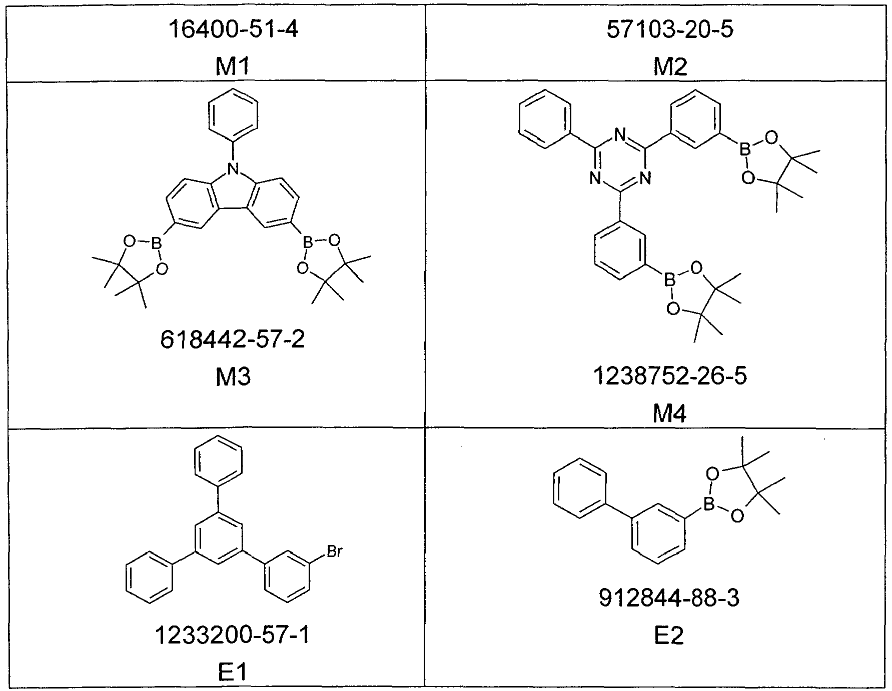

### Polymere:

Zusammensetzung der Polymere, mol %:

| Polymer | M1 [%] | M2 [%] | M3 [%] | M4 [%] | Ir-Komplex / [%] |
|---|---|---|---|---|---|
| P1 | --- | 30 | --- | 45 | Ir(L1-Br)₃/ 10 |
| P2 | 10 | 10 | --- | 35 | Ir(L1-Br)₃ / 10 |
| P3 | 50 | --- | 20 | 45 | Ir(L5-Br)₃ / 10 |
| P4 | 30 | 30 | 30 | 45 | Ir(L1-B)₃/10 |

Molekulargewichte und Ausbeute der erfindungsgemäßen Polymere

| Polymer | Mn [gmol⁻¹] | Polydispersität | Ausbeute |
|---|---|---|---|
| P1 | 239.000 | 4.9 | 50 % |
| P2 | 258.000 | 4.8 | 47 % |
| P3 | 421.000 | 5.2 | 64 % |
| P4 | 384.000 | 4.7 | 60 % |

### Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (Indium Zinn Oxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M3:M2:Ir(L1)₃ (55%:35%:10%) bedeutet hierbei, dass das Material M3 in einem Volumenanteil von 55%, M2 in einem Anteil von 35% und Ir(L1)₃ in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 6 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50 % der Startleuchtdichte abgefallen ist, also von z. B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik wird die Verbindung Ir(Ref1)₃ verwendet. Die Ergebnisse der OLEDs sind in Tabelle 2 zusammengefasst.

**Tabelle 1: Aufbau der OLED**

| **Bsp.** | **HTL2 Dicke** | **EBL Dicke** | **EML Dicke** | **HBL Dicke** | **ETL Dicke** |
|---|---|---|---|---|---|
| **Grüne OLED** | | | | | |
| D-Ir(Ref1)₃ | HTM 220 nm | --- | M3:M2:Ir(Ref1)₃ (65%:30%:5%) 25 nm | HBM 10 nm | ETM1:ETM2 (50%:50%) 20 nm |
| D-Ir(L1)₃ | HTM 220 nm | --- | M3:M2:Ir(L1)₃ (65%:30%:5%) 25 nm | HBM 10 nm | ETM1:ETM2 (50%:50%) 20 nm |
| D-Ir(L4)₃ | HTM 220 nm | --- | M3:M2:Ir(L4)₃ (60%:35%:5%) 25 nm | HBM 10 nm | ETM1:ETM2 (50%:50%) 20 nm |
| D-Ir(L5)₃ | HTM 220 nm | --- | M3:M2:Ir(L5)₃ (65%:30%:5%) 25 nm | HBM 10 nm | ETM1:ETM2 (50%:50%) 20 nm |
| D-Ir(L6)₃ | HTM 220 nm | --- | M3:M2:Ir(L6)₃ (65%:30%:5%) 25 nm | HBM 10 nm | ETM1:ETM2 (50%:50%) 20 nm |
| D-Ir(L9)₃ | HTM 220 nm | --- | M3:M2:Ir(L9)₃ (65%:30%:5%) 25 nm | HBM 10 nm | ETM1:ETM2 (50%:50%) 20 nm |
| D-Ir(L13)₃ | HTM 220 nm | --- | M3:M2:Ir(L13)₃ (65%:30%:5%) 25 nm | HBM 10 nm | ETM1:ETM2 (50%:50%) 20 nm |
| D-Ir(L15)₃ | HTM 220 nm | --- | M3:M2:Ir(L15)₃ (65%:30%:5%) 25 nm | HBM 10 nm | ETM1:ETM2 (50%:50%) 20 nm |
| D-Ir(L22)₃ | HTM 220 nm | --- | M3:M2:Ir(L22)₃ (65%:30%:5%) 25 nm | HBM 10nm | ETM1:ETM2 (50%:50%) 20 nm |
| D-Ir(L24)₃ | HTM 220 nm | --- | M3:M2:Ir(L24)₃ (65%:30%:5%) 25 nm | HBM 10nm | ETM1:ETM2 (50%:50%) 20 nm |
| D-Ir(L42)₃ | HTM 220 nm | --- | M3:M2:Ir(L42)₃ (65%:30%:5%) 25 nm | HBM 10 nm | ETM1:ETM2 (50%:50%) 20 nm |
| D-Ir(L46)₃ | HTM 220 nm | --- | M3:M2:Ir(L46)₃ (65%:30%:5%) 25 nm | HBM 10 nm | ETM1:ETM2 (50%:50%) 20 nm |
| D-Ir(L55)₃ | HTM 220 nm | --- | M3:M2:Ir(L55)₃ (65%:30%:5%) 25 nm | HBM 10 nm | ETM1:ETM2 (50%:50%) 20 nm |
| D-Ir(L56)₃ | HTM 220 nm | --- | M3:M2:Ir(L56)₃ (55%:40%:5%) 25 nm | HBM 10 nm | ETM1:ETM2 (50%:50%) 20 nm |
| D-Ir(L57)₃ | HTM 220 nm | --- | M3:M2:Ir(L57)₃ (65%:30%:5%) 25 nm | HBM 10 nm | ETM1:ETM2 (50%:50%) 20 nm |
| D-Ir(L58)₃ | HTM 220 nm | --- | M3:M2:Ir(L58)₃ (60%:30%:10%) 25 nm | HBM 10 nm | ETM1:ETM2 (50%:50%) 20 nm |
| D-Ir(L59)₃ | HTM 220 nm | --- | M3:M2:Ir(L59)₃ (65%:30%:5%) 25 nm | HBM 10 nm | ETM1:ETM2 (50%:50%) 20 nm |
| D-Ir(L1)₂(CL1) | HTM 220 nm | --- | M3:M2:Ir(L1)₂(CL1) (50%:40%:10%) 25 nm | HBM 10 nm | ETM1:ETM2 (50%:50%) 20 nm |
| D-Ir(L6)₂(CL11) | HTM 220 nm | --- | M3:M2:Ir(L6)₂(CL11) (50%:40%:10%) 25 nm | HBM 10 nm | ETM1:ETM2 (50%:50%) 20 nm |
| D-Ir(L22)₂(CL11) | HTM 220 nm | --- | M3:M2:Ir(L22)₂(CL1 1) (50%:40%:10%) 25 nm | HBM 10 nm | ETM1:ETM2 (50%:50%) 20 nm |

| **Blaue OLEDs** | | | | | |
|---|---|---|---|---|---|
| D-Ir(L25)₃ | HTM 180 nm | EBM 20 nm | M1:M4:Ir(L25)₃ (65%:30%:5%) 25 nm | HBM 10 nm | ETM1:ETM2 (50%:50%) 30 nm |
| D-Ir(L39)₃ | HTM 180 nm | EBM 20 nm | M1:M4:Ir(L39)₃ (65%:30%:5%) 25 nm | HBM 10 nm | ETM1:ETM2 (50%:50%) 30 nm |
| D-Ir(L1)₂(L25) | HTM 180 nm | EBM 20 nm | M1:M4:Ir(L1)₂(L25) (65%:30%:5%) 25 nm | HBM 10 nm | ETM 1: ETM2 (50%:50%) 30 nm |
| D-Ir(L25)₂(CL8) | HTM 180 nm | EBM 20 nm | M1 :M3:Ir(L25)₂(CL8) (65%:30%:5%) 25 nm | HBM 10 nm | ETM1:ETM2 (50%:50%) 30 nm |
| D-Ir(L29)₂(CL9) | HTM 180 nm | EBM 20 nm | M1:M3:Ir(L29)₂(CL9) (65%:30%:5%) 25 nm | HBM 10 nm | ETM1:ETM2 (50%:50%) 30 nm |
| D-Ir(L39)₂(CL10) | HTM 180 nm | EBM 20 nm | M1:M3:Ir(L39)₂(CL10) (65%:30%:5%) 25 nm | HBM 10nm | ETM1:ETM2 (50%:50%) 30 nm |

| **Gelbe OLEDs** | | | | | |
|---|---|---|---|---|---|
| D-Ir(L13)₃ | HTM 220 nm | --- | M3:M2:Ir(L13)₃ (60%:30%:10%) 25 nm | HBM 10 nm | ETM1:ETM2 (50%:50%) 20 nm |
| D-Ir(L53)₃ | HTM 230 nm | --- | M3:M2:Ir(L53)₃ (65%:30%:5%) 30 nm | --- | ETM1:ETM2 (50%:50%) 30 nm |
| D-Ir(L53)₂(CL2) | HTM 230 nm | --- | M3:M2:Ir(L53)₂(CL2) (65%:30%:5%) 30 nm | --- | ETM1:ETM2 (50%:50%) 30 nm |
| D-Ir(L46)₂(CL13) | HTM 230 nm | --- | M3:M2:Ir(L46)₂(CL2) (65%:30%:5%) 30 nm | --- | ETM1:ETM2 (50%:50%) 30 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD50 (h) 1000 cd/m²** |
|---|---|---|---|---|
| **Grüne OLED** | | | | |
| D-Ir(Ref1)₃ | 21.0 | 3.3 | 0.29/0.58 | 100000 |
| D-Ir(L1)₃ | 23.3 | 3.2 | 0.33/0.65 | 140000 |
| D-Ir(L4)₃ | 23.0 | 3.4 | 0.32/0.66 | --- |
| D-Ir(L5)₃ | 22.9 | 3.3 | 0.33/0.65 | --- |
| D-Ir(L6)₃ | 23.3 | 3.3 | 0.31/0.62 | 180000 |
| D-Ir(L9)₃ | 23.7 | 3.4 | 0.30/0.63 | 210000 |
| D-Ir(L13)₃ | 23.0 | 3.3 | 0.38/0.58 | 210000 |
| D-Ir(L15)₃ | 22.8 | 3.4 | 0.37/0.59 | 210000 |
| D-Ir(L22)₃ | 22.5 | 3.4 | 0.31/0.63 | --- |
| D-Ir(L24)₃ | 23.2 | 3.3 | 0.33/0.61 | --- |
| D-Ir(L42)₃ | 22.6 | 3.3 | 0.38/0.59 | --- |
| D-Ir(L46)₃ | 23.1 | 3.3 | 0.37/0.60 | --- |
| D-Ir(L55)₃ | 22.8 | 3.4 | 0.31/0.62 | 200000 |
| D-Ir(L56)₃ | 23.4 | 3.4 | 0.30/0.62 | --- |
| D-Ir(L57)₃ | 23.0 | 3.4 | 0.31/0.61 | --- |
| D-Ir(L58)₃ | 22.9 | 3.2 | 0.29/0.63 | 160000 |
| D-Ir(L59)₃ | 23.3 | 3.5 | 0.31/0.62 | --- |
| D-Ir(L1)₂(CL1) | 20.3 | 3.3 | 0.30/0.66 | --- |
| D-Ir(L6)₂(CL11) | 19.5 | 3.5 | 0.27/0.65 | 80000 |
| D-Ir(L22)₂(CL11) | 19.9 | 3.5 | 0.27/0.65 | --- |

| **Blaue OLEDs** | | | | |
|---|---|---|---|---|
| D-Ir(L25)₃ | 23.0 | 3.6 | 0.15/0.28 | --- |
| D-Ir(L39)₃ | 19.8 | 3.5 | 0.15/0.33 | --- |
| D-Ir(L1)₂(L25) | 21.4 | 3.4 | 0.18/0.42 | 15000 |
| D-Ir(L25)₂(CL8) | 20.1 | 3.5 | 0.15/0.33 | 2000 |
| D-Ir(L29)₂(CL9) | 19.5 | 3.6 | 0.15/0.30 | --- |
| D-Ir(L39)₂(CL10) | 18.7 | 3.6 | 0.15/0.34 | --- |

| **Gelbe OLEDs** | | | | |
|---|---|---|---|---|
| D-Ir(L13)₃ | 22.6 | 3.3 | 0.47/0.50 | 160000 |
| D-Ir(L53)₃ | 21.4 | 3.2 | 0.54/0.43 | 65000 |
| D-Ir(L53)₂(CL2) | 20.6 | 3.2 | 0.53/0.45 | --- |
| D-Ir(L46)₂(CL13) | 22.0 | 3.2 | 0.45/0.53 | --- |

### 2) Lösungs-prozessierte Devices

### A: Aus löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf weiche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für eine Device typische Schichtdicke von 80 nm mittels Spincoating erzielt werden soll. Die lösungsprozessierten Devices enthalten eine Emissionsschicht aus (Polystyrol):M5:M6:Ir(L)₃ (25%:25%:40%:10%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x 10⁻⁶ mbar) aufgedampft. Optional kann zunächst eine Lockblockierschicht und dann eine Eletronentransportschicht und dann erst die Kathode (z. B. Al oder LiF/Al) im Vakuum aufgedampft werden. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

### B: Aus polymeren Ir-Komplexen

Die Herstellung einer polymeren organischen Leuchtdiode (PLED) ist in der Literatur bereits vielfach beschrieben (z. B. WO 2004/037887). Die Substrate werden, wie unter A: Aus löslichen Funktionsmaterialien beschrieben, vorbereitet, danach werden unter Inertgasatmosphäre (Stickstoff bzw. Argon) zunächst 20 nm einer Interlayer (typischerweise ein lochdominiertes Polymer, hier HIL-012 von Merck) und dann 65 nm der Polymerschichten aus Toluollösung (Konzentration Interlayer 5 g/l) aufgebracht. Beide Schichten werden bei 160 °C mindestens 10 Minuten ausgeheizt. Danach wird die Kathode aus Barium (5 nm) und dann Aluminium (100 nm) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

**Tabelle 3: Ergebnisse mit aus Lösung prozessierten Materialien**

| **Bsp.** | **Ir(L)₃** | **EQE (%) 1000 cd/m²** | **Spannung (V) 1000 cd/m²** | **CIE x/y 1000 cd/m²** |
|---|---|---|---|---|
| **Grüne OLEDs** | | | | |
| S-IrL2)₃ | Ir(L2)₃ | 19.1 | 4.5 | 0.30/0.62 |
| S-Ir(L3)₃ | Ir(L3)₃ | 19.6 | 4.5 | 0.30/0.62 |
| S-Ir(L7)₃ | Ir(L7)₃ | 17.4 | 4.6 | 0.31/0.62 |
| S-Ir(L8)₃ | Ir(L8)₃ | 20.0 | 4.6 | 0.30/0.62 |
| S-Ir(L10)₃ | Ir(L10)₃ | 20.3 | 4.5 | 0.30/0.62 |
| S-Ir(L11)₃ | Ir(L11)₃ | 20.5 | 4.6 | 0.30/0.61 |
| S-Ir(L12)₃ | Ir(L12)₃ | 20.3 | 4.5 | 0.37/0.59 |
| S-Ir(L14)₃ | Ir(L14)₃ | 19.7 | 4.4 | 0.37/0.59 |
| S-Ir(L16)₃ | Ir(L16)₃ | 18.7 | 4.5 | 0.30/0.62 |
| S-Ir(L18)₃ | Ir(L18)₃ | 20.7 | 4.4 | 0.30/0.62 |
| S-Ir(L19)₃ | Ir(L19)₃ | 20.5 | 4.6 | 0.30/0.62 |
| S-IrL20)₃ | Ir(L20)₃ | 19.6 | 4.5 | 0.30/0.58 |
| S-Ir(L21)₃ | Ir(L21)₃ | 20.0 | 4.5 | 0.30/0.63 |
| S-Ir(L23)₃ | Ir(L23)₃ | 20.6 | 4.5 | 0.31/0.64 |
| S-Ir(L43)₃ | Ir(L43)₃ | 20.3 | 4.6 | 0.37/0.59 |
| S-Ir(L44)₃ | Ir(L44)₃ | 20.2 | 4.5 | 0.37/0.59 |
| S-Ir(L46)₃ | Ir(L46)₃ | 21.1 | 4.5 | 0.36/0.58 |
| S-Ir(L47)₃ | Ir(L47)₃ | 21.4 | 4.5 | 0.36/0.58 |
| S-Ir(L48)₃ | Ir(L48)₃ | 19.5 | 4.7 | 0.35/0.60 |
| S-Ir(L49)₃ | Ir(L49)₃ | 21.5 | 4.6 | 0.36/0.58 |
| S-Ir(L22)₂(CL11) | Ir(L22)₂(CL11) | 20.0 | 4.7 | 0.20/0.55 |
| S-Ir(L100)₃ | Ir(L100)₃ | 21.5 | 4.5 | 0.35/0.63 |
| S-Ir(L 101)₃ | Ir(L1 01)₃ | 20.6 | 4.6 | 0.35/0.62 |
| S-Ir(L102)₃ | Ir(L102)₃ | 18.6 | 4.1 | 0.32/0.64 |
| S-Ir(L103)₃ | Ir(L103)₃ | 20.3 | 4.6 | 0.34/0.62 |
| S-Ir(L104)₃ | Ir(L104)₃ | 20.6 | 4.6 | 0.38/0.59 |
| S-Ir(L201)₃ | Ir(L201)₃ | 20.0 | 4.6 | 0.35/0.62 |

| **Blaue OLEDs** | | | | |
|---|---|---|---|---|
| S-Ir(L25)₂(L39) | Ir(L25)₂(L39) | 18.4 | 4.7 | 0.15/0.30 |

| **Gelbe OLEDs** | | | | |
|---|---|---|---|---|
| S-Ir(L50)₃ | Ir(L50)₃ | 19.0 | 4.2 | 0.52/0.46 |
| S-Ir(L46)₂(CL13) | Ir(L46)₂(CL13) | 189.7 | 4.2 | 0.45/0.52 |
| S-Ir(L50)₂(CL14) | Ir(L50)₂(CL14) | 18.4 | 4.0 | 0.63/0.35 |
| S-Ir(L200)₃ | Ir(L200)₃ | 18.8 | 4.3 | 0.59/0.38 |

| **Polymere OLEDs** | | | | |
|---|---|---|---|---|
| D-P1 | P1 | 20.2 | 4.3 | 0.34/0.64 |
| D-P2 | P2 | 19.8 | 4.4 | 0.35/0.63 |

### 3) Weiß emittierende OLEDs

Gemäß den allgemeinen Verfahren aus 1) wird eine weiß emittierende OLED mit folgendem Schichtaufbau hergestellt:

**Tabelle 4: Aufbau der weißen OLEDs**

| **Bsp.** | **HTL2** | **EML Rot** | **EML Blau** | **EML Grün** | **HBL** | **ETL** |
|---|---|---|---|---|---|---|
| | **Dicke** | **Dicke** | **Dicke** | **Dicke** | **Dicke** | **Dicke** |
| D-W1 | HTM | EBM:Ir-R (97%:3%) | M1:M3:Ir(L28)₃ (40%:50%:10%) | M3:Ir-G (90%:10%) | M3 | ETM1:ETM2 (50%:50%) |
| | 230 nm | 9 nm | 8 nm | 7 nm | 10 nm | 30 nm |

**Tabelle 5: Deviceergebnisse**

| **Bsp.** | **EQE (%)** | **Spannung (V) 1000 cd/m²** | **CIE x/y 1000 cd/m²** | **LD50 (h)** |
|---|---|---|---|---|
| | **1000 cd/m²** | | **CRI** | **1000 cd/m²** |
| D-W1 | 22.3 | 6.6 | 0.45/0.43 | 5000 |
| | | | 80 | |

**Tabelle 6: Strukturformeln der verwendeten Materialien**

| | |
|---|---|
| 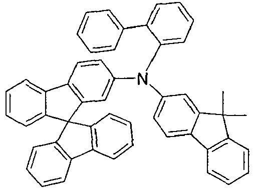 | 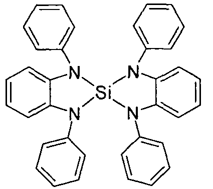 |
| HTM | EBM |
| 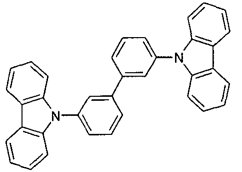 | 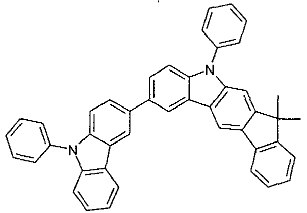 |
| M1 | M2 |
| 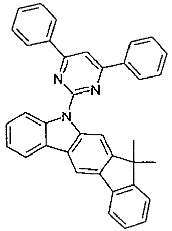 | 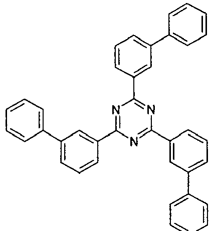 |
| M3 | M4 = HBM |
| 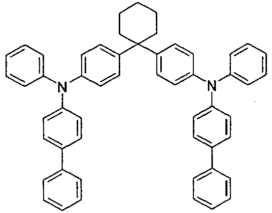 | 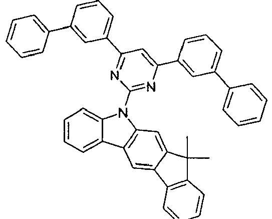 |
| M5 | M6 |
| 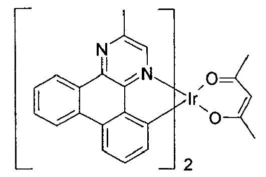 | 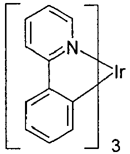 |
| Ir-R | Ir-G |
| 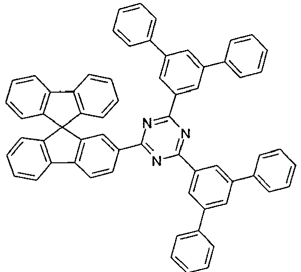 | 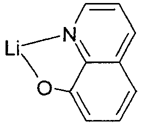 |
| ETM1 | ETM2 |
| 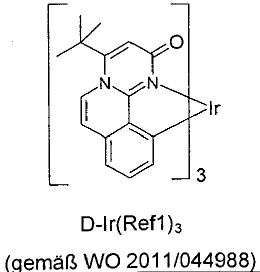 | |

### Vergleich der thermisch induzierten Lumineszenz-Löschung:

Auf einem Glasobjektträger werden nebeneinander Polystyrolfilme durch Auftropfen einer Dichlormethan-Lösung von Polystyrol und eines Emitters (Feststoffgehalt an Polystyrol ca. 10 Gew.-%, Feststoffgehalt an Emitter ca. 0.1 Gew.-%) und Abdampfen des Lösungsmittels hergestellt. Der Objektträger wird in einem abgedunkelten Raum von oben mit dem Licht einer UV-Lampe (Handelsübliche Lampe zur Betrachtung von DCs, Emissionswellenlänge 366 nm) beleuchtet, während er von unten mit dem Heißluftstrom eines regelbaren Heißluftföns angeströmt wird. Dabei wird die Temperatur sukzessive gesteigert und die thermische Lumineszenz-Löschung, also das partielle oder vollständige Erlöschen der Lumineszenz, in Abhängigkeit der Temperatur mit dem Auge verfolgt.

### Versuch 1:

### Film 1: Polystyrolfilm enthaltend Referenzemitter IrPPy, fac-Tris-(2-phenylpyridin)iridium [94928-86-6]

### Film 2: Polystyrolfilm enthaltend erfindungsgemäßen Emitter Ir(L1)₃

Ab einer Heißlufttemperatur von ca. 150 °C erkennt man ein langsames Erlöschen der Lumineszenz des Films 1; die Lumineszenz des Films 2 erscheint unverändert. Oberhalb von ca. 200 °C ist die Lumineszenz des Films 1 weitgehend erloschen, die des Films 2 erscheint nahezu unverändert. Selbst oberhalb von ca. 250 °C beobachtet man nur eine schwache Löschung der Lumineszenz des Films 2.

Beim Erkalten der Filme kehrt die Lumineszenz beider Filme zurück und erscheint so intensiv wie zu Beginn des Experiments. Das Experiment kann viele Male wiederholt werden, was zeigt, dass es sich um ein reversibles temperaturabhängiges Löschungsphänomen handelt und nicht um eine irreversible Zersetzung der Proben.

## Patentansprüche

1. Verbindung gemäß Formel (1),
[Ir(L)ₙ(L')ₘ] Formel (1)
enthaltend eine Teilstruktur Ir(L)ₙ der Formel (2): 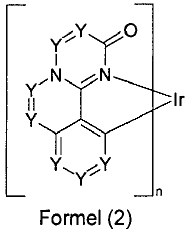 wobei für die verwendeten Symbole und Indizes gilt:
Y ist bei jedem Auftreten gleich oder verschieden CR oder N mit der Maßgabe, dass maximal ein Symbol Y pro Cyclus für N steht, oder zwei benachbarte Symbole Y stehen zusammen für eine Gruppe der folgenden Formel (3), 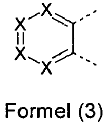 wobei die gestrichelten Bindungen die Verknüpfung dieser Gruppe im Liganden symbolisieren;
X ist bei jedem Auftreten gleich oder verschieden CR oder N mit der Maßgabe, dass maximal zwei Symbole X pro Ligand für N stehen;
R ist bei jedem Auftreten gleich oder verschieden H, D, F, Cl, Br, I, N(R¹)₂, CN, Si(R¹)₃, B(OR¹)₂, C(=O)R¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, Si(R¹)₂, C=O, NR¹, O, S oder CONR¹ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden;
R¹ ist bei jedem Auftreten gleich oder verschieden H, D, F, Cl, Br, I, N(R²)₂, CN, Si(R²)₃, B(OR²)₂, C(=O)R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², Si(R²)₂, C=O, NR², O, S oder CONR² ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches Ringsystem bilden;
R² ist bei jedem Auftreten gleich oder verschieden H, D, F oder ein aliphatischer, aromatischer und/oder heteroaromatischer organischer Rest mit 1 bis 20 C-Atomen, in dem ein oder mehrere H-Atome durch D oder F ersetzt sein können; dabei können zwei oder mehrere Substituenten R² miteinander ein mono- oder polycyclisches, aliphatisches oder aromatisches Ringsystem bilden;
L' ist gleich oder verschieden bei jedem Auftreten ein mono- oder bidentater Ligand;
n ist 1, 2 oder 3;
m ist 0, 1, 2, 3 oder 4;
**dadurch gekennzeichnet, dass** in der Teilstruktur der Formel (2) zwei benachbarte Gruppen Y für CR stehen und die jeweiligen Reste R zusammen mit den C-Atomen einen Ring gemäß einer der Formeln (4), (5), (6), (7), (8), (9) oder (10) aufspannen,
und/oder dass zwei benachbarte Gruppen Y für eine Gruppe der Formel (3) stehen, in dieser Gruppe der Formel (3) zwei benachbarte Gruppen X für CR stehen und die jeweiligen Reste R zusammen mit den C-Atomen einen Ring gemäß einer der Formeln (4), (5), (6), (7), (8), (9) oder (10) aufspannen, 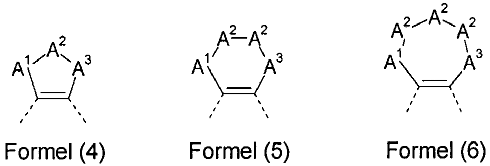 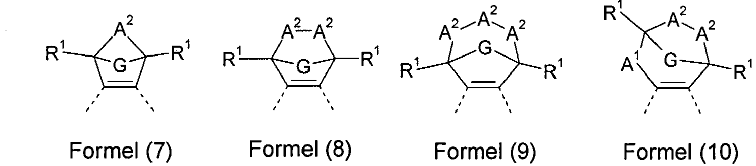 wobei R¹ und R² die oben genannten Bedeutungen aufweisen, die gestrichelten Bindungen die Verknüpfung der beiden Kohlenstoffatome im Liganden andeuten und weiterhin gilt:
A¹, A³ ist gleich oder verschieden bei jedem Auftreten C(R³)₂, S, NR³ oder C(=O);
A² ist C(R¹)₂, O, S, NR³ oder C(=O);
G ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
R³ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

2. Verbindung nach Anspruch 1, **dadurch gekennzeichnet, dass** n = 3 ist oder dass n = 2 und m = 1 ist, wobei L' ein bidentater Ligand ist, der über ein Kohlenstoffatom und ein Stickstoffatom, zwei Sauerstoffatome, zwei Stickstoffatome, ein Sauerstoff- und ein Stickstoffatom oder ein Kohlenstoffatom und ein Stickstoffatom an das Iridium koordiniert, oder dass n = 1 und m = 2 ist, wobei L' ein bidentater Ligand ist, der über ein Kohlenstoffatom und ein Stickstoffatom oder ein Kohlenstoffatom und ein Sauerstoffatom an das Iridium koordiniert.

3. Verbindung nach Anspruch 1 oder 2, **dadurch gekennzeichnet, dass** die Teilstruktur der Formel (2) ausgewählt ist aus den Formeln (11), (12), (13) oder (14), 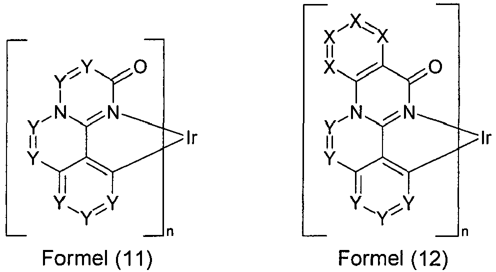 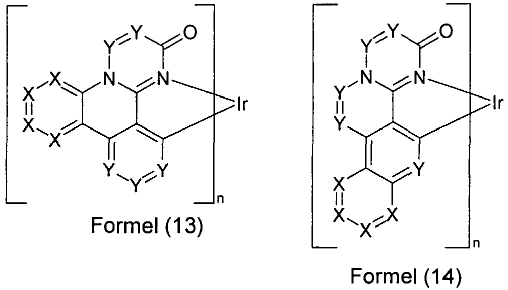 wobei Y bei jedem Auftreten gleich oder verschieden für CR oder N steht und die weiteren Symbole und Indizes die in Anspruch 1 genannten Bedeutungen aufweisen.

4. Verbindung nach einem oder mehreren der Ansprüche 1 bis 3, **dadurch gekennzeichnet, dass** im Liganden L insgesamt 0, 1 oder 2 der Symbole Y und, falls vorhanden, X für N stehen.

5. Verbindung nach einem oder mehreren der Ansprüche 1 bis 4, **dadurch gekennzeichnet, dass** die Teilstruktur der Formel (2) ausgewählt ist aus den Formeln (11-1) bis (11-5), (12-1) bis (12-8), (13-1) bis (13-8) und (14-1) bis (14-9), 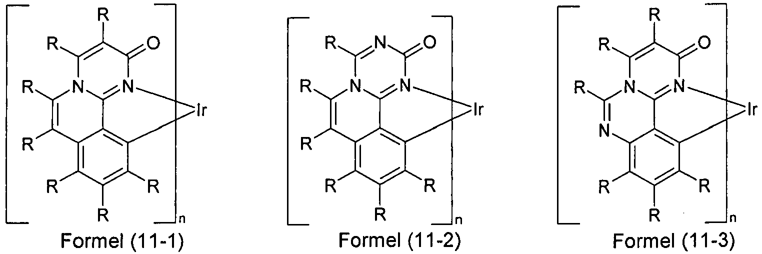 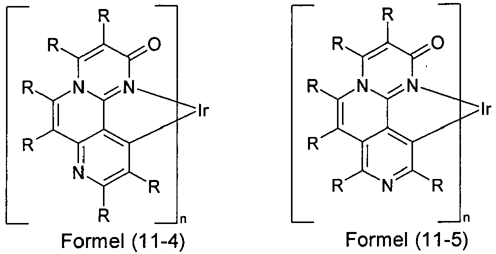 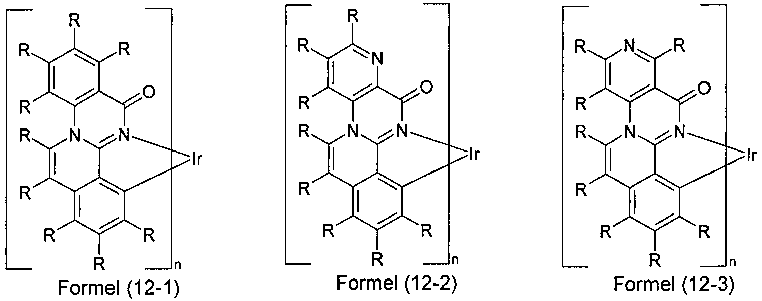 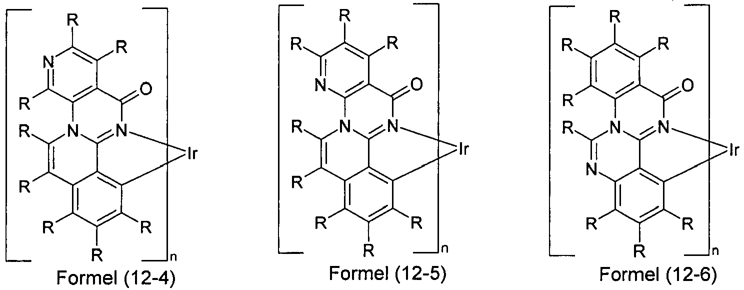 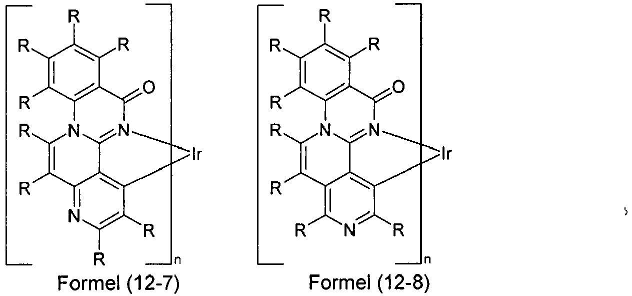 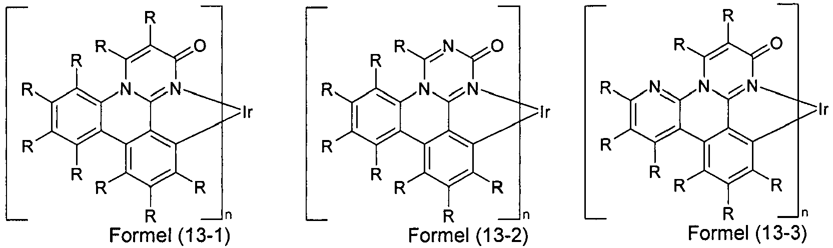 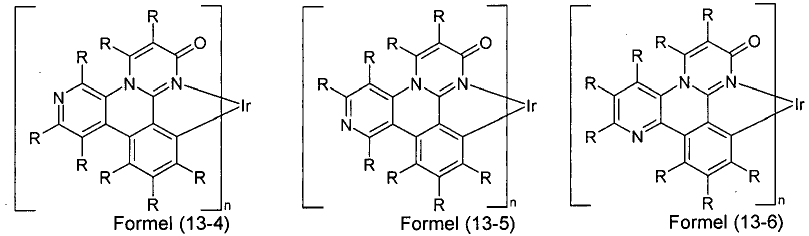 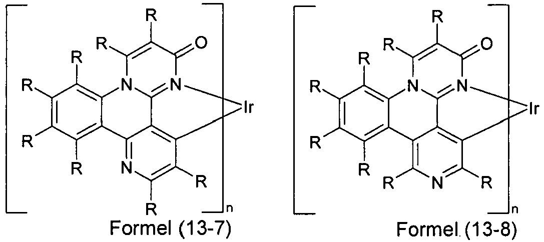 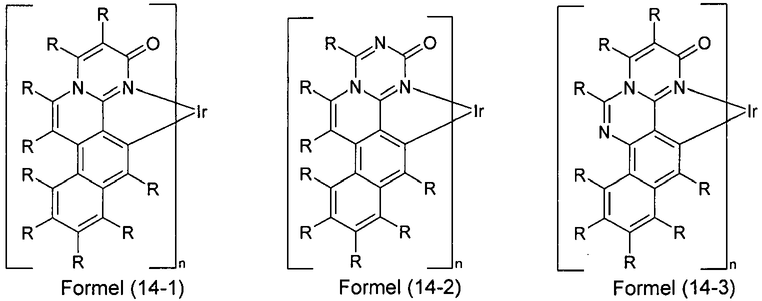 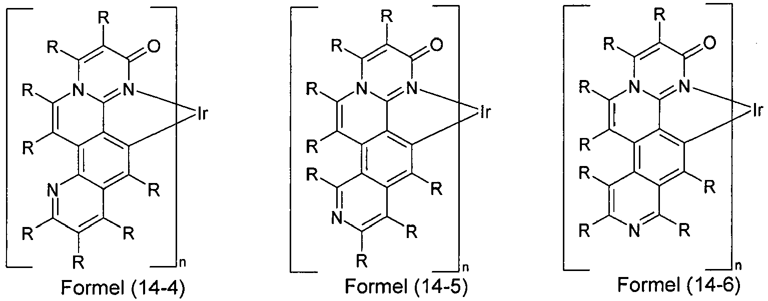 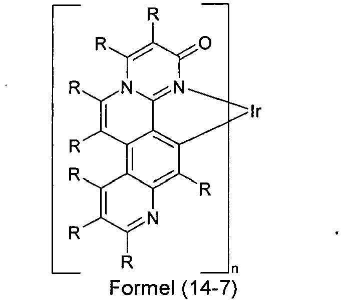 wobei die verwendeten Symbole und Indizes die in Anspruch 1 genannten Bedeutungen aufweisen, wobei der Rest R, der benachbart zu dem einem zusätzlichen N-Atom steht, bevorzugt ungleich H oder D ist.

6. Verbindung nach einem oder mehreren der Ansprüche 1 bis 4, **dadurch gekennzeichnet, dass** eines der Atome Y für N steht und/oder dass, wenn vorhanden, X für N steht, benachbart zu diesem N-Atom eine Gruppe R als Substituent gebunden ist, welche ungleich H oder D ist, oder.

7. Verbindung nach Anspruch 5 oder 6, **dadurch gekennzeichnet, dass** der Substituent R, welcher benachbart zu einem N-Atom ist, ausgewählt ist aus CF₃, OCF₃, einer Alkyl- oder Alkoxygruppe mit 1 bis 10 C-Atomen, insbesondere einer verzweigten oder cyclischen Alkyl- oder Alkoxygruppe mit 3 bis 10 C-Atomen, einer Dialkylaminogruppe mit 2 bis 10 C-Atomen, einem aromatischen bzw. heteroaromatischen Ringsystem oder einer Aralkyl- bzw. Heteroaralkylgruppe oder dass der Rest R mit einem benachbarten Rest R einen Cyclus gemäß einer der Formeln (4) bis (10) bildet.

8. Verbindung nach einem oder mehreren der Ansprüche 1 bis 7, **dadurch gekennzeichnet, dass** die Teilstruktur der Formel (2) ausgewählt ist aus den Formeln (11a) bis (14e), 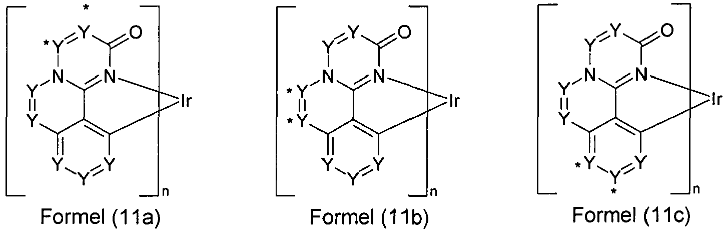 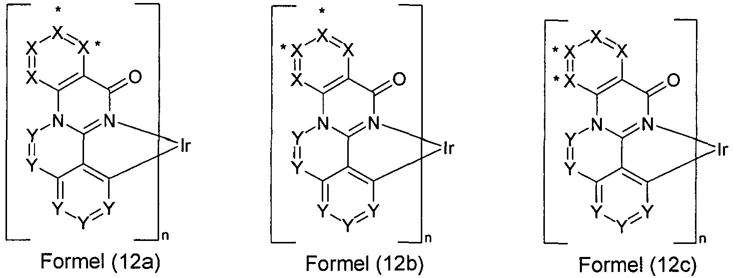 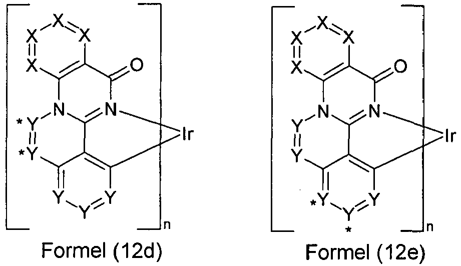 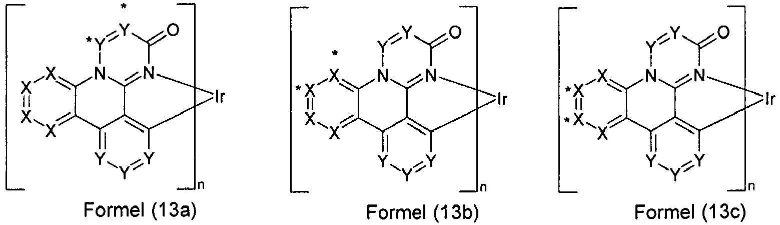 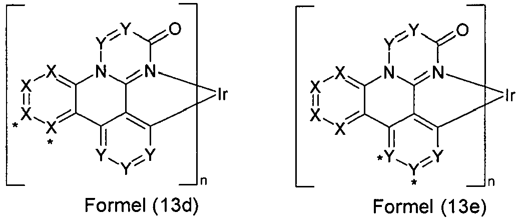 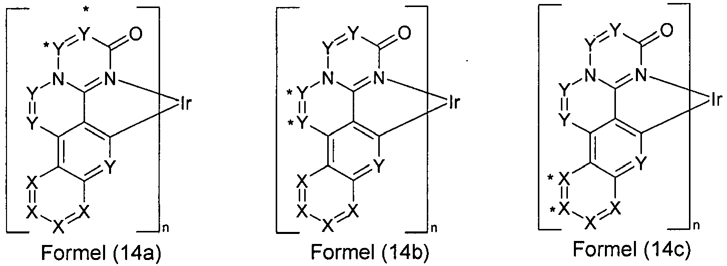 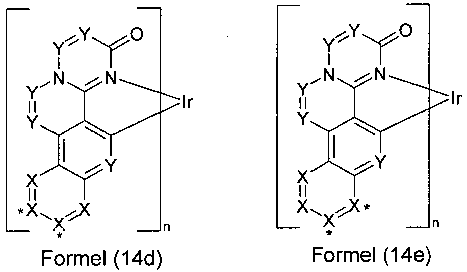 wobei die verwendeten Symbole und Indizes die in Anspruch 1 genannten Bedeutungen aufweisen und * jeweils die Position anzeigt, an der die beiden benachbarten Gruppen Y bzw. X für CR stehen und die jeweiligen Reste R zusammen mit den C-Atomen einen Ring gemäß einer der Formeln (4) bis (10) aufspannen.

9. Verbindung nach einem oder mehreren der Ansprüche 1 bis 8, **dadurch gekennzeichnet, dass** maximal eine der Gruppen A¹, A² und A³ für ein Heteroatom steht und die anderen Gruppen für C(R³)₂ bzw. C(R¹)₂ stehen oder A¹ und A³ gleich oder verschieden bei jedem Auftreten für NR³ stehen und A² für C(R¹)₂ steht.

10. Verbindung nach einem oder mehreren der Ansprüche 1 bis 9, **dadurch gekennzeichnet, dass** die Strukturen der Formel (4) ausgewählt sind aus den Strukturen der Formeln (4-A) bis (4-F), 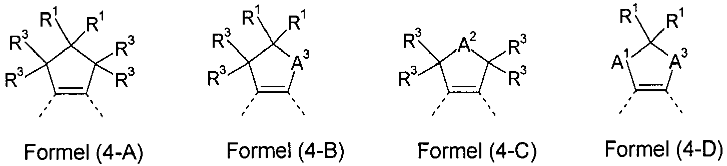 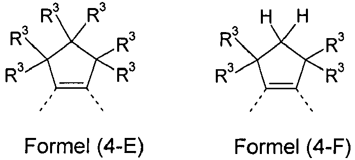 und dass die Strukturen der Formel (5) ausgewählt sind aus den Strukturen der Formeln (5-A) bis (5-F), 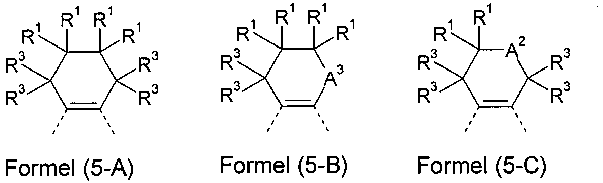 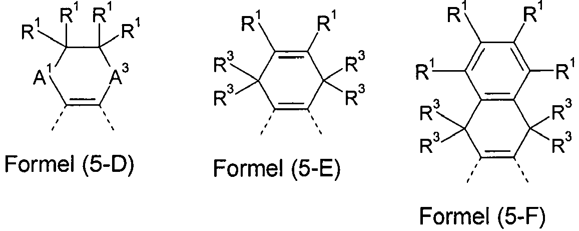 und dass die Strukturen der Formel (6) ausgewählt sind aus den Strukturen der Formeln (6-A) bis (6-E), 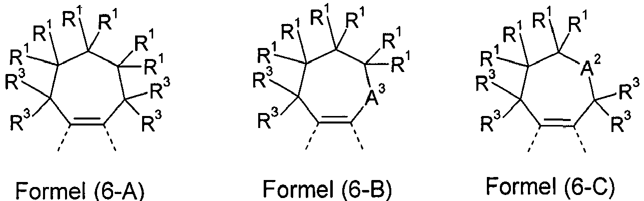 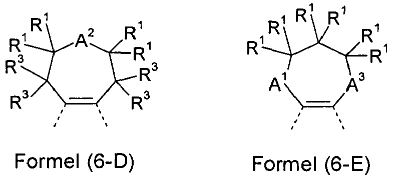 und dass die Strukturen der Formel (7) ausgewählt sind aus den Strukturen der Formeln (7-A) bis (7-C), 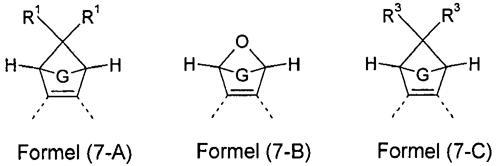 und dass die Strukturen der Formeln (8), (9) und (10) ausgewählt sind aus den Strukturen der Formeln (8-A), (9-A) und (10-A), 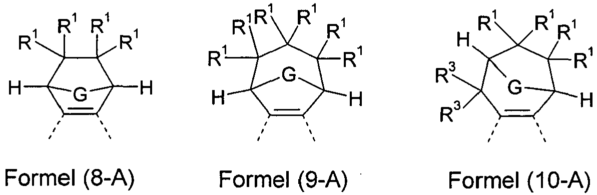 wobei R¹, R³ und G jeweils die in Anspruch 1 genannten Bedeutungen aufweisen und A¹ und A³ gleich oder verschieden bei jedem Auftreten für NR³ steht und A² gleich oder verschieden bei jedem Auftreten für O oder NR³ steht.

11. Oligomer, Polymer oder Dendrimer, enthaltend mindestens eine Verbindung nach einem oder mehreren der Ansprüche 1 bis 10, wobei die Verbindung statt einem oder mehreren Resten eine Bindung zum Oligomer, Polymer oder Dendrimer aufweist.

12. Verfahren zur Herstellung einer Verbindung nach einem oder mehreren der Ansprüche 1 bis 10 durch Umsetzung des freien Liganden mit Iridiumalkoholaten der Formel (43), mit Iridiumketoketonaten der Formel (44), mit Iridiumhalogeniden der Formel (45), mit dimeren Iridiumkomplexen der Formel (46) oder (47) oder mit Iridiumverbindungen, die sowohl Alkoholat- und/oder Halogenid- und/oder Hydroxy- wie auch Ketoketonatreste tragen, 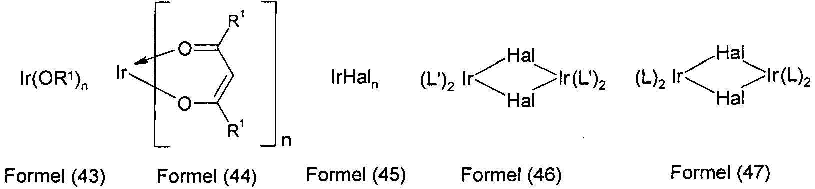 wobei die Symbole und Indizes die in Anspruch 1 angegebenen Bedeutungen haben und Hal = F, Cl, Br oder I ist.

13. Formulierung, enthaltend eine Verbindung nach einem oder mehreren der Ansprüche 1 bis 10 und/oder ein oder mehrere Oligomere, Polymere und/oder Dendrimere nach Anspruch 11 und mindestens eine weitere Verbindung, insbesondere ein Lösemittel und/oder ein Matrixmaterial.

14. Verwendung einer Verbindung nach einem oder mehreren der Ansprüche 1 bis 10 oder eines Oligomers, Polymers oder Dendrimers nach Anspruch 11 oder einer Formulierung nach Anspruch 13 in einer elektronischen Vorrichtung oder zur Erzeugung von Singulett-Sauerstoff, in der Photokatalyse oder in Sauerstoffsensoren.

15. Elektronische Vorrichtung enthaltend mindestens eine Verbindung nach einem oder mehreren der Ansprüche 1 bis 10 und/oder mindestens ein Oligomer, Polymer und/oder Dendrimer nach Anspruch 11 und/oder eine Formulierung nach Anspruch 13.

16. Elektronische Vorrichtung nach Anspruch 15, wobei es sich um eine organische Elektrolumineszenzvorrichtung handelt, **dadurch gekennzeichnet, dass** die Verbindung nach einem oder mehreren der Ansprüche 1 bis 10 als emittierende Verbindung in einer oder mehreren emittierenden Schichten eingesetzt wird.

## Claims

1. Compound of the formula (1),
[Ir(L)ₙ(L')ₘ] formula (1)
containing a moiety Ir(L)ₙ of the formula (2): 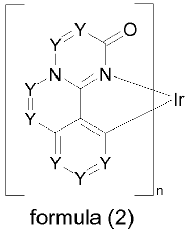 where the following applies to the symbols and indices used:
Y is on each occurrence, identically or differently, CR or N, with the proviso that a maximum of one symbol Y per ring stands for N, or two adjacent symbols Y together stand for a group of the following formula (3), 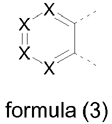 where the dashed bonds symbolise the linking of this group in the ligand;
X is on each occurrence, identically or differently, CR or N, with the proviso that a maximum of two symbols X per ligand stand for N;
R is on each occurrence, identically or differently, H, D, F, Cl, Br, I, N(R¹)₂, CN, Si(R¹)₃, B(OR¹)₂, C(=O)R¹, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R¹, where one or more non-adjacent CH₂ groups may be replaced by R¹C=CR¹, Si(R¹)₂, C=O, NR¹, O, S or CONR¹ and where one or more H atoms may be replaced by D, F or CN, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; two or more adjacent radicals R may also form a mono- or polycyclic, aliphatic, aromatic and/or benzo-fused ring system with one another;
R¹ is on each occurrence, identically or differently, H, D, F, Cl, Br, I, N(R²)₂, CN, Si(R²)₃, B(OR²)₂, C(=O)R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R², where one or more non-adjacent CH₂ groups may be replaced by R²C=CR², Si(R²)₂, C=O, NR², O, S or CONR² and where one or more H atoms may be replaced by D, F or CN, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², or a diarylamino group, diheteroarylamino group or arylheteroarylamino group having 10 to 40 aromatic ring atoms, which may be substituted by one or more radicals R²; two or more adjacent radicals R¹ may form a mono- or polycyclic, aliphatic ring system with one another;
R² is on each occurrence, identically or differently, H, D, F or an aliphatic, aromatic and/or heteroaromatic organic radical having 1 to 20 C atoms, in which one or more H atoms may be replaced by D or F; two or more substituents R² may form a mono- or polycyclic, aliphatic or aromatic ring system with one another;
L' is, identically or differently on each occurrence, a mono- or bidentate ligand;
n is 1, 2 or 3;
m is 0, 1, 2, 3 or 4;
**characterised in that** two adjacent groups Y in the moiety of the formula (2) stand for CR and the respective radicals R, together with the C atoms, form a ring of one of the formulae (4), (5), (6), (7), (8), (9) or (10), and/or **in that** two adjacent groups Y stand for a group of the formula (3), two adjacent groups X in this group of the formula (3) stand for CR, and the respective radicals R, together with the C atoms, form a ring of one of the formulae (4), (5), (6), (7), (8), (9) or (10), 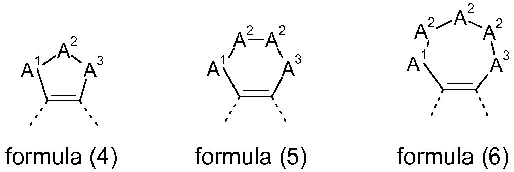 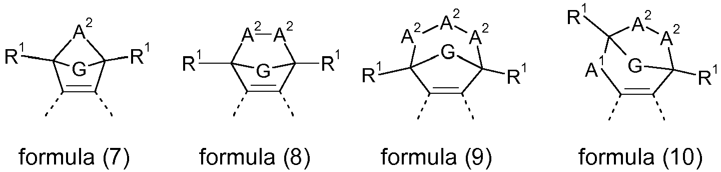 where R¹ and R² have the meanings given above, the dashed bonds indicate the linking of the two carbon atoms in the ligand, and furthermore:
A¹, A³ are, identically or differently on each occurrence, C(R³)₂, O, S, NR³ or C(=O);
A² is C(R¹)₂, O, S, NR³ or C(=O);
G is an alkylene group having 1, 2 or 3 C atoms, which may be substituted by one or more radicals R², or is -CR²=CR²- or an ortho-linked arylene or heteroarylene group having 5 to 14 aromatic ring atoms, which may be substituted by one or more radicals R²;
R³ is, identically or differently on each occurrence, F, a straight-chain alkyl or alkoxy group having 1 to 10 C atoms, a branched or cyclic alkyl or alkoxy group having 3 to 10 C atoms, which may in each case be substituted by one or more radicals R², where one or more non-adjacent CH₂ groups may be replaced by R²C=CR², C=C, Si(R²)₂, C=O, NR², O, S or CONR² and where one or more H atoms may be replaced by D or F, or an aromatic or heteroaromatic ring system having 5 to 24 aromatic ring atoms, which may in each case be substituted by one or more radicals R², or an aryloxy or heteroaryloxy group having 5 to 24 aromatic ring atoms, which may be substituted by one or more radicals R², or an aralkyl or heteroaralkyl group having 5 to 24 aromatic ring atoms, which may be substituted by one or more radicals R²; two radicals R³ which are bonded to the same carbon atom may form an aliphatic or aromatic ring system with one another and thus form a spiro system; furthermore, R³ may form an aliphatic ring system with an adjacent radical R or R¹;
with the proviso that two heteroatoms in these groups are not bonded directly to one another and two groups C=O are not bonded directly to one another.

2. Compound according to Claim 1, **characterised in that** n = 3 or **in that** n = 2 and m = 1, in which case L' is a bidentate ligand which is coordinated to the iridium via one carbon atom and one nitrogen atom, two oxygen atoms, two nitrogen atoms, one oxygen atom and one nitrogen atom or one carbon atom and one nitrogen atom, or **in that** n = 1 and m = 2, in which case L' is a bidentate ligand which is coordinated to the iridium via one carbon atom and one nitrogen atom or one carbon atom and one oxygen atom.

3. Compound according to Claim 1 or 2, **characterised in that** the moiety of the formula (2) is selected from the formulae (11), (12), (13) or (14), 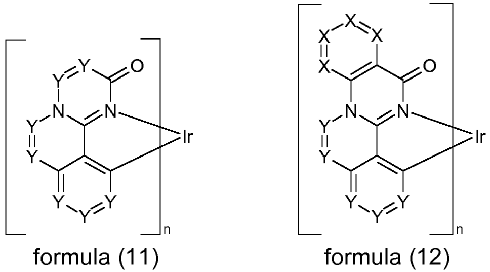 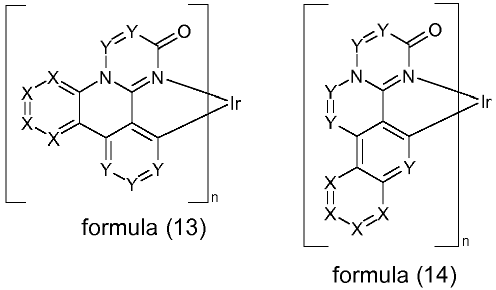 where Y stands on each occurrence, identically or differently, for CR or N and the other symbols and indices have the meanings given in Claim 1.

4. Compound according to one or more of Claims 1 to 3, **characterised in that** a total of 0, 1 or 2 of the symbols Y and, if present, X in the ligand L stand for N.

5. Compound according to one or more of Claims 1 to 4, **characterised in that** the moiety of the formula (2) is selected from the formulae (11-1) to (11-5), (12-1) to (12-8), (13-1) to (13-8) and (14-1) to (14-9), 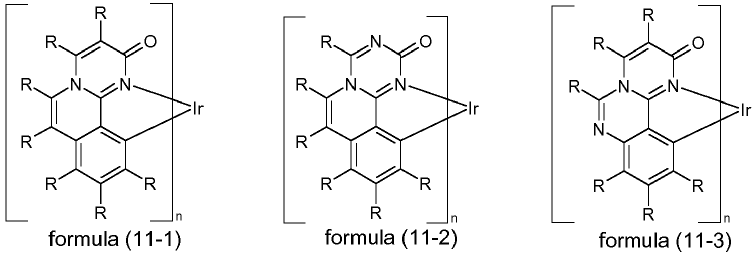 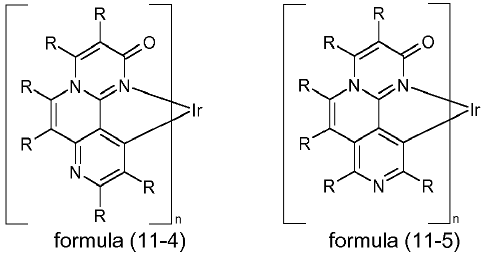 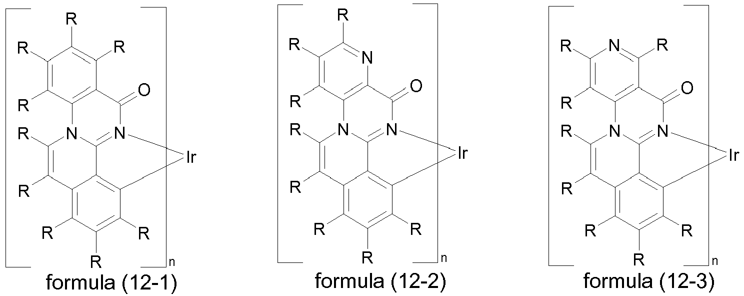 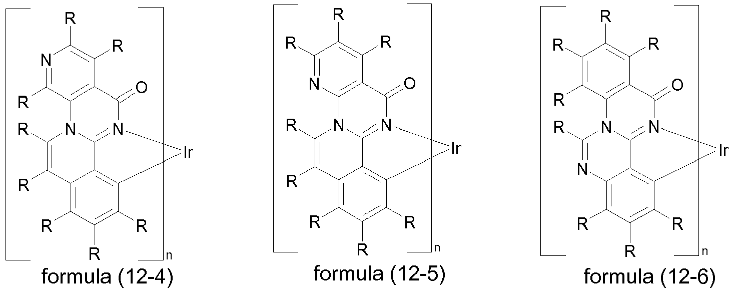 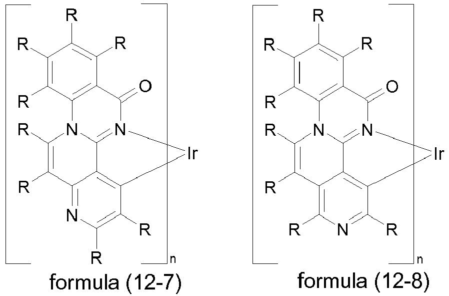 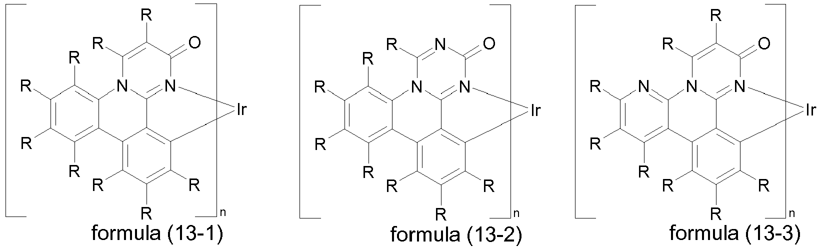 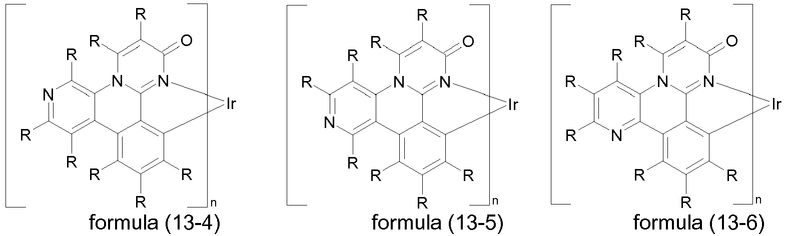 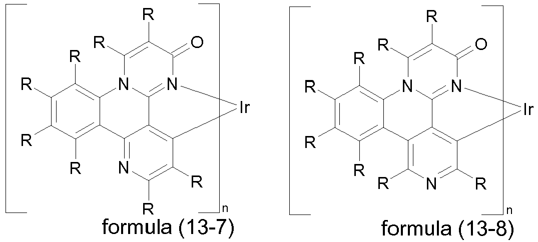 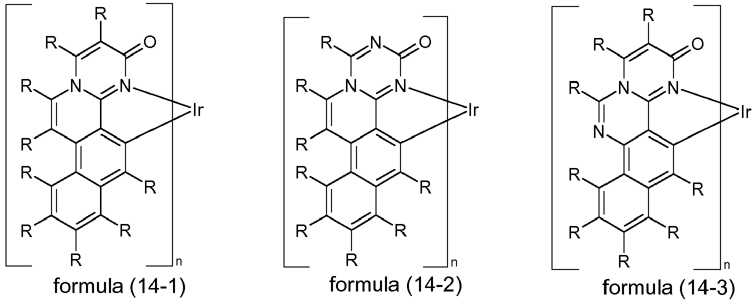 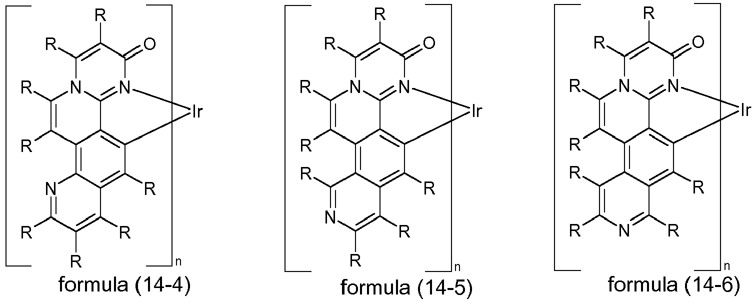 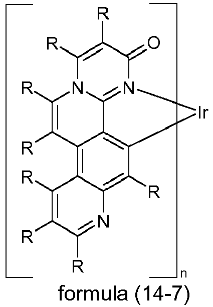 where the symbols and indices used have the meanings given in Claim 1, where the radical R that is adjacent to the one additional N atom is preferably not equal to H or D.

6. Compound according to one or more of Claims 1 to 4, **characterised in that** one of the atoms Y stands for N and/or **in that** X, if present, stands for N, a group R which is not equal to H or D is bonded as substituent adjacent to this N atom.

7. Compound according to Claim 5 or 6, **characterised in that** the substituent R that is adjacent to an N atom is selected from CF₃, OCF₃, an alkyl or alkoxy group having 1 to 10 C atoms, in particular a branched or cyclic alkyl or alkoxy group having 3 to 10 C atoms, a dialkylamino group having 2 to 10 C atoms, an aromatic or heteroaromatic ring system or an aralkyl or heteroaralkyl group, or **in that** the radical R with an adjacent radical R forms a ring of one of the formulae (4) to (10).

8. Compound according to one or more of Claims 1 to 7, **characterised in that** the moiety of the formula (2) is selected from the formulae (11a) to (14e), 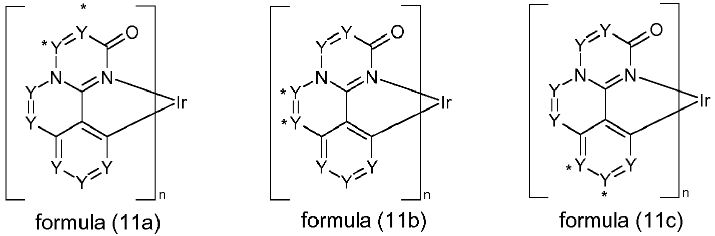 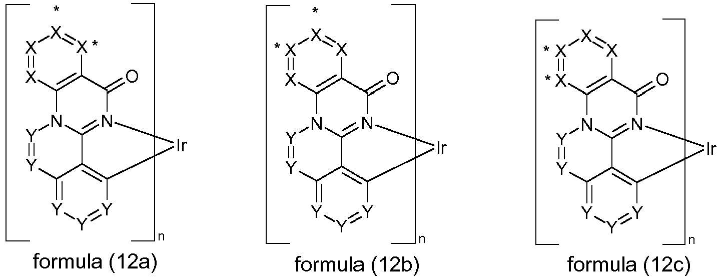 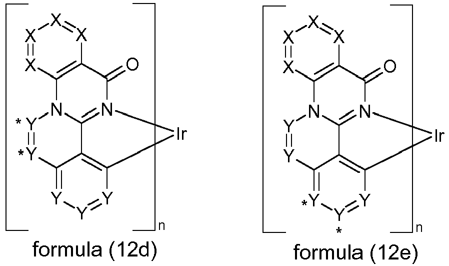 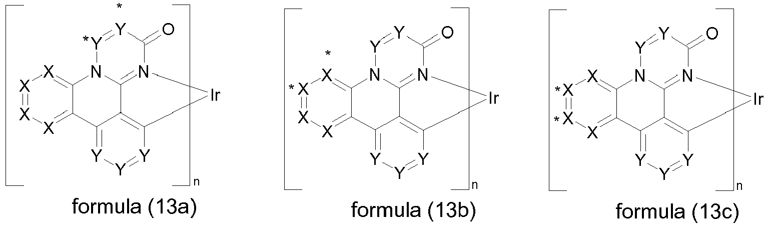 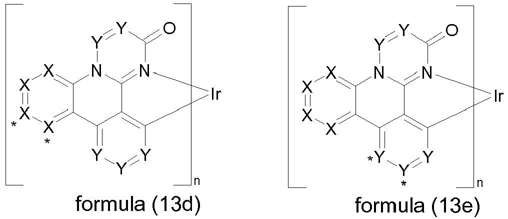 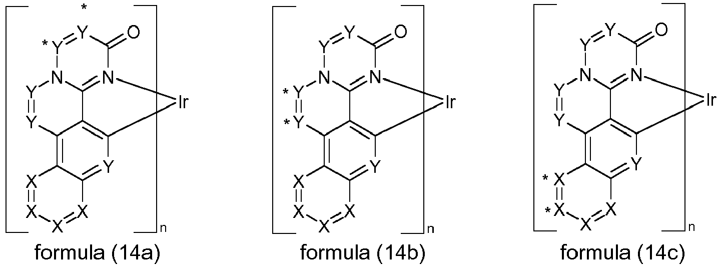 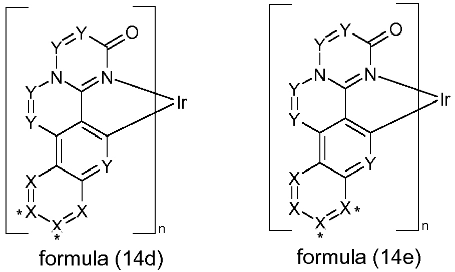 where the symbols and indices used have the meanings given in Claim 1 and * in each case indicates the position at which the two adjacent groups Y or X stand for CR and the respective radicals R, together with the C atoms, form a ring of one of the formulae (4) to (10).

9. Compound according to one or more of Claims 1 to 8, **characterised in that** a maximum of one of the groups A¹, A² and A³ stands for a heteroatom and the other groups stand for C(R³)₂ or C(R¹)₂ or A¹ and A³ stand, identically or differently on each occurrence, for NR³ and A² stands for C(R¹)₂.

10. Compound according to one or more of Claims 1 to 9, **characterised in that** the structures of the formula (4) are selected from the structures of the formulae (4-A) to (4-F), 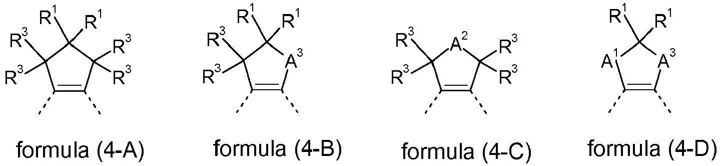 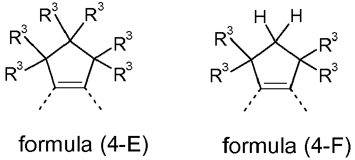 and **in that** the structures of the formula (5) are selected from the structures of the formulae (5-A) to (5-F), 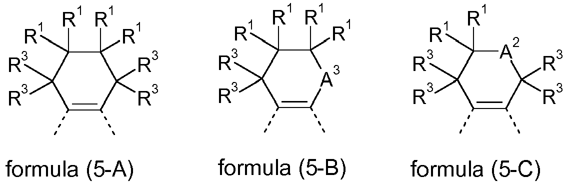 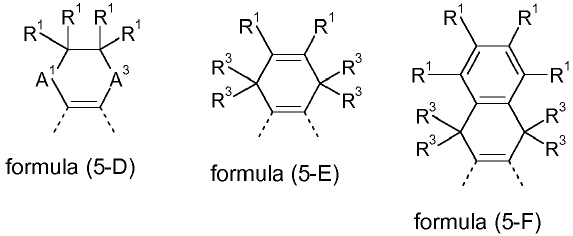 and **in that** the structures of the formula (6) are selected from the structures of the formulae (6-A) to (6-E), 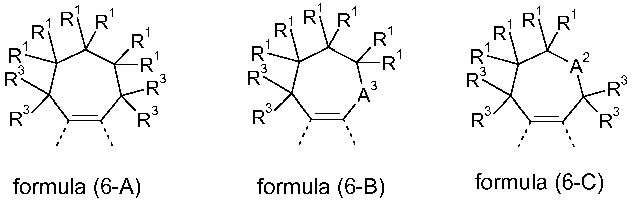 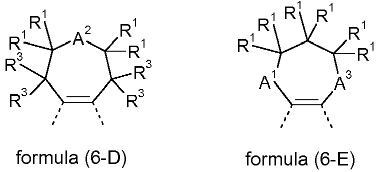 and **in that** the structures of the formula (7) are selected from the structures of the formulae (7-A) to (7-C), 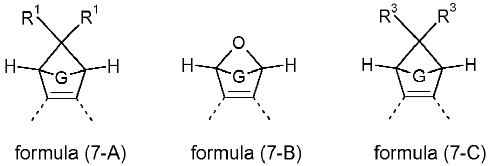 and **in that** the structures of the formulae (8), (9) and (10) are selected from the structures of the formulae (8-A), (9-A) and (10-A), 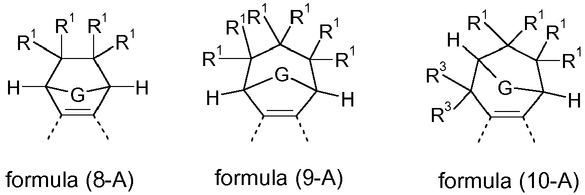 where R¹, R³ and G in each case have the meanings given in Claim 1, and A¹ and A³ stand, identically or differently on each occurrence, for NR³ and A² stands, identically or differently on each occurrence, for O or NR³

11. Oligomer, polymer or dendrimer containing at least one compound according to one or more of Claims 1 to 10, where the compound, instead of one or more radicals, has a bond to the oligomer, polymer or dendrimer.

12. Process for the preparation of a compound according to one or more of Claims 1 to 10 by reaction of the free ligand with iridium alkoxides of the formula (43), with iridium ketoketonates of the formula (44), with iridium halides of the formula (45), with dimeric iridium complexes of the formula (46) or (47) or with iridium compounds which carry both alkoxide and/or halide and/or hydroxyl and also ketoketonate radicals, 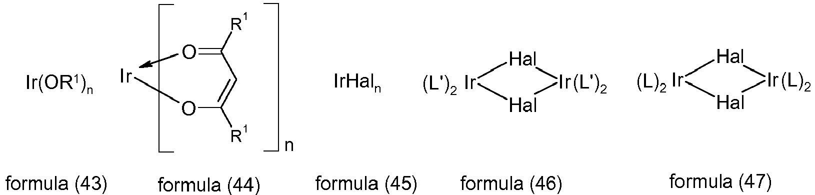 where the symbols and indices have the meanings indicated in Claim 1 and Hal = F, Cl, Br or I.

13. Formulation comprising a compound according to one or more of Claims 1 to 10 and/or one or more oligomers, polymers and/or dendrimers according to Claim 11 and at least one further compound, in particular a solvent and/or a matrix material.

14. Use of a compound according to one or more of Claims 1 to 10 or an oligomer, polymer or dendrimer according to Claim 11 or a formulation according to Claim 13 in an electronic device or for the generation of singlet oxygen, in photocatalysis or in oxygen sensors.

15. Electronic device containing at least one compound according to one or more of Claims 1 to 10 and/or at least one oligomer, polymer and/or dendrimer according to Claim 11 and/or a formulation according to Claim 13.

16. Electronic device according to Claim 15, which is an organic electroluminescent device, **characterised in that** the compound according to one or more of Claims 1 to 10 is employed as emitting compound in one or more emitting layers.

## Revendications

1. Composé de la formule (1) :
[Ir(L)ₙ(L')ₘ] formule (1)
contenant une moitié Ir(L)ₙ de la formule (2) : 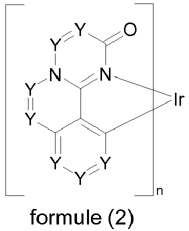 dans laquelle ce qui suit s'applique aux symboles et aux indices qui sont utilisés :
Y est pour chaque occurrence, de manière identique ou différente, CR ou N, étant entendu qu'un maximum d'un seul symbole Y par cycle représente N, ou deux symboles Y adjacents représentent ensemble un groupe de la formule (3) qui suit : 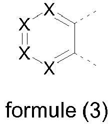 dans laquelle les liens en pointillés symbolisent la liaison de ce groupe dans le ligand ;
X est pour chaque occurrence, de manière identique ou différente, CR ou N, étant entendu qu'un maximum de deux symboles X par ligand représentent N ;
R est pour chaque occurrence, de manière identique ou différente, H, D, F, Cl, Br, I, N(R¹)₂, CN, Si(R¹)₃, B(OR¹)₂, C(=O)R¹, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R¹, où un ou plusieurs groupe(s) CH₂ non adjacents peut/peuvent être remplacé(s) par R¹C=CR¹, Si(R¹)₂, C=O, NR¹, O, S ou CONR¹ et où un ou plusieurs atome(s) de H peut/peuvent être remplacé(s) par D, F ou CN, ou un système de cycle aromatique ou hétéroaromatique qui comporte de 5 à 60 atomes de cycle aromatique, lequel peut dans chaque cas être substitué par un radical ou par plusieurs radicaux R¹, ou un groupe aryloxy ou hétéroaryloxy qui comporte de 5 à 60 atomes de cycle aromatique, lequel peut être substitué par un radical ou par plusieurs radicaux R¹, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R¹ ; deux radicaux R adjacents ou plus peuvent également former un système de cycle aliphatique, aromatique et/ou benzo-fusionné mono- ou polycyclique l'un avec l'autre ou les uns avec les autres ;
R¹ est pour chaque occurrence, de manière identique ou différente, H, D, F, Cl, Br, I, N(R²)₂, CN, Si(R²)₃, B(OR²)₂, C(=O)R², un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R², où un ou plusieurs groupe(s) CH₂ non adjacents peut/peuvent être remplacé(s) par R²C=CR², Si(R²)₂, C=O, NR², O, S ou CONR² et où un ou plusieurs atome(s) de H peut/peuvent être remplacé(s) par D, F ou CN, ou un système de cycle aromatique ou hétéro-aromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 60 atomes de cycle aromatique, lequel peut être substitué par un radical ou par plusieurs radicaux R², ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R²; deux radicaux R¹ adjacents ou plus peuvent former un système de cycle aliphatique mono- ou polycyclique l'un avec l'autre ou les uns avec les autres ;
R² est pour chaque occurrence, de manière identique ou différente, H, D, F ou un radical organique aliphatique, aromatique et/ou hétéroaromatique qui comporte de 1 à 20 atome(s) de C, où un ou plusieurs atome(s) de H peut/peuvent être remplacé(s) par D ou par F ; deux substituants R² ou plus peuvent former un système de cycle aliphatique ou aromatique mono- ou polycyclique l'un avec l'autre ou les uns avec les autres ; L' est, de manière identique ou différente pour chaque occurrence, un ligand mono- ou bidenté ;
n est 1, 2 ou 3 ;
m est 0, 1, 2, 3 ou 4 ;
**caractérisé en ce que** deux groupes Y adjacents dans la moitié de la formule (2) représentent CR et les radicaux R respectifs, en association avec les atomes de C, forment un cycle de l'une des formules (4), (5), (6), (7), (8), (9) ou (10) ;
et/ou **en ce que** deux groupes Y adjacents représentent un groupe de la formule (3), deux groupes X adjacents dans ce groupe de la formule (3) représentent CR, et les radicaux R respectifs, en association avec les atomes de C, forment un cycle de l'une des formules (4), (5), (6), (7), (8), (9) ou (10) ; 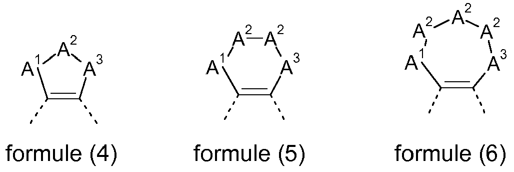 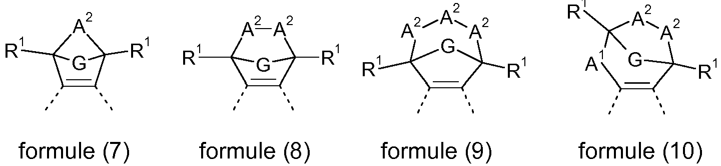 dans lesquelles R¹ et R² présentent les significations qui ont été données ci-avant, les liens en pointillés indiquent la liaison des deux atomes de carbone dans le ligand, et en outre :
A¹, A³ sont, de manière identique ou différente pour chaque occurrence, C(R³)₂, O, S, NR³ ou C(=O) ;
A² est C(R¹)₂, O, S, NR³ ou C(=O) ;
G est un groupe alkylène qui comporte 1, 2 ou 3 atome(s) de C, lequel peut être substitué par un radical ou par plusieurs radicaux R², ou est -CR²=CR²- ou un groupe arylène ou hétéroarylène ortho-lié qui comporte de 5 à 14 atomes de cycle aromatique, lequel peut être substitué par un radical ou par plusieurs radicaux R² ;
R³ est, de manière identique ou différente pour chaque occurrence, F, un groupe alkyle ou alcoxy en chaîne droite qui comporte de 1 à 10 atome(s) de C, un groupe alkyle ou alcoxy ramifié ou cyclique qui comporte de 3 à 10 atomes de C, lequel peut dans chaque cas être substitué par un radical ou par plusieurs radicaux R², où un ou plusieurs groupe(s) CH₂ non adjacents peut/ peuvent être remplacé(s) par R²C=CR², C=C, Si(R²)₂, C=O, NR², O, S ou CONR² et où un ou plusieurs atome(s) de H peut/ peuvent être remplacé(s) par D ou par F, ou un système de cycle aromatique ou hétéroaromatique qui comporte de 5 à 24 atomes de cycle aromatique, lequel peut dans chaque cas être substitué par un radical ou par plusieurs radicaux R², ou un groupe aryloxy ou hétéroaryloxy qui comporte de 5 à 24 atomes de cycle aromatique, lequel peut être substitué par un radical ou par plusieurs radicaux R², ou un groupe aralkyle ou hétéroaralkyle qui comporte de 5 à 24 atomes de cycle aromatique, lequel peut être substitué par un radical ou par plusieurs radicaux R² ; deux radicaux R³ qui sont liés au même atome de carbone peuvent former un système de cycle aliphatique ou aromatique l'un avec l'autre et peuvent ainsi former un système spiro ; en outre, R³ peut former un système de cycle aliphatique avec un radical R ou R¹ adjacent ;
étant entendu que deux hétéroatomes dans ces groupes ne sont pas liés directement l'un à l'autre et que deux groupes C=O ne sont pas liés directement l'un à l'autre.

2. Composé selon la revendication 1, **caractérisé en ce que** n = 3 ou **en ce que** n = 2 et m = 1, auquel cas L' est un ligand bidenté qui est coordonné par rapport à l'iridium via un atome de carbone et un atome d'azote, deux atomes d'oxygène, deux atomes d'azote, un atome d'oxygène et un atome d'azote, ou un atome de carbone et un atome d'azote, ou **en ce que** n = 1 et m = 2, auquel case L' est un ligand bidenté qui est coordonné par rapport à l'iridium via un atome de carbone et un atome d'azote ou un atome de carbone et un atome d'oxygène.

3. Composé selon la revendication 1 ou 2, **caractérisé en ce que** la moitié de la formule (2) est sélectionnée parmi les formules (11), (12), (13) ou (14) : 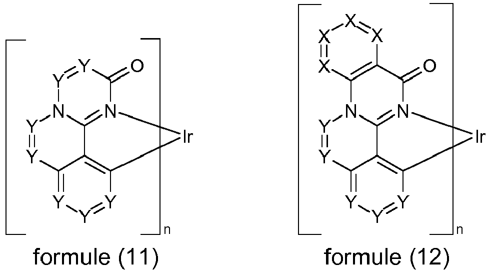 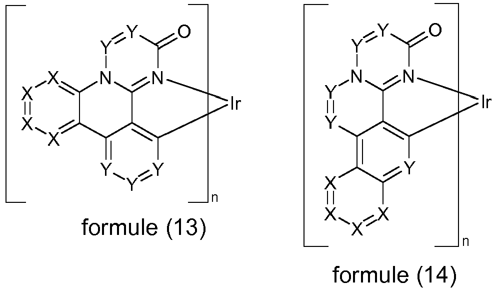 dans lesquelles Y représente pour chaque occurrence, de manière identique ou différente, CR ou N et les autres symboles ainsi que les autres indices présentent les significations qui ont été données selon la revendication 1.

4. Composé selon une ou plusieurs des revendications 1 à 3, **caractérisé en ce qu'**un total de 0, 1 ou 2 des symboles Y et, s'il est présent, X dans le ligand L représentent N.

5. Composé selon une ou plusieurs des revendications 1 à 4, **caractérisé en ce que** la moitié de la formule (2) est sélectionnée parmi les formules (11-1) à (11-5), (12-1) à (12-8), (13-1) à (13-8) et (14-1) à (14-9) : 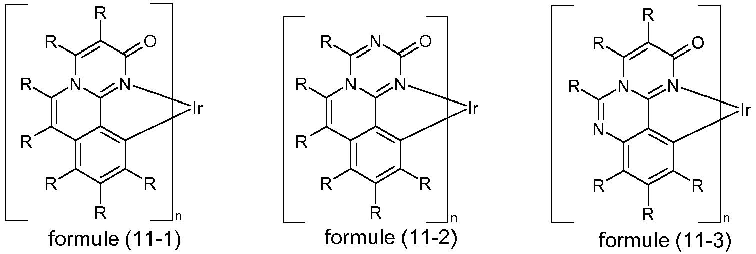 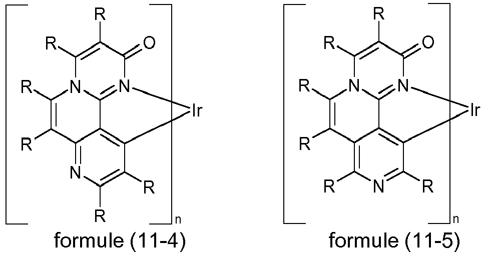 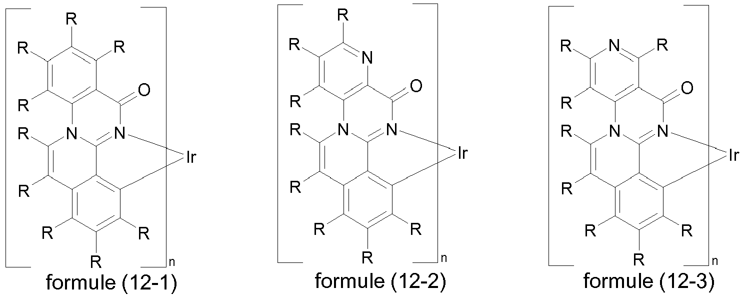 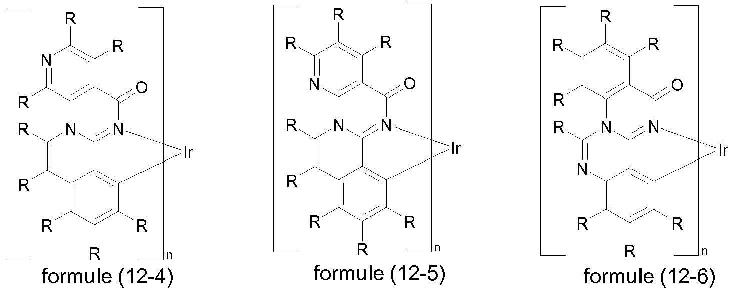 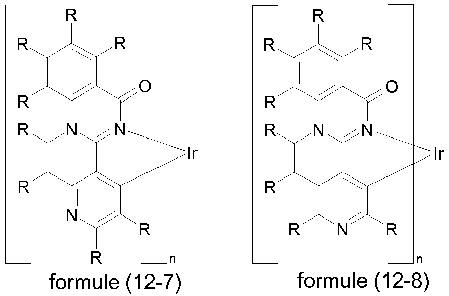 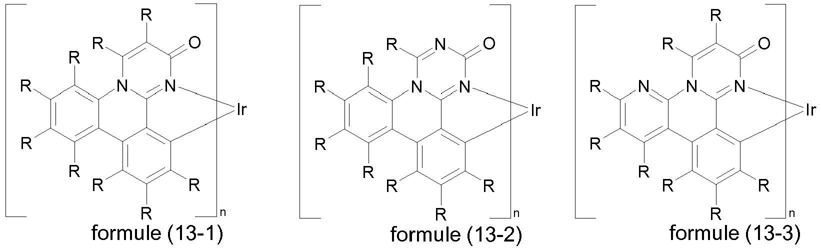 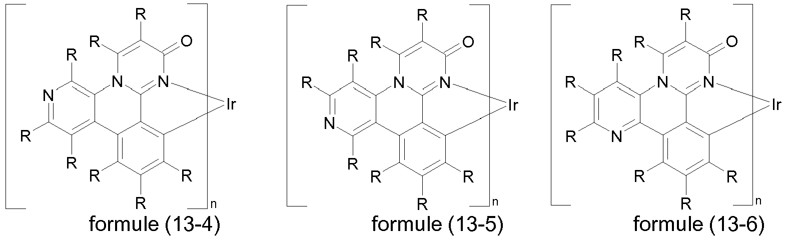 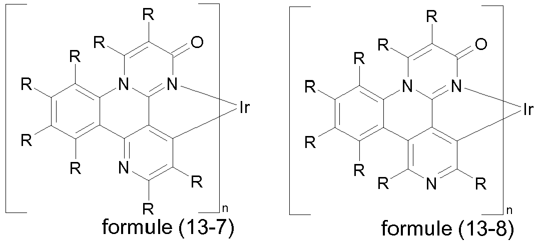 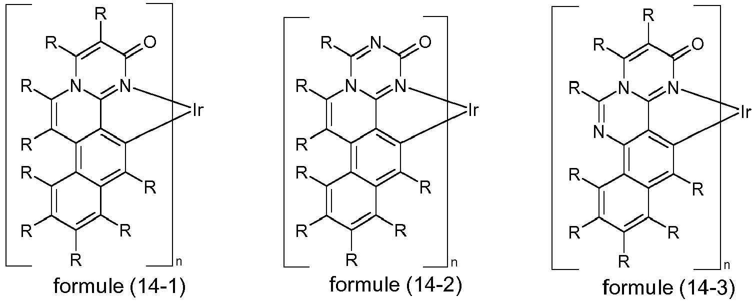 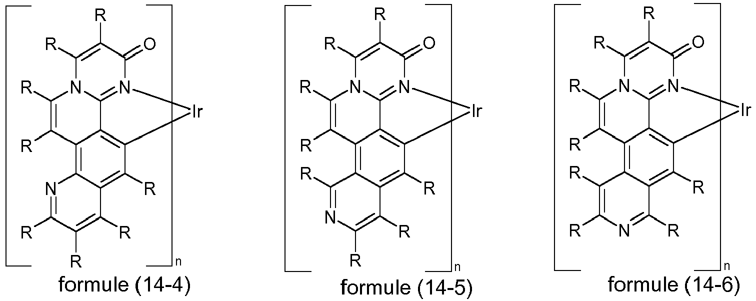 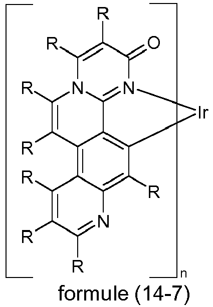 dans lesquelles les symboles et les indices qui sont utilisés présentent les significations qui ont été données selon la revendication 1, où le radical R qui est adjacent à l'atome de N additionnel considéré n'est de préférence égal ni à H, ni à D.

6. Composé selon une ou plusieurs des revendications 1 à 4, **caractérisé en ce que** l'un des atomes Y représente N et/ou **en ce que** X, s'il est présent, représente N, et un groupe R qui n'est égal ni à H, ni à D est lié en tant que substituant qui est adjacent à cet atome de N.

7. Composé selon la revendication 5 ou 6, **caractérisé en ce que** le substituant R qui est adjacent à un atome de N est sélectionné parmi CF₃, OCF₃, un groupe alkyle ou alcoxy qui comporte de 1 à 10 atome(s) de C, en particulier un groupe alkyle ou alcoxy ramifié ou cyclique qui comporte de 3 à 10 atomes de C, un groupe dialkylamino qui comporte de 2 à 10 atomes de C, un système de cycle aromatique ou hétéroaromatique ou un groupe aralkyle ou hétéroaralkyle, ou **en ce que** le radical R, avec un radical R adjacent, forme un cycle de l'une des formules (4) à (10).

8. Composé selon une ou plusieurs des revendications 1 à 7, **caractérisé en ce que** la moitié de la formule (2) est sélectionnée parmi les formules (11a) à (14e) : 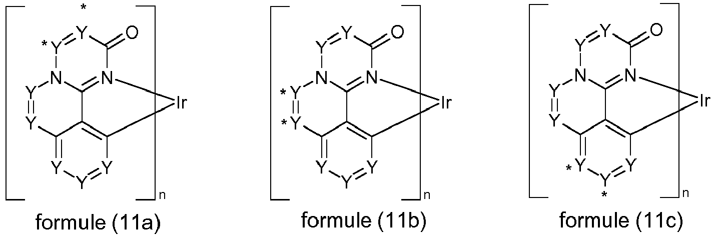 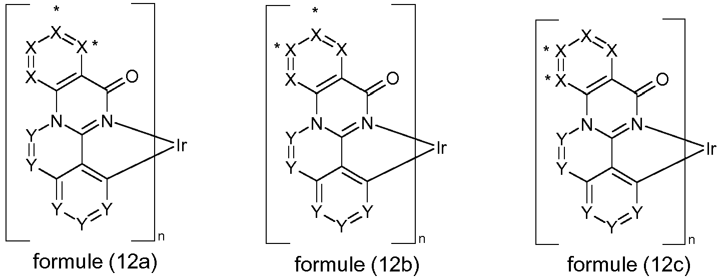 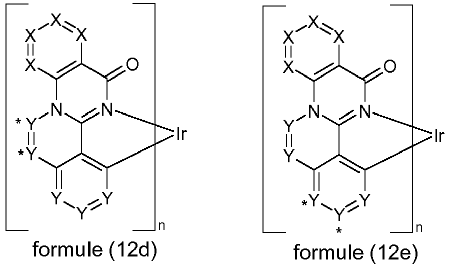 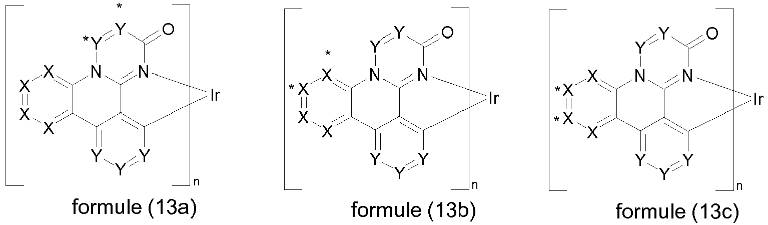 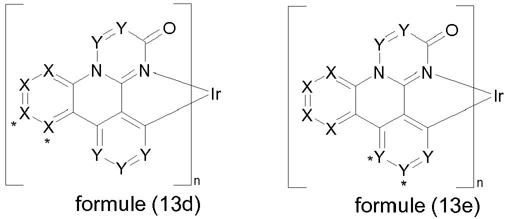 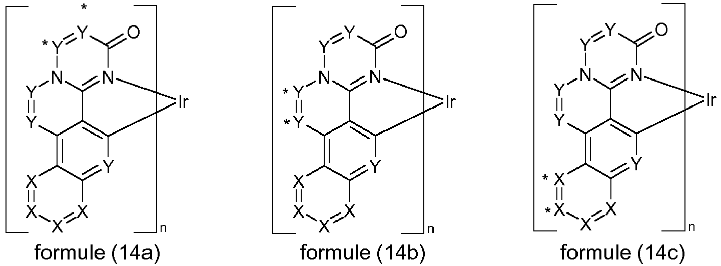 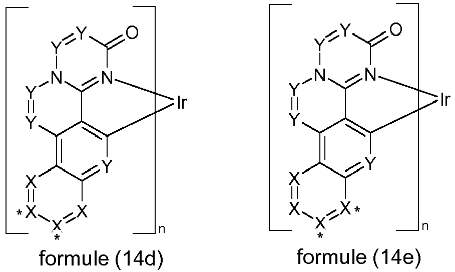 dans lesquelles les symboles et les indices qui sont utilisés présentent les significations qui ont été données selon la revendication 1 et * indique dans chaque cas la position au niveau de laquelle les deux groupes Y ou X adjacents représentent CR, et les radicaux R respectifs, en association avec les atomes de C, forment un cycle de l'une des formules (4) à (10).

9. Composé selon une ou plusieurs des revendications 1 à 8, **caractérisé en ce qu'**un maximum d'un seul des groupes A¹, A² et A³ représente un hétéroatome et les autres groupes représentent C(R³)₂ ou C(R¹)₂, ou A¹ et A³ représentent, de manière identique ou différente pour chaque occurrence, NR³, et A² représente C(R¹)₂.

10. Composé selon une ou plusieurs des revendications 1 à 9, **caractérisé en ce que** les structures de la formule (4) sont sélectionnées parmi les structures des formules (4-A) à (4-F) : 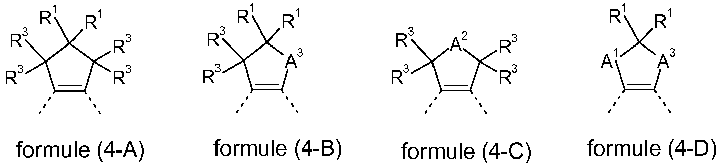 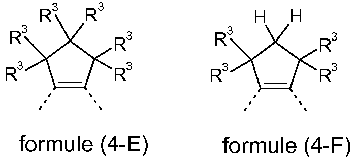 et **en ce que** les structures de la formule (5) sont sélectionnées parmi les structures des formules (5-A) à (5-F) : 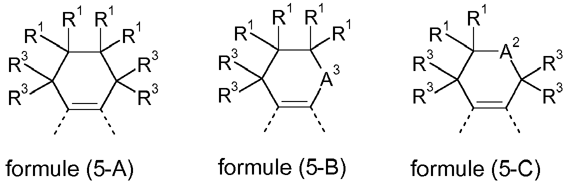 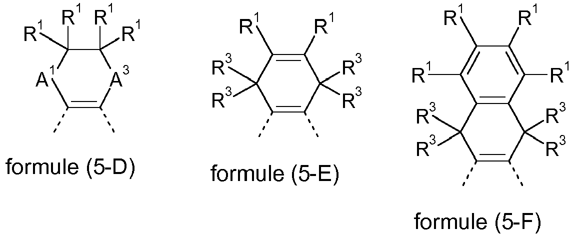 et **en ce que** les structures de la formule (6) sont sélectionnées parmi les structures des formules (6-A) à (6-E) : 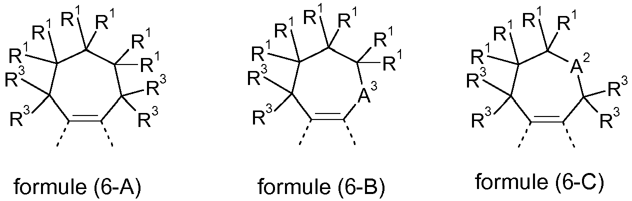 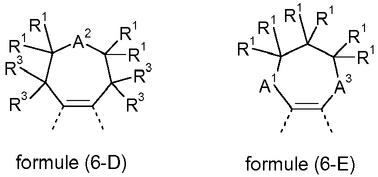 et **en ce que** les structures de la formule (7) sont sélectionnées parmi les structures des formules (7-A) à (7-C) : 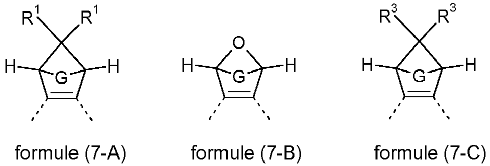 et **en ce que** les structures des formules (8), (9) et (10) sont sélectionnées parmi les structures des formules (8-A), (9-A) et (10-A) : 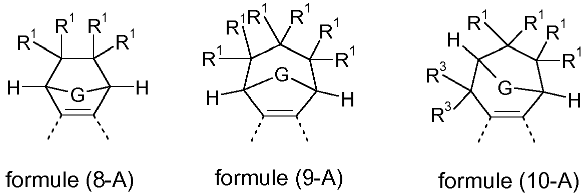 dans lesquelles R¹, R³ et G présentent dans chaque cas les significations qui ont été données selon la revendication 1, et A¹ et A³ représentent, de manière identique ou différente pour chaque occurrence, NR³, et A² représente, de manière identique ou différente pour chaque occurrence, O ou NR³

11. Oligomère, polymère ou dendrimère contenant au moins un composé selon une ou plusieurs des revendications 1 à 10, où le composé, en lieu et place d'un radical ou de plusieurs radicaux, comporte une liaison sur l'oligomère, le polymère ou le dendrimère.

12. Procédé pour la préparation d'un composé selon une ou plusieurs des revendications 1 à 10 au moyen de la réaction du ligand libre avec des alcoxydes d'iridium de la formule (43), avec des cétocétonates d'iridium de la formule (44), avec des halogénures d'iridium de la formule (45), avec des complexes d'iridium dimériques de la formule (46) ou (47) ou avec des composés d'iridium qui sont porteurs à la fois de radicaux alcoxyde et/ou halogénure et/ou hydroxyle et également cétocétonate : 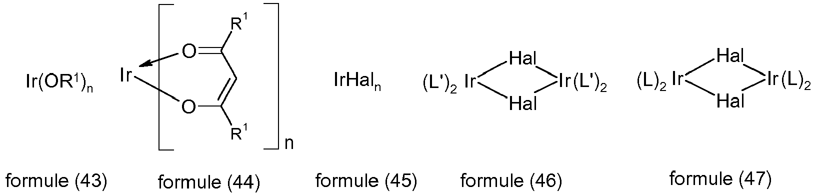 dans lesquelles les symboles et les indices présentent les significations qui ont été indiquées selon la revendication 1 et Hal = F, Cl, Br ou I.

13. Formulation comprenant un composé selon une ou plusieurs des revendications 1 à 10 et/ou un ou plusieurs oligomère(s), polymère(s) et/ou dendrimère(s) selon la revendication 11 et au moins un autre composé, en particulier un solvant et/ou un matériau de matrice.

14. Utilisation d'un composé selon une ou plusieurs des revendications 1 à 10 ou d'un oligomère, d'un polymère ou d'un dendrimère selon la revendication 11 ou d'une formulation selon la revendication 13 dans un dispositif électronique ou pour la génération d'oxygène singulet, pour la photocatalyse ou dans des capteurs d'oxygène.

15. Dispositif électronique contenant au moins un composé selon une ou plusieurs des revendications 1 à 10 et/ou au moins un oligomère, un polymère et/ou un dendrimère selon la revendication 11 et/ou une formulation selon la revendication 13.

16. Dispositif électronique selon la revendication 15, lequel est un dispositif électroluminescent organique, **caractérisé en ce que** le composé selon une ou plusieurs des revendications 1 à 10 est utilisé en tant que composé d'émission dans une ou plusieurs couche(s) d'émission.
